# EUROPÄISCHE PATENTSCHRIFT

(11) **EP 1 267 425 B1**
(45) Veröffentlichungstag und Bekanntmachung des Hinweises auf die Patenterteilung: **15.08.2007**
(21) Anmeldenummer: 02013415.1
(22) Anmeldetag: 12.06.2002
(51) Int. Cl.: H01L 41/09

(54) **Piezoelektrisches Stellelement**
Piezoelectric positioning element
Elément de positionnement piézoélectrique

(30) Priorität: 12.06.2001 DE 10128483; 07.11.2001 DE 10154526
(43) Veröffentlichungstag der Anmeldung: 18.12.2002
(73) Patentinhaber: Physik Instrumente (PI) GmbH & Co. KG, 76228 Karlsruhe (DE)
(72) Erfinder: Wischnewskiy, Wladimir, Dr., 76337 Waldbronn (DE)
(74) Vertreter: Kruspig, Volkmar

(56) Entgegenhaltungen:
- EP-A- 0 344 008
- WO-A-01/13505
- US-A- 5 453 653
- Y. TOMIKAWA, T. OGASAWARA, S. SUGAWARA, M. KONNO, T. TAKANO: "On the Construction of an Ultrasonic Motor" PAPER OF TECHNICAL GROUP ON US87-5, IECE, Bd. 87, Nr. 46, 25. Mai 1987 (1987-05-25), Seiten 29-36, XP009052579
- TOMIKAWA Y ET AL: "CONSTRUCTION OF ULTRASONIC MOTORS AND THEIR APPLICATION" JAPANESE JOURNAL OF APPLIED PHYSICS, PUBLICATION OFFICE JAPANESE JOURNAL OF APPLIED PHYSICS. TOKYO, JP, Bd. 27, Nr. SUPPL 27-1, 1. März 1988 (1988-03-01), Seiten 195-197, XP000026973 ISSN: 0021-4922

## Beschreibung

Die Erfindung betrifft ein piezoelektrisches Stellelement nach dem Oberbegriff des Patentanspruchs 1.

Lineare piezoelektrische Motoren, deren Funktionsweise auf der Ausnutzung von Wanderwellen beruhen, gehören zum bekannten Stand der Technik und sind beispielsweise Gegenstand der Patentschriften EP 0 475 752 B2 und US-PS 5,596,241.

Derartige Motoren besitzen den Nachteil, dass es unmöglich ist, sie in beliebigem Maße zu miniaturisieren, da die Mindestlänge ihrer Wellenleiter ein Vielfaches von 6λ bis 10λ der sich in ihnen ausbreitenden Wellen betragen muss. Außerdem sind sie technologisch sehr schwierig herzustellen, in ihrem Aufbau sehr kompliziert und deshalb entsprechend teuer.

Weiterhin sind piezoelektrische Motoren bekannt, deren Funktionsweise auf stehenden akustischen Wellen basiert. Ein solcher Stand der Technik ergibt sich u.a. aus der US-PS 5,453,653. Der Motor dieser Ausführungsart kann genügend klein gestaltet werden und läßt technologisch die Produktion größerer Stückzahlen zu. Als Antriebselement dient in diesem Motor ein monolithischer piezoelektrischer Oszillator mit einer langen Seite, einer kurzen Seite und einem, auf der kleinen Oberfläche der kurzen Seite angeordneten Friktionselement. Auf der ersten großen Seite besitzt der piezoelektrische Oszillator eine erste und eine zweite Elektrodengruppe. Auf der zweiten großen Seite befindet sich eine gemeinsame Elektrode. Jede erste und zweite Elektrodengruppe bedecken zwei gleichgroße rechteckige und diagonal angeordnete Gebiete einer metallisierten Piezokeramikoberfläche. Ein Oszillator liefert eine elektrische Wechselspannung an die gemeinsame Elektrode und an die erste oder die zweite Elektrodengruppe. Aufgrund der asymmetrischen Ausführung jeder der beiden Elektrodengruppen in bezug zur Längsachse der Piezoplatte, ergibt sich eine asymmetrische Deformation. Dies führt dazu, dass das Friktionselement eine Bewegung entweder in die eine oder die andere Richtung auf geschlossenen Bahnen ausführt, abhängig davon, an welche Elektrodengruppe die elektrische Spannung gegeben wird.

Das sich bewegende Friktionselement versetzt ein angepresstes getriebenes Element in Bewegung, welches dann seinerseits Bewegungen in die eine oder andere Richtung ausführt. Der Motor wird mit einer Frequenz angeregt, die nahe der Resonanzfrequenz der zweiten Schwingungsmode der Biegeschwingungen der Piezoplatte in ihrer Längsrichtung liegt.

In piezoelektrischen Motoren dieser Bauweise geben Längsschwingungen des Oszillators die im Oszillator gespeicherte Energie an das getriebene Element weiter. Die Parameter dieser Schwingungen bestimmen die Größe der Speisespannung des Motors, die Motorgeometrie und die gesamte Motorkonstruktion.

Die Speisespannung des betrachteten piezoelektrischen Motors muß durch den kleinen elektromechanischen Kopplungskoeffizienten der Biegemoden der Oszillatorschwingungen sehr hoch gewählt werden. Außerdem wird der Biegeoszillator in einem piezoelektrischen Motor dieser Konstruktion sehr stark durch das getriebene Element gedämpft, wodurch sich die erforderliche Speisespannung zusätzlich erhöht. So sind bei piezoelektrischen Oszillatoren in Motoren der aus dem Stand der Technik bekannten Ausführungsvarianten Speisespannungen bis zu 500V erforderlich, wodurch ein entsprechender Hochspannungsschutz notwendig wird.

Das Verhältnis der Abmessungen der langen Seite der Oszillatorplatte zur kurzen Seite beträgt bei piezoelektrischen Motoren der aus dem Stand der Technik bekannten Versionen ca. 3,7. Die Oszillatorplatte ist mit ihrer kurzen Seite parallel zur Oberfläche eines getriebenen Elements angeordnet und verbiegt sich bei Motorbetrieb längs ihrer langen Seite. Diese Motorkonstruktion beschränkt die maximal mögliche vom Motor entwickelte Kraft durch die Biegesteifigkeit der Oszillatorplatte.

Da sich sich das Friktionselement auf der kurzen Seite der Oszillatorplatte befindet, sind dessen Abmessungen begrenzt. Seine Breite darf nicht größer als ein Drittel der kurzen Seite des Piezoelements betragen. Dadurch wird die Breite des Friktionskontaktes begrenzt, die demzufolge in den Motoren der der aus dem Stand der Technik bekannten Konstruktionen ca. 0,3...0,4 mm beträgt. Diese geringe Breite des Friktionskontakts schränkt die vom Motor zu entwickelnde Kraft zusätzlich entscheidend ein. So werden bei Motoren der bekannten Ausführungsarten, die aus einem Oszillator bestehen, als maximale Kraft nur etwa 10N erreicht. Aufgrund der kleinen Breite des Friktionskontakts vergrößert sich zudem der Verschleiß, womit eine vorübergehende Instabilität des Motorbetriebs einhergeht. Die kleine Breite des Friktionskontakts verringert insbesondere die Bewegungsstabilität des getriebenen Elements bei kleinen Bewegungsgeschwindigkeiten. Weiterhin führt der schmale Friktionskontakt zu Parameteränderungen des Motors während längerer Lagerung.

Eine Motorkonstruktion nach US-PS 5,453,653 sieht nur ein Friktionselement auf der Oberfläche eines piezoelektrischen Oszillators vor. Dadurch wird der piezoelektrische Oszillator mechanisch instabil, wodurch sich die Positionierungsgenauigkeit verringert und die Konstruktion der Oszillatorhalterung komplizierter wird.

Zusätzlich dazu begrenzt ein Friktionselement die maximal mögliche vom Motor mit einem piezoelektrischen Oszillator entwickelte Kraft. Werden mehrere, in einem Paket gebündelte Oszillatoren verwendet, verschlechtert sich die Positionierungsgenauigkeit des getriebenen Elements, wobei sich zusätzlich die elektronische Motorsteuerung sehr kompliziert gestaltet.

Weiterhin wird durch Tourikawa et al., Japanese Journal of Applied Physics, Vol. 27 (1988) Supplement 27-1, pp. 195 - 197 ein piezoelektrischer Linearmotor mit einem hohlzylindrischen Oszillator beschrieben, bei dem eine Radialschwingung angeregt wird.

Der Erfindung liegt daher die Aufgabe zugrunde, einen piezoelektrischen Motor auf der Grundlage eines monolithischen piezoelektrischen Oszillators zu entwickeln, mit dem sich eine größere Kraft bei einer kleineren Erregerspannung erzielen läßt, der eine höhere Betriebsstabilität bei einer längeren Betriebsdauer aufweist, eine gleichmäßigere Bewegung des getriebenen Elements bei niedrigen Bewegungsgeschwindigkeiten und eine höhere Parameterstabilität bei einer Lagerung des Motors über längere Zeiten gewährleistet, eine mechanisch robuste Oszillatorkonstruktion aufweist und der eine Steuerungsmöglichkeit zur Verfolgung der Oszillatorresonanzfrequenz sowie eine Positions- und Parameterregelung des getriebenen Elements zuläßt.

Diese Aufgabe wird durch ein piezoelektrisches Stellelement, insbesondere einen piezoelektrischen Motor nach Patentanspruch 1 gelöst.

Der erfindungsgemäße piezoelektrische Motor umfaßt ein Gehäuse, ein getriebenes Element, eine sich auf dem Gehäuse oder auf dem getriebenen Element befindliche Friktionsschicht und ein mit einer elektrischen Erregerquelle elektrisch verbundenes treibendes Element, das mindestens ein, im Friktionskontakt mit der der Friktionsschicht stehendes Friktionselement enthält, in Form mindestens eines monolithischen plattenförmigen oder zylindrischen piezoelektrischen Oszillators mit ersten und zweiten Hauptoberflächen, ersten und zweiten Seitenoberflächen und ersten und zweiten, sich auf seinen Hauptoberflächen befindenden Elektrodengruppen.

Wesentlich ist hierbei, daß der genannte piezoelektrische Oszillator eine Resonanzlänge sowie eine Resonanzhöhe besitzt, wobei die erste und zweite Elektrodengruppe zwei Generatoren akustischer Wellen bilden. Der erste Generator regt dabei eine stehende longitudinale akustische, in Richtung der Oszillatorresonanzlänge schwingende Welle an. Analog dazu wird durch den zweiten Generator eine stehende longitudinale akustische Welle angeregt, die in Richtung der Oszillatorresonanzhöhe schwingt. Die Oszillatorresonanzlänge ist gleich einem ganzzahligen Vielfachen der Wellenlänge der in ihre Richtung schwingenden stehenden akustischen longitudinalen Welle, die von dem ersten Generator erzeugt wird, während die Oszillatorresonanzhöhe gleich einer halben Wellenlänge der in ihre Richtung schwingenden stehenden akustischen longitudinalen Welle ist, die ihrerseits von dem zweiten Generator erzeugt wird. Das Maß der Oszillatorresonanzlänge bzw. die Oszillatorresonanzhöhe unterliegt dabei insbesondere der Bedingung, dass die Frequenzen der im Oszillator in Richtung der Oszillatorresonanzlänge und -höhe schwingenden stehenden akustischen longitudinalen Wellen gleich sind.

Durch die beschriebene Ausführung der Oszillatorresonanzlänge und -höhe ist eine Anbringung von Friktionselementen an den Seitenoberflächen des Oszillators sowie die Anordnung der Oszillatorplatte mit ihrer langen Seite entlang der Oberfläche des getriebenen Elements möglich. Bei einer solchen Ausführungsform einer Oszillatorkonstruktion bilden Längsschwingungen entlang der Länge der Oszillatorplatte die Hauptschwingungen, die die im Oszillator gespeicherte Energie an das getriebene Element weitergeben. Dieser Schwingungsmode weist einen höheren elektromechanischen Kopplungskoeffizienten als der Mode der Biegeschwingungen auf und ermöglicht somit eine Verkleinerung der Erregerspannung des Oszillators.

Da der zweite Schwingungstyp der im vorgeschlagenen Motor benutzten Schwingungen die Längsschwingungsmode in Richtung der Höhe der Oszillatorplatte ist, besteht die Möglichkeit, die Oszillatorhöhe ungefähr zu verdoppeln. Damit erhöht sich die Längssteifigkeit der Oszillatorplatte und die maximal mögliche von diesem Oszillator entwickelte Kraft nimmt zu. Außerdem können an einem solchen Oszillator Friktionselemente mit einer größeren Breite des Friktionskontakts angebracht werden. Auch diese Ausgestaltung bewirkt eine Zunahme der möglichen vom Oszillator entwickelten Kraft. Die erfindungsgemäße Oszillatorkonstruktion ermöglicht die Anbringung mehrerer Friktionselemente entweder auf einer der Seitenoberflächen des Oszillators oder zwei Seitenoberflächen gleichzeitig. Der Oszillator wird deutlich robuster und damit erhöht sich in hohem Masse die Stabilität des Motorbetriebes bei niedrigen Bewegungsgeschwindigkeiten des getriebenen Elements.

Die große Breite des Friktionskontakts verringert den Verschleiß des Friktionselements und verkleinert das Maß der Parameteränderungen des Motors während seiner Lagerung.

In einer ersten Ausführungsform des vorgeschlagenen piezolektrischen Motors ist die längs der Resonanzhöhe des piezoelektrischen Oszillators schwingende stehende akustische longitudinale Welle vorzeichenkonstant längs der Resonanzlänge. In dieser Motorvariante können auf einer der Seitenoberflächen des Oszillators ein oder zwei Friktionselemente angeordnet werden.

In einer weiteren Ausführungsform des vorgeschlagenen piezoelektrischen Motors ist die sich längs der Resonanzhöhe des piezoelektrischen Oszillators ausbreitende stehende akustische longitudinale Welle vorzeichenvariabel längs der Resonanzlänge. In dieser Motorvariante können auf einer der Seitenoberflächen des Oszillators ein, zwei oder drei Friktionselemente angeordnet werden.

Im vorgeschlagenen piezoelektrischen Motor sind Elektroden der ersten Gruppe, also die Elektroden, die den ersten Generator von akustischen Wellen bilden, vorwiegend in Randgebieten der Hauptoberflächen des Oszillators symmetrisch bezüglich der durch die Mitte der Resonanzhöhe des Oszillators gehenden Symmetrieebene angeordnet, während die den zweiten Generator der akustischen Wellen bildenden Elektroden der zweiten Elektrodengruppe, in mittleren Gebieten der Hauptoberflächen des Oszillators, symmetrisch bezüglich der obengenannten Symmetrieebene angeordnet sind.

Eine solche Elektrodenkonfiguration ermöglicht eine unabhängige Erregung einer stehenden akustischen longitudinalen Welle im Oszillator, die in Richtung der Resonanzlänge und einer weiteren stehenden akustischen longitudinalen Welle, die in Richtung der Resonanzhöhe schwingt.

In einer weiteren vorteilhaften Ausgestaltungsform des piezoelektrischen Motors werden die erste und zweite Elektrodengruppe, die jeweils den ersten bzw. den zweiten Generator der stehenden akustischen longitudinalen Wellen bilden, miteinander vereinigt und bilden somit einen zusammengesetzten Generator, der gleichzeitig eine in Richtung der Resonanzlänge des piezoelektrischen Oszillators schwingende stehende akustische longitudinale Welle und eine in Richtung der Resonanzhöhe stehende akustische longitudinale Welle erzeugt.

Eine solche Elektrodenkonstruktion ermöglicht die gleichzeitige Erregung im Oszillator einer entlang der Resonanzlänge des piezoelektrischen Oszillators schwingenden stehenden akustischen longitudinalen Welle und einer entlang seiner Resonanzhöhe schwingenden stehenden akustischen longitudinalen Welle.

Eine vorteilhafte Motorkonstruktion enthält zwei oder mehrere plattenförmige piezoelektrische Oszillatoren, die miteinander verbunden sind, so dass sich ein einheitlicher elektromechanischer Resonator ergibt.
Bei einer solchen Ausführungsform des piezoelektrischen Motors verringert sich die Erregerspannung des piezoelektrischen Oszillators in einem erheblichen Maße.

Die akustisch gekoppelten Oszillatoren, die den piezoelektrischen Motor bilden, sind in einer Ausführungsvariante mit Hilfe eines starren organischen Klebers miteinander verbunden. Eine solche Verbindung ist insbesondere hinsichtlich einer vereinfachten Herstellungstechnologie vorteilhaft. Alternativ dazu besteht die Möglichkeit, die akustisch verbundenen Oszillatoren des piezoelektrischen Motors durch Sintern miteinander zu verbinden. Bei dieser Verbindungsart erhöht sich die Festigkeit erheblich.

Erfolgt im piezoelektrischen Motor die Erregung einer vorzeichenkonstanten stehenden akustischen longitudinalen Welle in Richtung der Resonanzhöhe des piezoelektrischen Oszillators, ist es möglich, Friktionselemente auf einer oder zwei Seitenoberflächen des piezoelektrischen Oszillators anzuordnen, und zwar in den Bereichen mit vorzeichengleichen Schwingungsmaxima, der in Richtung der Resonanzlänge des piezoelektrischen Resonators schwingenden stehenden akustischen longitudinalen Welle.

Eine solche Anordnung der Friktionselemente ermöglicht es, eine gleichgerichtete Bewegung der Friktionselemente für den piezoelektrischen Motor zu verwirklichen.

In einem piezoelektrischen Motor, in dem eine vorzeichenvariable stehende akustischen longitudinale Welle, die in Richtung der Resonanzhöhe des piezoelektrischen Oszillators schwingt, erzeugt wird, können die Friktionselemente auf einer oder zwei Seitenoberflächen des piezoelektrischen Oszillators angeordnet werden und zwar in Bereichen mit vorzeichenungleichen Schwingungsmaxima, der in Richtung der Resonanzlänge schwingenden akustischen longitudinalen Welle.

Je nach Ausführungsform können bei den erfindungsgemäßen Varianten des piezoelektrischen Motors Friktionselemente in Form von Streifen, Stäbchen, pyramidalen Elementen, oder konischen, zylindrischen, halbsphärischen Elementen aus Oxidkeramik, Metallkeramik oder als Komposit mit anderen Materialien gefertigt werden.

Eine Ausführung der Friktionselemente auf diese Art ermöglicht eine optimale Anpassung an das getriebene Element. Friktionselemente in Form von Streifen oder Stäbchen können Quernute aufweisen, die es ermöglichen, die zwischen dem Friktionselement und dem Oszillator entstehenden mechanischen Spannungen zu reduzieren und darüber hinaus eine Verbiegung der Funktionsoberfläche des Friktionselements zu vermeiden. Abhängig von der Ausführungsform des vorgeschlagenen Motors können die Friktionselemente eine ein- oder mehrschichtige Struktur aufweisen.

Dadurch wird eine optimale Anpassung der Friktionselemente an den jeweiligen piezoelektrischen Oszillator ermöglicht. Abhängig von der konkreten Motorvariante können Schichten der ein- oder mehrschichtigen Struktur der Friktionselemente parallel zu den Seitenoberflächen des piezoelektrischen Oszillators angeordnet sein.

Eine solche Anordnung der Schichten der Friktionselemente ermöglicht es, die Friktionselemente mit einer maximal möglichen Fläche des Friktionskontakts zu versehen, der in der Lage ist, gegenüber den aus dem Stand der Technik bekannten Ausführungsformen eines piezoelektrischen Oszillators, Motors oder Stellelements deutlich höhere Kräfte zu übertragen.

In weiteren Ausführungsformen des erfindungsgemäßen piezoelektrischen Motors kann die ein- oder mehrschichtige Schichtstruktur der Friktionselemente in ihrer Gesamtheit oder teilweise senkrecht zu den Seitenoberflächen des piezoelektrischen Oszillators angeordnet werden. Eine solche Anordnung der Schichten der Friktionselemente ermöglicht eine maximale Unterdrückung parasitärer und damit unerwünschter Schwingungen, die während des Motorbetriebs in den Friktionselementen entstehen.

In einer weiteren Ausführungsvariante des piezoelektrischen Motors sind die Schichten der ein- oder mehrschichtigen Struktur zylindrischer, konischer oder halbsphärischer gestalteter Friktionselemente entsprechend ausgeführt und konzentrisch angeordnet. Eine solche Schichtanordnung ermöglicht eine den piezoelektrischen Oszillator minimal belastende Gestaltung der Friktionselemente.

Im Rahmen der Ausführungsformen des piezoelektrischen Motors weisen die Schichten innerhalb der ein - oder mehrschichtigen Struktur der Friktionselemente einen unterschiedlichen Elastizitätsmodul auf. Diese Variante der Schichten der Friktionselemente ermöglicht eine optimale Anpassung der Friktionselemente des piezoelektrischen Motors an den piezoelektrischen Oszillator.

Als eine Ausgestaltung weist die verschleißfeste Schicht mehrschichtiger Friktionselemente der piezoelektrischen Motoren des Friktionselements einen Elastizitätsmodul auf, der durch die Verschleißfestigkeit und mechanische Festigkeit seiner Funktionsoberfläche bestimmt ist, während eine verbindende Schicht des Friktionselements durch einen Elastizitätsmodul gekennzeichnet ist, der dem Elastizitätsmodul der piezoelektrischen Keramik des Oszillators angepaßt ist. Dadurch wird eine optimale akustische Abstimmung des Friktionselements mit dem piezoelektrischen Oszillator ermöglicht.

In Ausführungsformen des piezoelektrischen Motors mit konzentrisch angeordneten Schichten der Friktionselemente weist die verschleißfeste Schicht der mehrschichtigen Struktur der Friktionselemente zweckmäßigerweise einen Elastizitätsmodul auf, der durch die geforderte Verschleißsowie mechanische Festigkeit seiner Funktionsoberfläche bestimmt ist, während die Eigenschaften der dämpfenden Schicht durch die dynamische Stabilität der verschleißfesten Schicht bestimmt werden.
Dadurch wird eine maximal mögliche dynamische Stabilität der Friktionselemente erreicht.

Bei Ausführungsformen des piezoelektrischen Motors mit einer zwei- oder mehrschichtigen Struktur der Friktionselemente besteht die Möglichkeit, die Schichten aus monolithischen Materialien zu fertigen und durch Sintern miteinander zu verbinden. Damit wird eine maximal mögliche Verbindungsfestigkeit der Schichten der Friktionselemente erzielt.

Bei Ausführungsformen piezoelektrischer Motoren mit einer zwei- oder mehrschichtigen Struktur der Friktionselemente kann ein poröses Material als verbindende Schicht des Friktionselements vorgesehen werden, wodurch die Verbindungsfestigkeit des Friktionselements mit der Oberfläche des piezoelektrischen Oszillators erhöht wird.

Die Porösität der Materialien innerhalb der Schichtstruktur der Friktionselemente kann in dieser Ausführungsform variabel gestaltet sein. Alle Schichten können vollständig oder teilweise aus einem porösen Material mit einer variablen Porosität bestehen. Besonders zweckmäßig sind Ausführungen piezolektrischer Motoren mit einer mehrschichtigen Struktur der Friktionselemente, bei welcher die verbindende Schicht eine maximale Porosität aufweist und die verschleißfeste Schicht nicht porös ist. Eine solche Ausführungsform der Friktionselemente ermöglicht es, Sprünge, die durch mechanische Spannungen innerhalb des Friktionselements hervorgerufen werden, zu vermeiden.

Als weitere Ausgestaltung des erfindungsgemäßen piezoelektrischen Motors, insbesondere mit senkrecht oder konzentrisch bezüglich der Seitenoberflächen des Oszillators angeordneten Schichten der Friktionselemente, besteht die dämpfende Schicht aus einem porösen Werkstoff. Dies ermöglicht eine maximale Dämpfung des Friktionselements.

In den verschiedenen Ausführungsvarianten des vorgeschlagenen Motors, die über eine ebene Funktionsoberfläche der Friktionselemente verfügen, kann diese Funktionsoberfläche geneigt zur Seitenoberfläche angeordnet werden, auf der sich die Friktionselemente befinden, wodurch sich die Kopplungskraft zwischen den Friktionselementen und der Friktionsschicht erhöht.

In Kombination kann die Funktionsoberfläche der Friktionselemente eine dreieckige konkave oder konvexe Form, runde konkave oder konvexe Form aufweisen, wobei die Funktionsoberflächen der Friktionselemente entlang der Resonanzlänge des piezoelektrischen Oszillator angeordnet sind. Diese Ausführungsvarianten der Funktionsoberflächen von Friktionselementen vergrößern die verfügbare Fläche des Friktionskontaktes.

Die Friktionselemente des erfindungsgemäßen piezoelektrischen Motors können bei einer Ausführungsform mittels eines organischen Stoffes, z.B. eines Klebers auf der Basis von Epoxydharz, mit der Oberfläche des piezoelektrischen Oszillators verbunden sein, wodurch sich die Herstellungstechnologie des piezoelektrischen Motors vereinfacht.

Alternativ dazu besteht bei einer weiteren Ausführungsform des piezoelektrischen Motors die Möglichkeit, die Friktionselemente mittels eines Stoffes mit der Oberfläche des piezoelektrischen Oszillators zu verbinden, der eine stoffschlüssige Bindung mit dem Material des Oszillators eingeht. Als verbindendendes Material kommen beispielsweise bleihaltiges leichtschmelzendes Glas oder dergleichen andere Stoffe in Betracht. Diese Variante der Verbindung zwischen der Oberfläche der piezoelektrischen Keramik und den Friktionselementen ermöglicht eine maximale Verbindungsfestigkeit.

In den dargelegten Varianten des erfindungsgemäßen piezoelektrischen Motors können alle Poren der Friktionselemente oder ein Teil davon mit einem Stoff aufgefüllt sein, der das Friktionselement mit der Oberfläche des piezoelektrischen Oszillators verbindet, wodurch sich ebenfalls eine erhöhte Verbindungsfestigkeit ergibt.

Bei Ausgestaltungen der erfindungsgemäßen piezoelektrischen Motoren, bei denen die Friktionselemente Quernute aufweisen, ist es möglich, die Quernute mit einem schalldämpfenden Stoff aufzufüllen, wodurch die mechanische Güte der Friktionselemente verringert wird. Dadurch werden in Teilen der Friktionselemente entstehende parasitäre Schwingungen gedämpft.

Die Friktionselemente selbst können darüber hinaus auch als Glasstreifen ausgeführt sein, die auf die Oberfläche des piezoelektrischen Oszillators aufgeschmolzen sind. Dadurch vereinfacht sich die Herstellungstechnologie der Friktionselemente.

Werden die Friktionselemente als Glasstreifen gefertigt, können diese mit Pulver eines verschleißfesten Stoffes aufgefüllt werden. Beispielsweise kann dazu pulverförmiges Aluminiumoxid, Zirkonoxid, Wolframcarbid, Titancarbid oder ein anderer ähnlicher Stoff verwendet werden. Dadurch wird die Verschleißfestigkeit der Friktionselemente erhöht.

Als zweckmäßige Ausgestaltung des erfindungsgemäßen piezoelektrische Motors ist eine Ausgestaltung mit den piezoelektrischen Oszillator begrenzenden Elementen vorgesehen, die eine Verschiebung in Richtung seiner Resonanzlänge verhindern. In einer vorteilhaften Ausführungsvariante des piezoelektrischen Motors können die die Verschiebung des Oszillators verhindernden Elemente als mechanische Resonatoren dienen, deren Resonanzfrequenz mit der Schwingungsfrequenz des piezoelektrischen Oszillators während des Motorbetriebs übereinstimmt. Dadurch reduzieren sich die mechanischen Verluste.

In einer Ausführungsform des erfindungsgemäßen piezoelektrischen Motors ist der piezoelektrische Oszillator mit mindestens einem fixierenden Element ausgestattet, das starr mit dem Oszillator verbunden ist. Die fixierenden Elemente ermöglichen somit eine starre Befestigung des piezoelektrischen Oszillators.

In einer ersten Ausführungsform sind die fixierenden Elemente mindestens auf einer der Seitenoberflächen des piezoelektrischen Oszillators angeordnet, vorzugsweise an den Stellen der Schwingungsminima der längs der Resonanzlänge des Oszillators schwingenden stehenden akustischen longitudinalen Welle. Eine solche Anordnung der fixierenden Elemente ermöglicht eine Stirnfixierung des piezoelektrischen Oszillators.

Bei einer weiteren Ausführungsform des erfindungsgemäßem piezoelektrischen Motors sind die fixierenden Elemente mindestens auf einer der Hauptoberflächen des piezoelektrischen Oszillators angeordnet, vorzugsweise an den Stellen von Schwingungsminima der in Richtung der Resonanzlänge des Oszillator schwingenden stehenden akustischen longitudinalen Welle. Eine solche Anordnung der fixierenden Elemente ermöglicht eine seitliche Fixierung des piezoelektrischen Oszillators.

Bei einer Ausführungsform des erfindungsgemäßen piezoelektrischen Motors weisen die fixierenden Elemente die Form eines rechteckigen Prismas, dreieckigen Prismas, halbzylindrischen Prismas oder dergleichen weitere prismatische Formen auf, wobei es möglich ist, sie als konische Elemente, pyramidenförmige Elemente, halbsphärische Elemente oder als rechteckige Elemente mit Profilnuten oder herausragenden Teilen, als zylindrische Stufenelemente oder als runde Elemente mit Profilbohrungen auszuführen. Die entsprechende Konstruktionsausführung der fixierenden Elemente ermöglicht eine zuverlässige Befestigung der piezoelektrischen Oszillatoren.

In weiteren Ausführungsvarianten des erfindungemäßen piezoelektrischen Motors sind die fixierenden Elemente aus einem Werkstoff ausgeführt, dessen Elastizitätsmodul gleich oder ein wenig größer als der Elastizitätsmodul der piezoelektrischen Keramik ist, insbesondere aus Oxidkeramik. Eine solche Konstruktionsausführung gewährleistet eine hohe Festigkeit der fixierenden Elemente.

Bei einer Ausführungsformen bestehen die fixierenden Elemente aus einem Werkstoff, dessen Elastizitätsmodul klein gegenüber dem Elastizitätsmodul der Piezokeramik des piezoelektrischen Oszillators ist. Diese Konstruktionsausführung der fixierenden Elemente ermöglicht eine Verringerung der zwischen dem fixierenden Element und dem Oszillator entstehenden mechanischen Spannungen.

Auch können die fixierende Elemente aus demselben Piezokeramiktyp gefertigt werden, wie der piezoelektrische Oszillator. Dadurch wird eine optimale akustische Kopplung der fixierenden Elemente an den Oszillator erreicht. Zudem kann auch jedes fixierende Element oder ein Teil aus einem porösen Werkstoff gefertigt werden. Damit werden die im fixierenden Element entstehenden akustischen Schwingungen verringert.

Es ist auch möglich, in speziellen Motoren die fixierenden Elemente als Resonanzbiegeplatten oder -balken auszuführen. Eine derartige Konstruktion der fixierenden Elemente ermöglicht eine Verringerung mechanischer Verluste.

Die fixierenden Elemente als Bestandteile des erfindungsgemäßen piezoelektrischen Motors können mit Hilfe eines organischen Klebers mit der Oberfläche des piezoelektrischen Oszillators verbunden werden. Dadurch vereinfacht sich die Herstellungstechnologie des Motors.

Je nach Ausführungsform des erfindungsgemäßen piezoelektrischen Motors können die fixierenden Elemente mindestens auf einer der Seitenoberflächen des piezoelektrischen Oszillators angeordnet sein, insbesondere an den Stellen der Schwingungsminima der in Richtung der Resonanzlänge des Oszillators schwingenden stehenden akustischen longitudinalen Welle. Damit wird eine Anordnung der fixierenden Elemente in Form einer Stirnfixierung ermöglicht.

In einer anderen Ausführungsform des erfindungsgemäßen piezoelektrischen Motors sind fixierende Elemente mindestens auf einer der Hauptoberflächen des piezoelektrischen Oszillators angeordnet, insbesondere an den Stellen der Schwingungsminima der in Richtung der Resonanzlänge des Oszillators schwingenden stehenden longitudinalen Welle. Durch eine solche Anordnung der fixierenden Elemente wird eine seitliche Fixierung ermöglicht.

Bei einer Ausführungsvariante des erfindungsgemäßen piezoelektrischen Motors können die fixierenden Elemente in festen Stützträgern aufgestellt werden. Dadurch wird eine besonders stabile Fixierung des piezoelektrischen Oszillators ermöglicht. Insbesondere können die feste Stützträger in Form flacher Federn gefertigt werden. Dadurch werden die durch den Stützträger entstehenden mechanische Verluste verringert.

Das getriebene Element des piezoelektrischen Motors ist im allgemeinen verschiebbar gelagert. Dadurch werden Längsbewegungen des getriebenen Elements ermöglicht.
Das verschiebbar gelagerte getriebene Element ist in Abhängigkeit von seiner konkreten Gestaltung als eine rechteckige Plattform, ein Rahmen oder als Balken mit rechteckigem, vieleckigem, rundem Querschnitt oder als ein Rohr ausgeführt. Damit ergeben sich vielfältige Gestaltungsmöglichkeiten für einen piezoelektrischen Linearmotor.

Außerdem kann das getriebene Element drehbar gelagert werden. Eine solche Motorkonstruktion ermöglicht eine Rotationsbewegung des getriebenen Elements. In den Motorvarianten mit dem drehbar gelagerten getriebenen Element kann das getriebene Element die Form eines Zylinders, einer Scheibe, eines Hohlzylinders oder eines Ringes besitzen.

Die genannten Konstruktionsformen des getriebenen Elements ermöglichen einen Aufbau verschiedener Varianten eines piezoelektrischen Rotationsmotors. Im Rahmen des erfindungsgemäßen piezoelektrischen Motors sind als Ausgestaltung des Friktionselements rechteckige, runde, elliptische oder ähnliche Dämpfungsbohrungen vorgesehen, die eine Ausbreitung von akustischen Wellen, deren Frequenz gleich der Frequenz des piezoelektrischen Oszillators während eines Motorbetriebes oder ihrer Oberschwingungen ist, im Friktionselement verhindern. Dadurch wird eine Verbesserung des Friktionskontakts des Motors ermöglicht.

Erfindungsgemäß kann die Friktionsschicht des getriebenen Elements aus Oxidkeramik oder einem vergleichbaren anderen harten und verschleißfesten Werkstoff gefertigt werden, wobei deren Dicke zweckmäßigerweise mindestens fünf mal kleiner als die Resonanzhöhe des piezoelektrischen Oszillators ist, um die Amplitude von akustischen Längsschwingungen, die in der Friktionsschicht entstehen möglichst nachhaltig zu verringern.

Die Dicke des sich unter der Friktionsschicht befindlichen Friktionselements muß einen größeren Wert als die Resonanzhöhe des piezoelektrischen Oszillators aufweisen, um die Amplitude der im getriebenen Element entstehenden akustischen Biegeschwingungen zu verringern.

Erfindungsgemäß kann zwischen dem Körper des getriebenen Elements und der Friktionsschicht eine dünne Dämpfungsschicht eingefügt sein, die aus einem viskosen organischen oder einem porösen nichtorganischen Werkstoff oder als Komposit derselben besteht, um die akustische Kopplung zwischen der Friktionsschicht und den getriebenen Elementen zu verringern.

Der erfindungsgemäße piezoelektrische Motor kann aus mindestens zwei gegenüberliegenden piezoelektrischen Oszillatoren und mindestens zwei auf gegenüberliegenden Seiten des getriebenen Elements angeordneten Friktionsschichten bestehen, um auf ein Lager zur Stabilisierung der Längsbewegung verzichten zu können.

Um das getriebene Element in einer besonders stabilen Lage zu halten, besteht der erfindungsgemäße piezoelektrische Motor in einer besonderen Ausführungsform aus mindestens drei piezoelektrischen Oszillatoren und mindesten drei, parallel zueinander angeordneten und mindestens in drei Ebenen liegenden Friktionsschichten.

Bei der Ausführungsform eines erfindungsgemäßen piezoelektrischen Motors mit getrennten Generatoren für longitudinale Wellen ist die elektrische Erregerquelle als ein Zweikanalleistungsverstärker ausgeführt. Dieser besteht aus einem ersten und einem zweiten Kanal, an einen Grundgenerator angeschlossene Formierungsstufen, sowie Ausgangsleistungsverstärkern, die elektrisch über Anpassungsstufen mit entsprechenden Elektroden des Generators am piezoelektrischen Oszillator angeschlossen sind. Diese erzeugen akustische longitudinale in Richtung der Resonanzlänge des piezoelektrischen Oszillators schwingender Wellen, sowie akustische longitudinale Wellen, die in Richtung der Resonanzhöhe schwingen.

Der Aufbau der elektrischen Erregerquelle mit getrennten Generatoren ermöglicht es, im Oszillator über die erregten akustischen Wellen optimale Bewegungsbahnen der Friktionselemente zu erzielen.

Bei einer anderen Ausführungsform ist die elektrische Erregerquelle als ein Einkanalleistungsverstärker aufgebaut, der eine an den Grundgenerator angeschlossenen Formierungstufe und einen Ausgangsleistungsverstärker umfaßt, der über eine Anpassungstufe und einen Elektrodenkommutator mit den Elektroden des entsprechenden zusammengesetzten Piezo-Generators verbunden ist.

Die Ausgangsleistungsverstärker sind als Brückenleistungsverstärker aufgebaut, von denen jeder zwei Halbbrücken einschließt. Die Formierungstufen enthalten zwei Erregerkanäle der genannten Halbbrückenleistungsverstärker, wobei einer der Erregerkanäle mit einem Phasensteuerungsglied ausgestattet ist und einen Phasensteuerungseingang enthält. Dadurch wird eine Regelung der Bewegungsgeschwindigkeit des getriebenen Elements ermöglicht.

Als Ausgestaltung des erfindungsgemäßen Motors ist eine Austattung mit einem Signalpegelumformer vorgesehen, dessen Ausgang mit dem Phasensteuerungseingang eines Phasensteuerungsgliedes verbunden ist. Dies ermöglicht eine Steuerung der Bewegungsgeschwindigkeit des getriebenen Elements mittels eines linearen elektrischen Signals.

In einer anderen Ausführungsform ist der erfindungsgemäße Motor mit einem Demodulator eines pulsbreitenmodulierten Signals ausgestattet, dessen Ausgang mit dem Phasensteuerungseingang des Phasensteuerungsglieds verbunden ist. Dadurch wird eine Steuerung der Bewegungsgeschwindigkeit des getriebenen Elements mittels eines pulsbreitenmodulierten Signals ermöglicht.

Des weiteren ist eine Ausgestaltung des erfindungsgemäßen Motors mit einem Stufendetektor für die Nullage möglich, dessen Messeingang an den Eingang des Signalpegelumformers oder an den Ausgang des Demodulators eines pulsbreitenmodulierten Signals angeschlossen ist. Dabei ist der Ausgang des Stufendetektors mit dem Eingang eines Reversumschalters oder mit dem Steuereingang eines Elektrodenkommutators verbunden. Durch diese Ausgestaltung des Motors ist eine Reversierung des getriebenen Elements möglich.

Bei einer weiteren Ausgestaltung ist der Grundgenerator mit einem Frequenzsteuereingang ausgestattet. In dieser Motorvariante ist eine Frequenzregelung des Grundgenerators möglich.
Ebenso ist eine Ausgestaltung des erfindungsgemäßen Motors mit einem Phasendetektor vorgesehen, der einen ersten und einen zweiten Phaseneingang und einen Ausgang umfaßt, wobei der Ausgang des Phasendetektors an den Frequenzsteuereingang des Grundgenerators angeschlossen ist, der erste Phaseneingang elektrisch mit den gleichnamigen Elektroden des entsprechenden Generators von akustischer longitudinaler Wellen verbunden und der zweite Phaseneingang elektrisch mit einem dieser Welle verbunden ist.
Hierdurch ist eine automatische Frequenzregelung des Grundgenerators möglich.

Bei der Ausführungsform des erfindungsgemäßen Motors mit getrennten Generatoren akustischer Wellen ist ein Sensor als eine dünne piezokeramische Platte ausgeführt, die auf ihren großen Oberflächen Elektroden enthält, und der akustisch gekoppelt auf der Oberfläche des piezoelektrischen Oszillators, insbesondere an den Stellen der größten mechanischen Spannungen der akustischen im piezoelektrischen Oszillator schwingenden longitudinalen Welle befestigt ist. Damit ist mittels des Sensors eine Bestimmung der mechanischen Resonanz des durch getrennte Generatoren angeregten Oszillators möglich.

Bei der Ausführungsform des Motors mit zusammengesetzten Generatoren akustischer Wellen ist der Sensor vornehmlich in Form zweier dünner piezokeramischer Platten ausgeführt, die auf ihren breiten Oberflächen Elektroden enthalten und die akustisch gekoppelt auf der Oberfläche des piezoelektrischen Oszillators befestigt sind. Zweckmäßigerweise sind diese an Stellen, an denen die größten mechanischen Spannungen der akustischen longitudinalen Welle entstehen, fixiert, sowie an den Punkten, die bei einer Signalphasenverschiebung eines der Kanäle des Leistungsverstärkers bezüglich des Signals eines anderen um 180° zu diesem, phasenverschobenen Kanals, die gleichen Bewegungsbahnen besitzen. Dabei sind beide Sensorteile über einen Sensorsignalkommutator an den zweiten Eingang des Phasendetektors angeschlossen. Dessen Steuereingang ist elektrisch mit dem Steuereingang des Reversumschalters verbunden. In dieser Variante ermöglicht der Sensor ebenfalls eine Bestimmung der Stärke der mechanischen Resonanz des piezoelektrischen Oszillators.

Der vorgeschlagene Motor kann mit einem Koordinaten- oder Bewegungsparametersensor des getriebenen Elements ausgestattet werden, der elektrisch mit einem prozessorgesteuerten Regler der vom Sensor gemessenen Parameter verbunden und dessen Ausgang mit dem Signalpegelumformer oder dem Demodulator eines pulsbreitenmodulierten Signals verbunden ist. Damit ist eine Regelung der Koordinaten-oder Bewegungsparameter des getriebenen Elements möglich.

Die Erfindung soll nun im folgenden anhand eines Ausführungsbeispiels näher erläutert werden. Zur Verdeutlichung dienen folgende Abbildungen:
- 1.: Hauptansicht des vorgeschlagenen Motors,
- 2.: Konstruktionsvariante des Oszillators mit Erregung einer vorzeichenkonstanten longitudinalen Welle,
- 3.: Funktionsweise eines Oszillators mit Erregung einer vorzeichenkonstanten Welle,
- 4.: Funktionsweise eines Friktionskontakts,
- 5.: Oszillatorvarianten mit einer Resonanzlänge L = λ,
- 6.: Oszillatorvarianten mit einer Resonanzlänge L = nλ,
- 7.: Elektrodenkonfigurationen eines Oszillators mit einer Resonanzlänge L = nλ,
- 8.: Oszillatorvarianten in Form eines Zylinderteils,
- 9.: Oszillatorvariante in Form eines Zylinders mit einer Resonanzlänge L = 2 λ,
- 10.: Oszillatorvariante in Form eines Zylinders mit einer Resonanzlänge L = 3 λ,
- 11.: Konstruktionsvariante des Oszillators mit Erregung einer vorzeichenvariablen Longitudinalwelle,
- 12.: Funktionsweise eines Oszillators mit Erregung einer vorzeichenvariablen Welle,
- 13.: Oszillatorvarianten mit einer Resonanzlänge L = λ,
- 14.: Oszillatorvariante mit einer Resonanzlänge L = nλ,
- 15.: Elektrodenkonfigurationen eines Oszillators mit einer Resonanzlänge L = λ,
- 16.: Oszillatorvariante in Form eines Zylinders mit einer Resonanzlänge L gleich 5 λ,
- 17.: Oszillatorvariante mit zusammengesetzten Generatoren akustischer Wellen,
- 18.: Elektrodenkonfigurationen eines Oszillators mit zusammengesetzten Generatoren akustischer Wellen,
- 19.: Funktionsweise eines Oszillators mit zusammengesetzten Generatoren akustischer Wellen,
- 20.: Oszillatorvarianten mit einer Resonanzlänge L = λ.
- 21.: Oszillatorvarianten mit einer Resonanzlänge L = 2λ.
- 22.: Oszillatorvarianten mit einer Resonanzlänge L = 4λ,

- 23.: Oszillatorvariante mit zusammengesetzten Generatoren akustischer Wellen in Form eines Zylinderteils,
- 24.: Oszillatorvarianten mit zusammengesetzten Generatoren akustischer Wellen in Form eines Zylinders,
- 25.: Oszillatorvariante in Form eines ganzen elektromechanischen Resonators,
- 26.: Varianten von Friktionselementen,
- 27.: Varianten von Friktionselementen, die Quernute besitzen,
- 28.: Varianten von mehrschichtigen Friktionselementen,
- 29.: Varianten von Friktionselementen mit senkrecht angeordneten Schichten,
- 30.: Varianten von Friktionselementen mit zylindrischen Schichten,
- 31.: Friktionselement mit geneigter Funktionsoberfläche,
- 32.: Varianten von Friktionselementen mit verschiedenartigen Funktionsoberflächen,
- 33.: Friktionselemente als Glasstreifen,
- 34.: eine Konstruktionsvariante des vorgeschlagenen Motors,
- 35.: eine weitere Konstruktionsvariante des vorgeschlagenen Motors,
- 36.: Varianten von fixierenden Elementen,
- 37.: Befestigungsvariante von fixierenden Elementen,
- 38.: Friktionselemente in Form von Resonanzplatten oder Balken,
- 39.: Befestigung von fixierenden Elementen in starren Stützträgern,
- 40.: Getriebenes Element in Form einer Plattform,
- 41.: Varianten von Friktionsschichten mit verschiedenartigen Funktionsoberflächen,
- 42.: Eine Konstruktionsvariante des Motors mit geneigter Funktionsoberfläche der Friktionselemente,
- 43.: eine weitere Konstruktionsvariante des Motors,
- 44.: Konstruktionsvariante des Motors mit einem zylindrischen Oszillator mit Resonanzlänge L = 2λ,
- 45.: Konstruktionsvariante des Motors mit einem zylindrischen Oszillator, mit Resonanzlänge L = 3λ,
- 46.: eine weitere Konstruktionsvariante des Motors,
- 47.: Konstruktionsvariante des Motors mit drei Oszillatoren,
- 48.: Blockschema einer elektrischen Erregerquelle für den Motor mit getrennten Generatoren von akustischen Wellen,
- 49.: Blockschema einer elektrischen Erregerquelle für den Motor mit den zusammengesetzten Generatoren von akustischen Wellen,
- 50.: Blockschema des ersten und zweiten Kanals der Leistungsverstärker,
- 51.: Varianten einer Anpassungstufe,
- 52.: Diagramme elektrischer Spannungen,
- 53.: Kennlinie des Signalphasensteuerungsglieds,
- 54.: Blockschema des Motors mit einem Signalpegelumformer,
- 55.: Diagramm eines pulsbreitenmodulierten Signals,
- 56.: Kennlinienvarianten,
- 57.: Varianten eines Sensors zur Detektion der mechanischen Spannungen des Oszillators,
- 58.: Kennlinien eines Sensors der mechanischen Spannungen,
- 59.: eine Konstruktionsvariante des Motors mit einem Frequenzsteuereingang des Grundgenerators und einem Phasendetektor,
- 60.: Blockschema einer Konstruktionsvariante des Motors mit einem zweiteiligen Sensor, und
- 61.: Blockschema einer Konstruktionsvariante des Motors mit einem prozessorgesteuerten Regler.

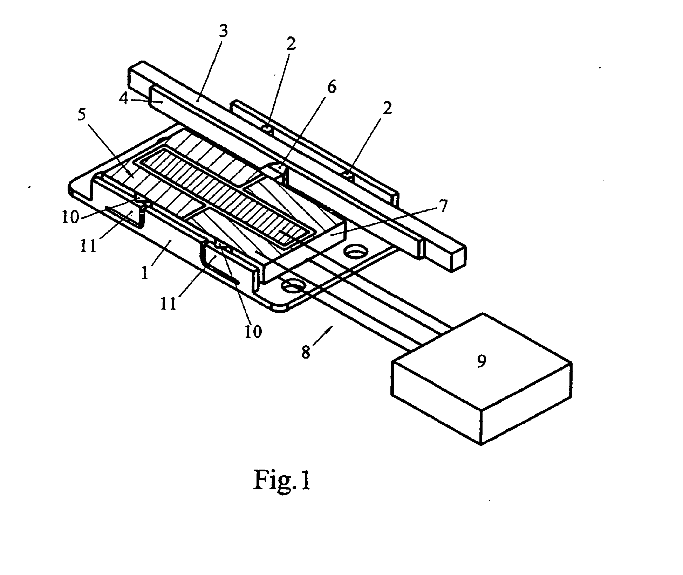

Fig. 1 zeigt eine bevorzugte Variante des erfindungsgemäßen piezoelektrischen Motors. Der Motor besteht aus einem Gehäuse 1, in dem das Lager für die Längsbewegung 2 des getriebenen Elements 3 mit der Friktionsschicht 4 aufgestellt ist. In der betrachteten Motorvariante ist das getriebene Element 3 als ein Balken mit rechteckigem Querschnitt ausgeführt.
In dem Gehäuse 1 ist auch das treibende Element 5 mit dem Friktionselement 6 angeordnet, das sich, mit der Friktionsschicht 4, im Friktionskontakt befindet.
Das treibende Element 5 ist als ein monolithischer plattenförmiger piezoelektrischer Oszillator 7 ausgeführt, der elektrisch über die Ausgänge 8 mit der elektrischen Erregerquelle 9 verbunden ist.

Zur Vermeidung einer Längsverschiebung ist der piezoelektrische Oszillator 7 mit den fixierenden Elementen 10 ausgestattet, die in den Trägern 11 aufgestellt sind.

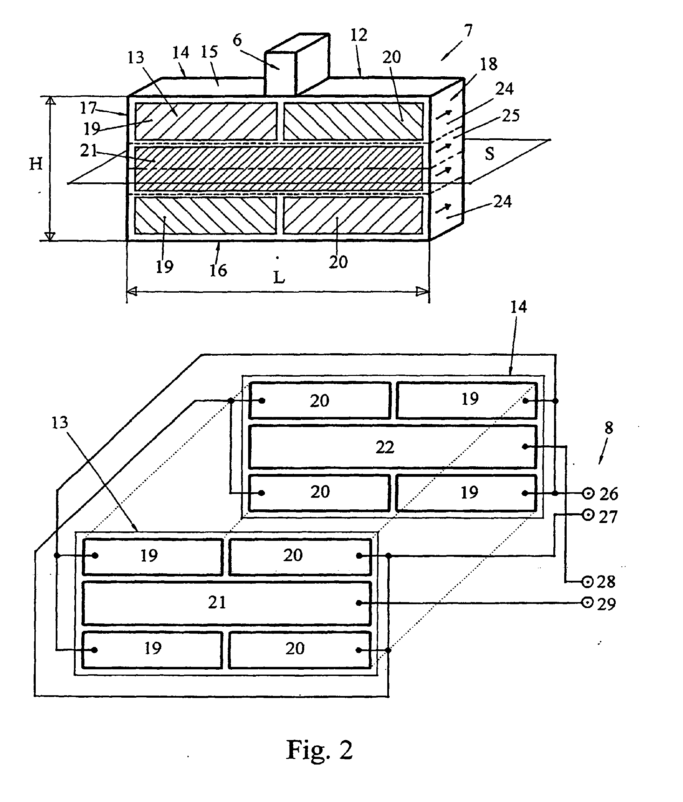

In Fig. 2 ist eine der Konstruktionsvarianten des Piezo-Oszillators 7 dargestellt. Sein Hauptteil ist das rechteckige Piezoelement 12. Der Oszillator 7 hat eine erste 13 und eine zweite 14 Hauptoberfläche, eine erste 15 und eine zweite 16 Seitenoberfläche, eine erste 17 und eine zweite 18 Stirnoberfläche, die Resonanzlänge L und die Resonanzhöhe H. Die piezoelektrische Keramik des Piezoelements 12 ist normal zu den Hauptoberflächen 13, 14 des Oszillators 7 polarisiert, so wie es in Fig.2 und weiter durch Pfeile angedeutet ist. In der betrachteten Variante des Oszillators 7 ist die Resonanzlänge L gleich der Wellenlänge λ einer sich entlang der Länge des Oszillators 7 ausbreitenden Welle. Die Resonanzhöhe H des Oszillators 7 ist gleich einer halben Wellenlänge ν einer sich entlang der Höhe des Oszillators 7 ausbreitenden Welle.
Auf den zwei Hauptoberflächen 13, 14 des Oszillators 7 befinden sich zwei Elektrodengruppen. Die erste Elektrodengruppe schließt die Elektroden 19, 20 ein und die zweite die Elektroden 21, 22. Die Konfiguration der Elektroden 19, 20, 21, 22, ihre Anordnung und elektrische Beschaltung ist in Fig. 2, unterer Teil dargestellt.
Die Elektroden 19, 20 der ersten Elektrodengruppe und die dazwischen liegende piezoelektrische Keramik bilden den Generator 24 einer akustischen Longitudinalwelle, die sich entlang der Resonanzlänge L des piezoelektrischen Oszillators 7 ausbreitet.
Die Elektroden 21, 22 der zweiten Elektrodengruppe und die dazwischen liegende piezoelektrische Keramik bilden den Generator 25 einer akustischen Longitudinalwelle, die sich entlang der Resonanzhöhe H des piezoelektrischen Oszillators 7 ausbreitet. In der gezeigten Variante des Oszillators 7 ist diese Welle, eine längs der Resonanzlänge L des Oszillators 7 vorzeichenkonstante Welle.
Die Elektroden 19, 20 der ersten Elektrodengruppe sind in den Randgebieten der Hauptoberflächen 13, 14 des Oszillators 7 angeordnet, symmetrisch bezüglich der Symmetrieebene S, die durch die Mitte der Resonanzhöhe des Oszillators 7 geht und senkrecht zu den Hauptoberflächen 13, 14 steht. Die Elektroden 21, 22 der zweiten Elektrodengruppe sind in den Zentralgebieten der Hauptoberflächen 13, 14 des Oszillators 7 angeordnet, symmetrisch bezüglich der Symmetrieebene S, die durch die Mitte der Resonanzhöhe des Oszillators 7 geht und senkrecht zu den Hauptoberflächen 13, 14 steht.
Zur elektrischen Verbindung des Oszillators 7 mit der elektrischen Erregerquelle 9 ist jede der Elektroden 19, 20, 21, 22 mit Anschlüssen 26, 27, 28, 29 ausgestattet, die die Anschlussgruppe 8 bilden. Die Anschlüsse 19, 20 dienen der Zuführung von Erregerspannung zum Generator der akustischen Wellen 24. Die Anschlüsse 28, 29 dienen der Zuführung von Erregerspannung zum Generator der akustischen Wellen 25.

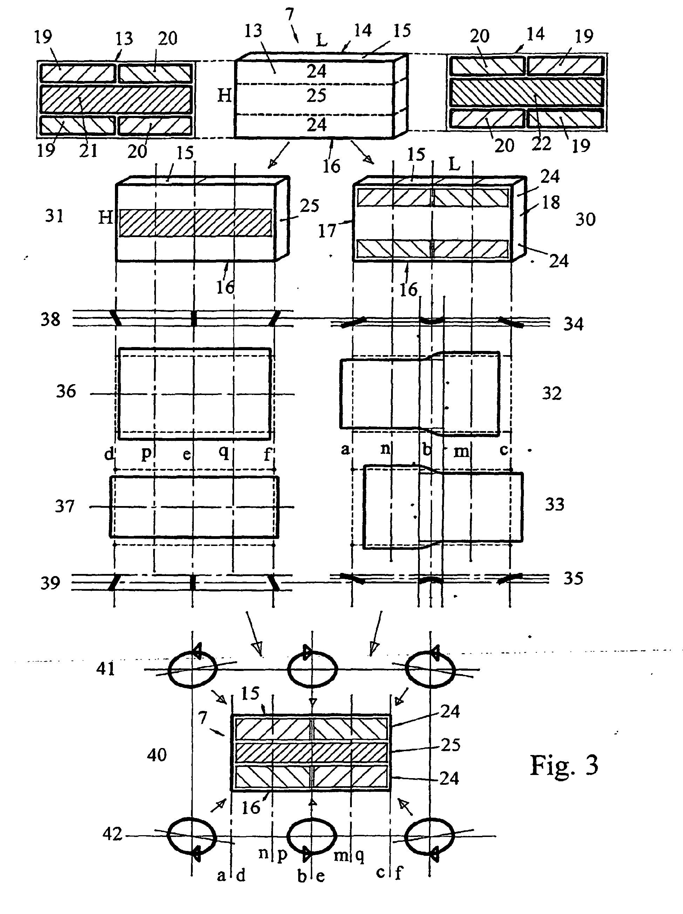

Fig. 3 erklärt die Funktionsweise des Oszillators 7 der betrachteten Motorvariante. Zur Erklärung der Funktionsweise wird das Prinzip der unabhängigen Erregung von akustischen Wellen in dem Oszillator 7 herangezogen. Nach diesem Prinzip, aufgrund der kleinen Schwingungsamplitude, kann der Oszillator 7 als zwei in Pos. 30, 31 gezeigten, unabhängigen Oszillatoren dargestellt werden, wobei jeder der beiden nur noch einen Generator von akustischen Wellen enthält. Der in Pos. 30 dargestellte Oszillator enthält nur den Generator 24 der akustischen Welle, die sich entlang seiner Resonanzlänge L ausbreitet und der in Pos. 31 nur den Generator 25 der akustischen Longitudinalwelle, die sich entlang seiner Resonanzhöhe H ausbreitet.
Bei einer Erregung des Generators 24 hat der in Pos. 30 dargestellte Oszillator, die in Pos. 32, 33 dargestellten Schwingungsformen. Die auf seinen Seitenoberflächen 15, 16 längs der Achsen a, b, c liegenden Punkte befinden sich in Schwingungsgeschwindigkeitsmaxima und sie bewegen sich längs der in Pos. 34, 35 dargestellten Längsbahnen. Die auf seinen Seitenoberflächen, längs der Achsen n, m liegenden Punkte befinden sich in Schwingungsgeschwindigkeitsminima und besitzen nur eine kleine Queramplitude der Schwingungen.
Bei einer Erregung des Generators 25 hat der in Pos. 31 dargestellte Oszillator die in Pos. 36, 37 dargestellten Schwingungsformen. In diesem Fall bewegen sich die auf seiner Seitenoberflächen 15,16 längs der Achsen d, p, e, q, f liegenden Punkte längs der in Pos. 38, 39 dargestellten Querbahnen. Diese akustische Welle ist längs der Resonanzlänge L des Oszillators vorzeichenkonstant. Bei einer solchen Welle entsteht eine positive (Pos.36) oder eine negative Verschiebung der Seitenoberflächen 15, 16 (Pos.37) bezüglich ihrer Anfangslage.
Bei einer gleichzeitigen Erregung der beiden Generatoren 24 und 25, die zu demselben Oszillator 7 gehören (siehe Pos.40), kommt es zur Bewegungsüberlagerung der entlang der Achsen ad, be und cf auf der Oberfläche 15, 16 liegenden Punkte. Damit bewegen sich Punkte, die entlang dieser Achsen liegen, längs der in Pos. 41, 42 dargestellten geschlossenen Bahnen. Die Form dieser Bewegungsbahnen kann in erster Näherung als elliptisch angesehen werden. Stellen entlang der Achsen ad, be, und cd auf der Oberfläche 15, 16 sind optimal zur Befestigung der Friktionselemente 6 geeignet.
Stellen entlang der Achsen np, mq befinden sich in Schwingungsgeschwindigkeitsminima und haben nur eine Queramplitude der Schwingungen. Diese Stellen sind optimal zur Befestigung der fixierenden Elemente 10 geeignet.

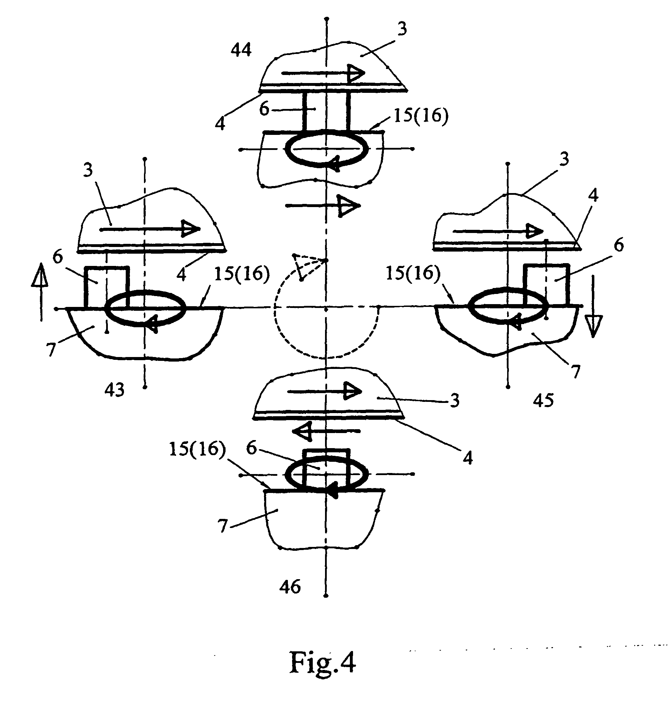

In Fig. 4 sind elliptische Bewegungsphasen des auf einer der Seitenoberflächen 15 oder 16 entlang einer der Achsen ad, be, cf, angebrachten Friktionselements 6 dargestellt. Pos. 43 - Phase der Vorwärtsanpressung, Phase der Vorwärtsbewegung - Pos.44, Phase der Rückwertsanpressung - Pos. 45, Phase der Rückwertsbewegung - Pos.46.
Die Bewegungsrichtung des Friktionselements 6 wird durch das Vorzeichen der Schwingungsgeschwindigkeitsmaxima der akustischen Welle bestimmt, die sich entlang der Resonanzlänge L des Oszillators 7 ausbreitet. Die Friktionselemente 6 werden an den Stellen angebracht, an denen die Punkte der Oberflächen 15, 16 eine gleichsinnige Bewegungsrichtung auf geschlossenen Bahnen haben.

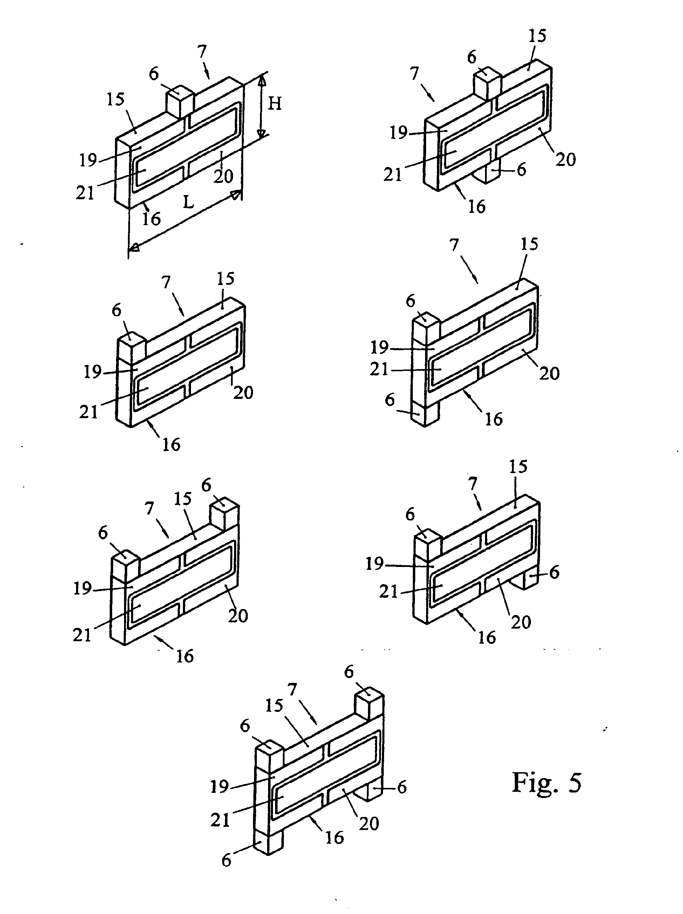

In Fig. 5 sind Konstruktionsvarianten des Oszillators 7 dargestellt mit den auf seiner Oberfläche 15, 16 angebrachten Friktionselementen 6 bei einer Resonanzlänge L des Oszillators, die gleich λ ist.

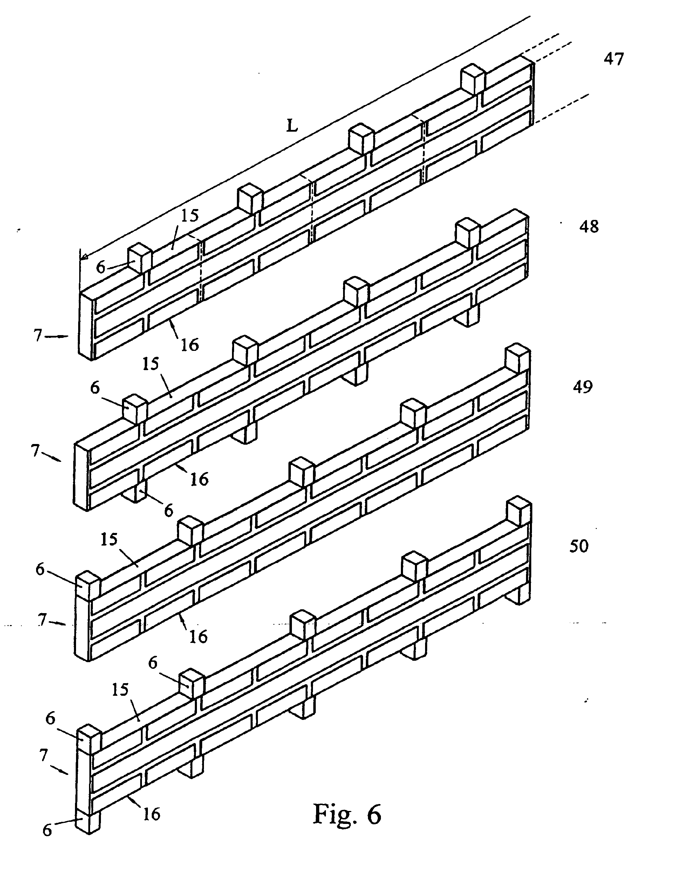

Die Pos. 47, 48, 49, 50 der Fig. 6 zeigen KonstruktionsVarianten des Oszillators 7 mit der Resonanzlänge L, die ein ganzzahliges Vielfaches von λ beträgt, d.h. L = k*λ, wobei k=1,2,3...

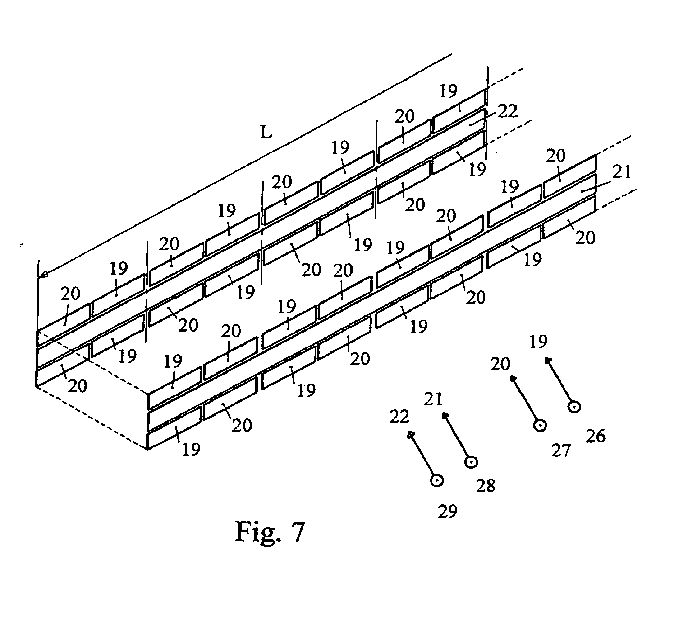

Fig. 7 zeigt eine Konfiguration der Elektroden 19, 20, 21, 22 und ihre elektrische Beschaltung mit den Anschlüssen 26, 27, 28, 29 für den Oszillator 7 , dessen Resonanzlänge L ein ganzzahliges Vielfaches von λ beträgt.

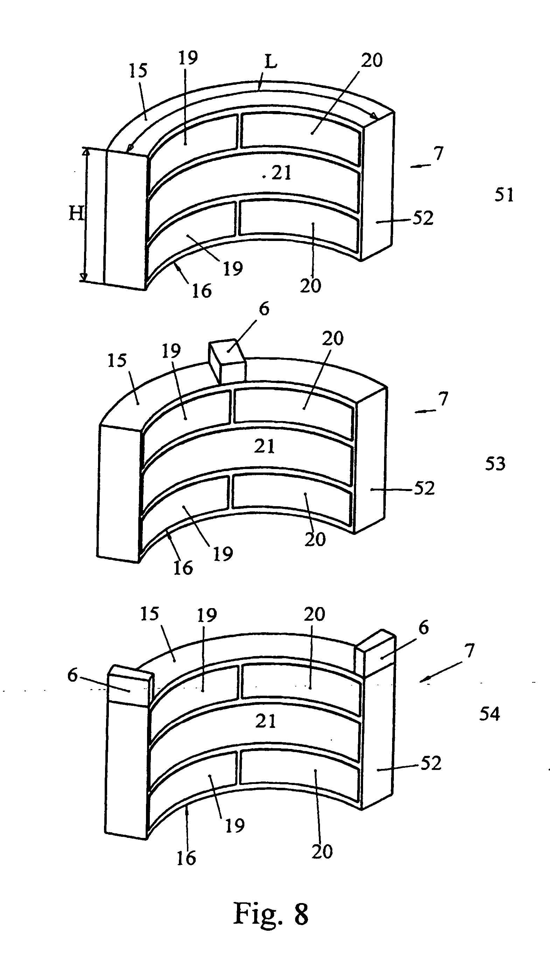

Die Pos. 51 der Fig. 8 offenbart eine Konstruktionsvariante des Oszillators 7 in Form des Zylinderteils 52, dessen Resonanzlänge L gleich λ ist. Die Pos. 53, 54 zeigen Anordnungsvarianten der Friktionselemente 6 auf den Seitenoberflächen 15, 16 mit dem Oszillator 6 in Form des Zylinderteils 52.

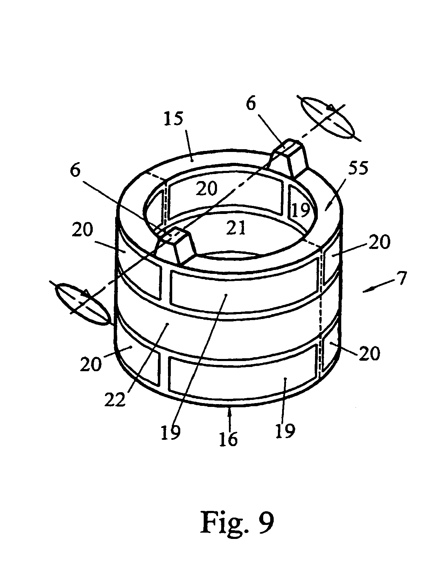

Fig. 9 zeigt eine Konstruktionsvariante des Oszillators 7 in Form des Zylinders 55, dessen Resonanzlänge L gleich 2 λ ist. Ein solcher Oszillator setzt sich aus zwei Teilen 52 zusammen (siehe Fig. 8), wobei jedes Teil eine Resonanzlänge L gleich λ hat. In dieser Konstruktionsvariante des Oszillators 7 haben die zwei Friktionselemente 6 eine entgegengesetzte Bewegungsrichtung.

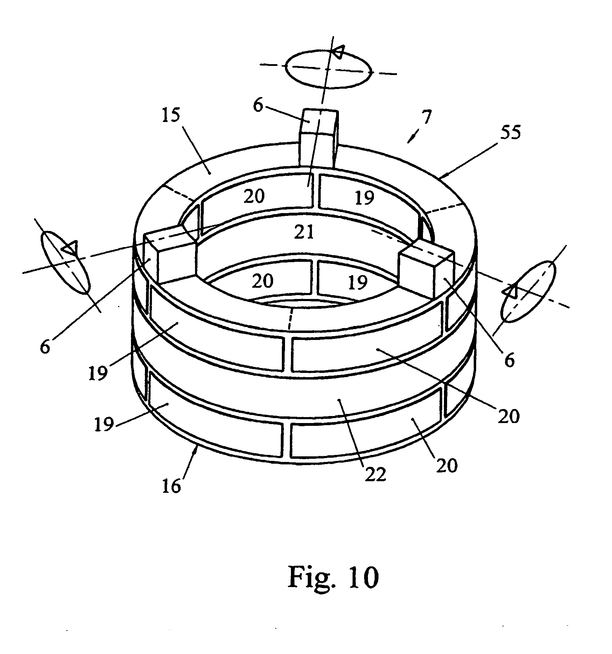

Fig. 10 zeigt eine Konstruktionsvariante des Oszillators 7 in Form des Zylinders 55, der sich aus drei Teilen 52 zusammen setzt (siehe Fig.8), mit einer gemeinsamen Resonanzlänge L=3λ.

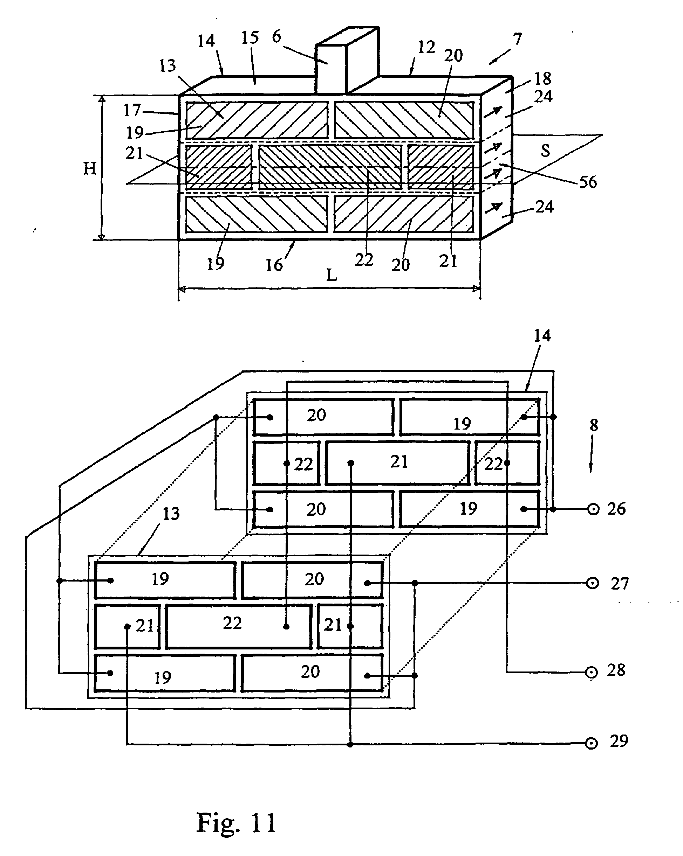

Fig. 11 zeigt den piezoelektrischen Oszillator 7 mit dem Generator 56, der längs seiner Resonanzlänge L eine vorzeichenvariable akustische Stehwelle erzeugt, die sich entlang seiner Resonanzhöhe H ausbreitet. Fig. 11, unterer Teil zeigt eine Konfigurationsvariante der Elektroden 19, 20 und 21, 22 der Generatoren 24 und 56, ihre Anordnung auf der Hauptoberflächen 13, 14 des Oszillators 7 und ihre elektrische Beschaltung mit den Anschlüssen 26, 27 und 28, 29.

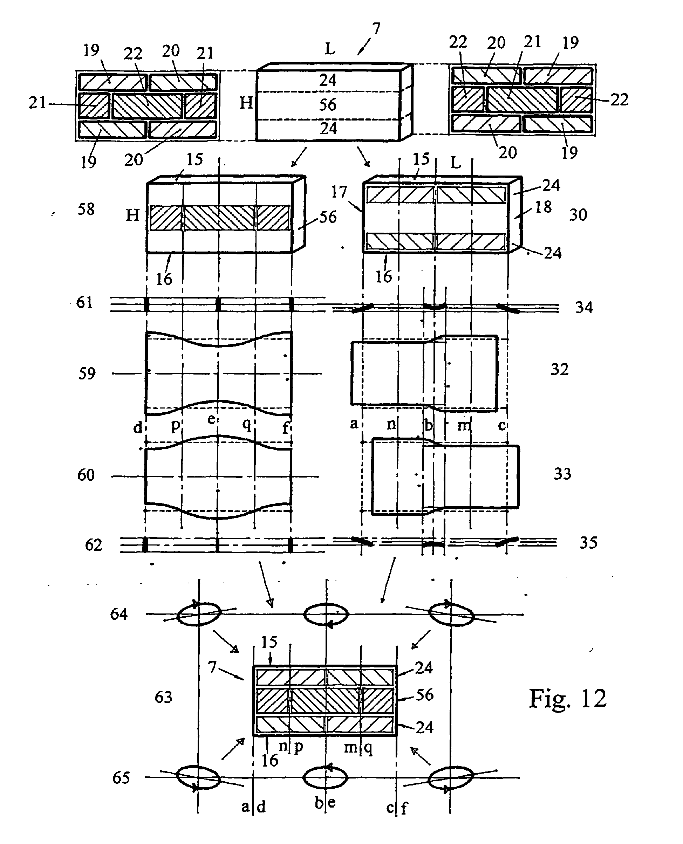

Fig.12 erklärt die Funktionsweise des Oszillators 7 mit dem Generator der akustischen Welle 56. Der Generator 56 erregt im Oszillator 7 eine akustische Longitudinalwelle, die sich entlang seiner Resonanzhöhe H ausbreitet und vorzeichenvariabel längs seiner Resonanzlänge L ist.
Zur Erklärung der Funktionsweise wird das Prinzip der unabhängigen Erregung von akustischen Wellen in dem Oszillator 7 herangezogen. Der in Pos. 30 Fig. 12 dargestellte Oszillator enthält nur den Generator 24 und der in Pos. 58 nur den Generator 56.
Bei einer Erregung des Generators 24 hat der in Pos. 30 gezeigte Oszillator die in Pos. 32, 33 dargestellten Schwingungsformen. Die auf seiner Seitenoberfläche 15, 16 längs der Achsen a, b, c liegende Punkte befinden sich in Schwingungsgeschwindigkeitsmaxima und sie bewegen sich längs der in Pos. 34, 35 dargestellten Längsbahnen. Die auf seinen Seitenoberflächen, längs der Achsen n, m, liegenden Punkte befinden sich in Schwingungsgeschwindigkeitsminima und besitzen nur eine kleine Queramplitude der Schwingungen.
Bei einer Erregung des Generators 56 hat der in Pos. 58 dargestellte Oszillator die in Pos. 59, 60 dargestellten Schwingungsformen. In diesem Fall bewegen sich die auf seinen Seitenoberflächen 15,16 längs der Achsen d, e, f, liegende Punkte längs der in Pos. 61, 62 dargestellten Querbahnen.
In diesem Fall ist die vom Generator 56 erzeugte akustische Welle längs der Resonanzlänge L des Oszillators 7 vorzeichenvariabel. Bei einer solchen Welle ändert sich das Deformationsvorzeichen der Seitenoberflächen 15, 16 längs der Resonanzlänge L.

Die auf seinen Seitenoberflächen 15,16 längs der Achsen p, q liegenden Punkte befinden sich in Schwingungsgeschwindigkeitsminima und sie führen praktisch keine Schwingungen aus.
Bei einer gleichzeitigen Erregung der beiden Generatoren 24 und 56, die zu demselben Oszillator 7 gehören (siehe Pos. 63), kommt es zur Bewegungsüberlagerung der entlang der Achsen ad, be und cf auf den Oberflächen 15,16 liegenden Punkte. Im Ergebnis bewegen sich Punkte, die entlang dieser Achsen liegen längs der in Pos. 64, 65 dargestellten geschlossenen Bahnen. Die Form dieser Bewegungsbahnen kann in erster Näherung als elliptisch angesehen werden.
Da die akustisch stehende, sich entlang der Höhe H des Oszillators 7 ausbreitende Welle, das Deformationsvorzeichen entlang der Resonanzlänge L wechselt, verläuft die Bewegung aller in Schwingungsgeschwindigkeitsmaxima liegenden Punkte in gleicher Richtung. In diesem Fall können die Friktionselemente 6 auf den Seitenoberflächen 15, 16 in allen Schwingungsgeschwindigkeitsmaxima einer akustischen Welle aufgestellt werden, die sich entlang der Resonanzlänge L des Oszillators 7 ausbreitet.
Punkte, die längs der Achsen np, mq liegen, führen keine Schwingungen aus. Sie sind gut geeignet zur Befestigung von fixierenden Elementen 10.

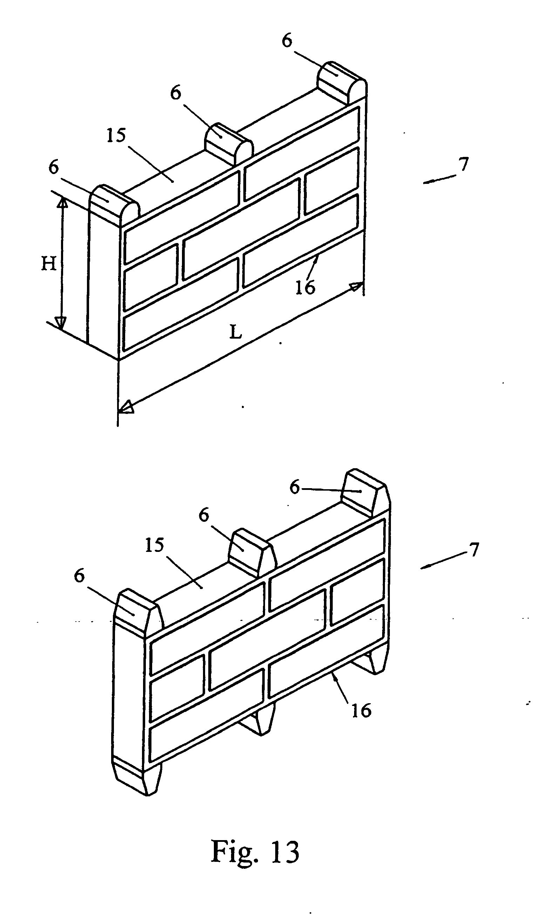

In Fig. 13 sind zwei Konstruktionsvarianten des Oszillators 7 dargestellt, mit der Resonanzlänge L gleich λ, mit den Friktionselementen 6, die auf einer 15 und auf zwei 15, 16 Seitenoberflächen angeordnet sind.

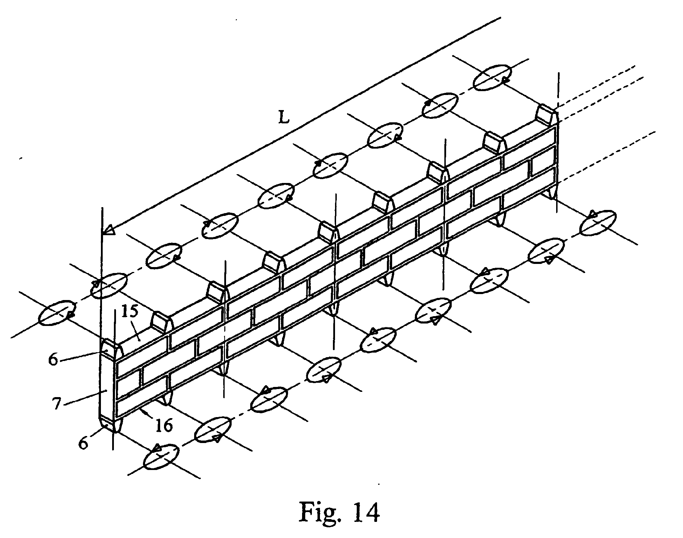

In Fig. 14 ist eine Konstruktionsvariante des piezoelektrischen Oszillators 7 gezeigt, dessen Resonanzlänge L ein ganzzahliges Vielfaches von λ beträgt.

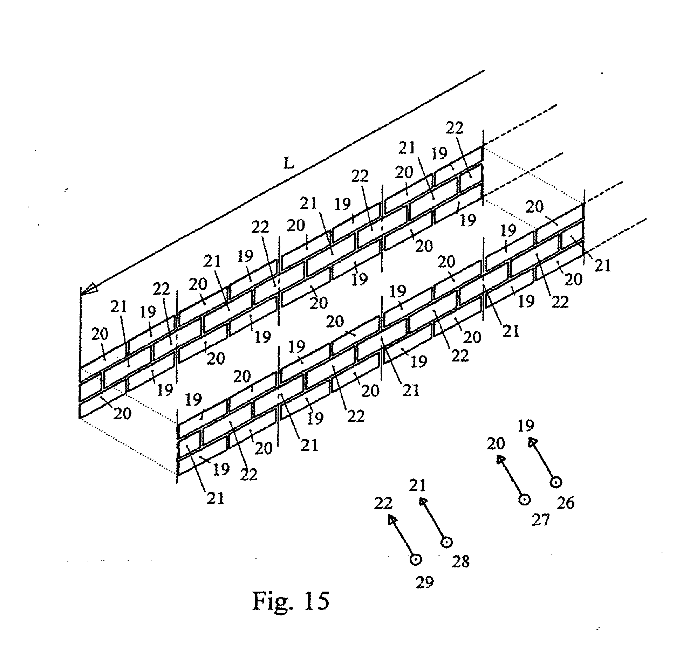

Fig. 15 offenbart eine Anordnung der Elektroden 19, 20, 21, 22 und ihre elektrische Beschaltung mit den Anschlüssen 26, 27, 28, 29 für einen Oszillator 7, dessen Länge ein ganzzahliges Vielfaches von λ beträgt.

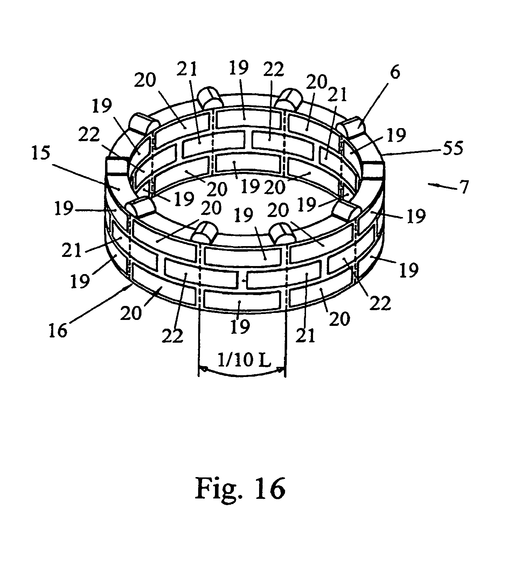

Fig. 16 zeigt den Oszillator 7 in Form eines Zylinders 55, dessen Resonanzlänge L 5λ beträgt.

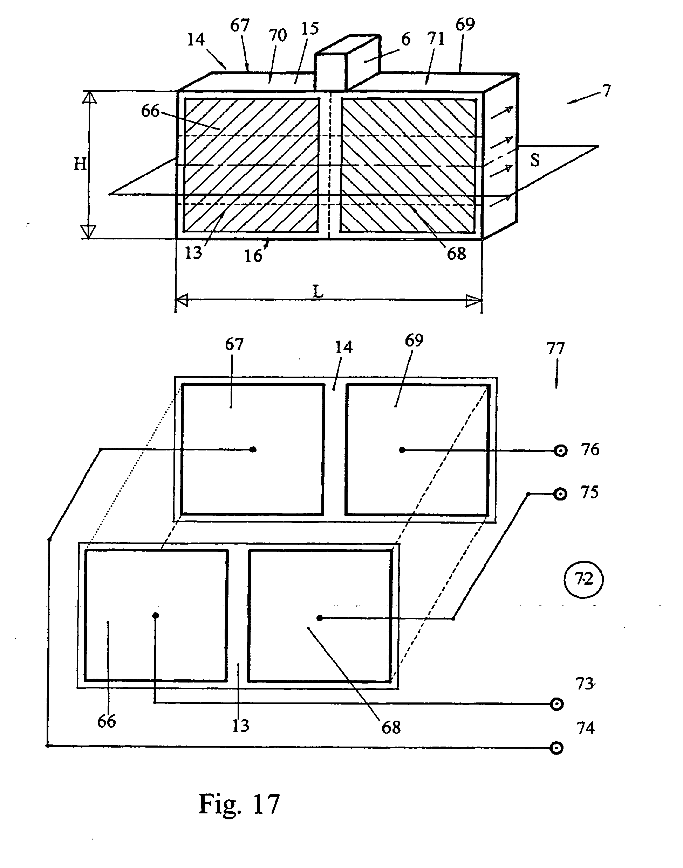

Fig. 17 zeigt eine Konstruktionsvariante des Oszillators 7, dessen Elektroden 19 (siehe Fig. 2) die zu der Oberfläche 13 gehören, mit einem Teil der Elektrode 21 vereinigt sind und gemeinsam die erste vereinte Elektrode 66 bilden. Elektroden 20, die zu der Oberfläche 14 gehören, sind mit einem Teil der Elektrode 22 vereinigt und bilden gemeinsam die zweite vereinte Elektrode 67. Elektroden 20, die zu der Oberfläche 13 gehören, sind mit einem Teil der Elektrode 21 vereinigt und bilden gemeinsam die dritte vereinte Elektrode 68. Elektroden 19, die zu der Oberfläche 14 gehören, sind mit einem Teil der Elektrode 22 vereinigt und bilden gemeinsam die vierte vereinte Elektrode 69.
Die Gruppe der vereinten Elektroden 66, 67 mit der dazwischen liegenden piezoelektrischen Keramik bildet den ersten zusammengesetzten Generator 70 von akustischen Wellen und die Gruppe der vereinten Elektroden 68, 69 mit der dazwischen liegenden piezoelektrischen Keramik bildet den zweiten zusammengesetzten Generator 71 von akustischen Wellen.
Fig. 17 Pos. 72 zeigt eine Konfigurationsvariante der vereinten Elektroden 66, 67, 68, 69 und ihre Anordnung auf den Oberflächen 13, 14 des Oszillators 7. Zur elektrischen Beschaltung der vereinten Elektroden mit der elektrischen Erregerquelle 9 sind sie mit den Anschlüssen 73, 74, 75, 76 ausgestattet und bilden gemeinsam die Elektrodengruppe 77.

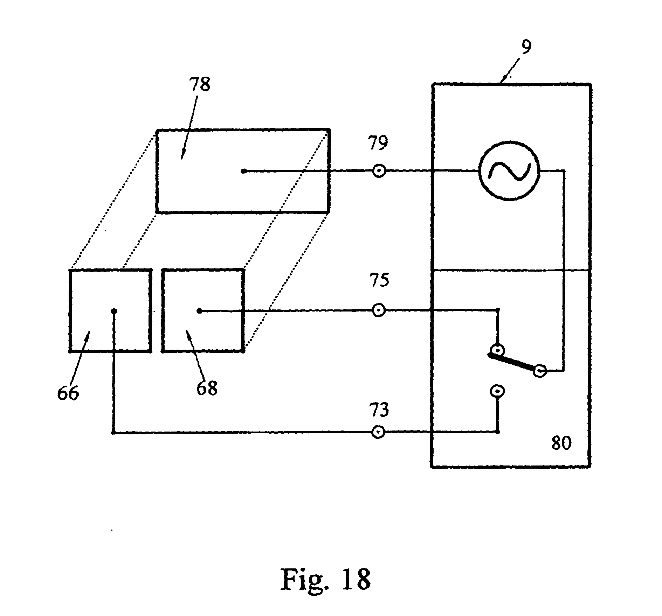

In Fig. 18 ist die Elektrodenkonfiguration des Oszillators 7 dargestellt, bei der zwei vereinte Elektroden 67, 69 miteinander verbunden sind und eine gemeinsame Elektrode 78 bilden, die mit dem Anschluss 79 verbunden ist. Bei einer solchen Motorvariante kann die elektrische Erregerquelle 9 mit einem Elektrodenkommutator 80 ausgestattet werden.

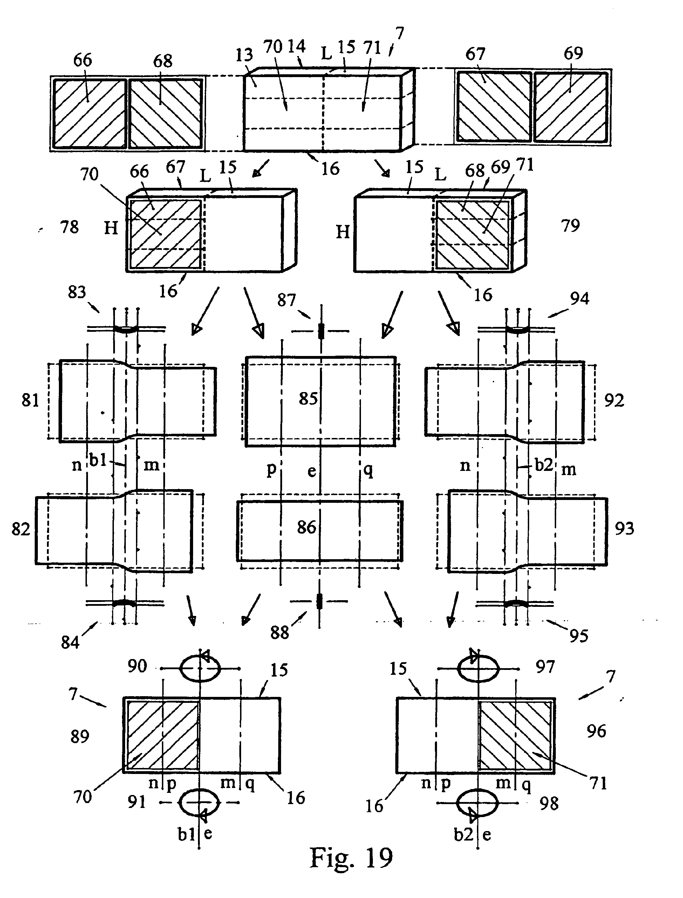

Fig. 19 erklärt die Funktionsweise des Oszillators 7 mit den zusammengesetzten Generatoren der akustischen Wellen 70, 71. Pos. 78 Fig. 19 zeigt einen Oszillator mit einem Generator von akustischen Wellen 70, der sich im linken Oszillatorteil befindet.
Bei einer Erregung dieses Generators wird in dem Oszillator eine stehende akustische Welle erzeugt, die sich längs der Resonanzlänge L ausbreitet. Bei der Ausbreitung dieser Welle hat der Oszillator 7 die in Pos. 81, 82 dargestellten Schwingungsformen. Die auf den Seitenoberflächen 15, 16 längs der Achse b1 liegende Punkte haben die in Pos 83, 84 dargestellten Bewegungsbahnen.
Außerdem wird bei der Erregung des Generators 70 wird in dem in Pos. 78 dargestellten Oszillator eine akustische Longitudinalwelle erzeugt, die sich entlang der Resonanzhöhe H ausbreitet. Bei der Ausbreitung dieser Welle hat der Oszillator 7 die in Pos. 85, 86 dargestellten Schwingungsformen. Die auf den Seitenoberflächen 15, 16 längs der Achse e liegende Punkte haben die in Pos 87, 88 dargestellten Bewegungsbahnen.
Da sich im Oszillator diese Wellen gleichzeitig ausbreiten, kommt es zur Bewegungsüberlagerung der auf den Oberflächen 15,16 längs der Achsen b1e liegenden Punkte, was in Pos. 89 dargestellt ist. Im Ergebnis bewegen sich diese Punkte entlang der in Pos. 90, 91 dargestellten und mit Pfeilen angedeuteten geschlossenen Bahnen.
In Pos. 79 ist ein Oszillator dargestellt, bei dem der zusammengesetzte Generator der akustischen Wellen sich in seinem rechten Teil befindet. Bei einer Erregung dieses Generators wird in dem Oszillator eine akustische Longitudinalwelle erzeugt, die sich längs der Resonanzlänge L ausbreitet. Die Schwingungsphase dieser Welle ist um 180° bezüglich der gleichen, von dem zusammengesetzten Generator 70 erzeugten Welle verschoben. Bei der Erregung des Generators 71 hat der Oszillator die in Pos. 92, 93 gezeigten Schwingungsformen, und Punkte der Oberflächen 15, 16, die sich längs der Achse b2 befinden, bewegen sich längs der Bewegungsbahnen, die in Pos. 94, 95 dargestellt sind. Außerdem wird bei der Erregung des Generators 71 im Oszillator 7 eine akustische Longitudinalwelle erzeugt, die sich entlang der Resonanzhöhe H ausbreitet. Die Schwingungsphase dieser Welle ist phasengleich mit der von dem Generator 70 erzeugten Welle.
Die Pos. 96 zeigt eine Bewegungsüberlagerung der auf den Oberflächen 15,16 längs der Achse b2e liegenden Punkte als Folge einer Ausbreitung von zwei Wellen im Oszillator 7, die vom Generator 71 erzeugt werden. Die Bewegungsbahnen dieser Punkte sind in Pos. 97, 98 dargestellt. In diesem Fall haben die Punkte eine entgegengesetzte Bewegungsrichtung im Vergleich zu der Erregung des Generators 70.
In beiden Fällen sind die Bewegungsbahnen in Pos. 90, 91 und 97, 98 dargestellt und können bei erster Näherung als Ellipsen angesehen werden.
Stellen der Oberflächen 15, 16 längs der Achsen b1, b2 sind die Befestigungspunkte der Friktionselemente 6.
Punkte entlang der Achsen np, mq auf den Oberflächen 15, 16 befinden sich in Schwingungsgeschwindigkeitsminima der sich entlang der Resonanzlänge L des Oszillators 7 ausbreitenden Welle und sind optimal zur Befestigung der fixierenden Elemente 10 geeignet.

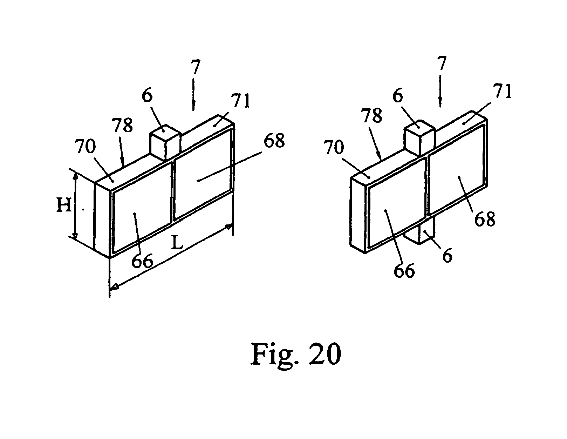

In Fig. 20 sind zwei Oszillatoren 7 mit den Generatoren 70, 71 dargestellt, deren Resonanzlänge L gleich λ ist.

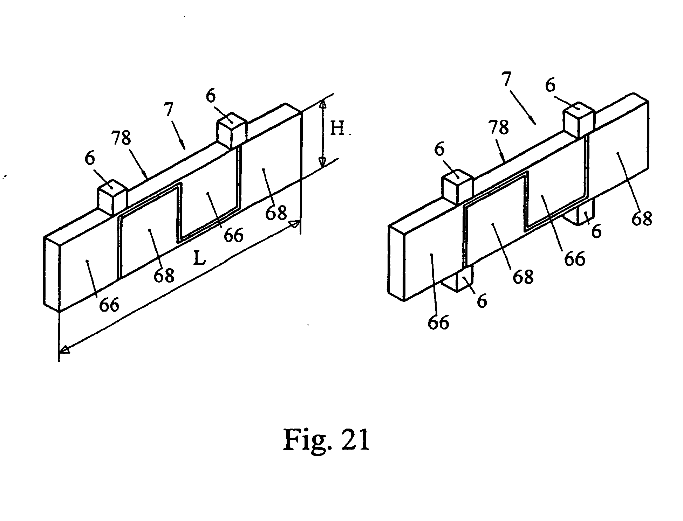

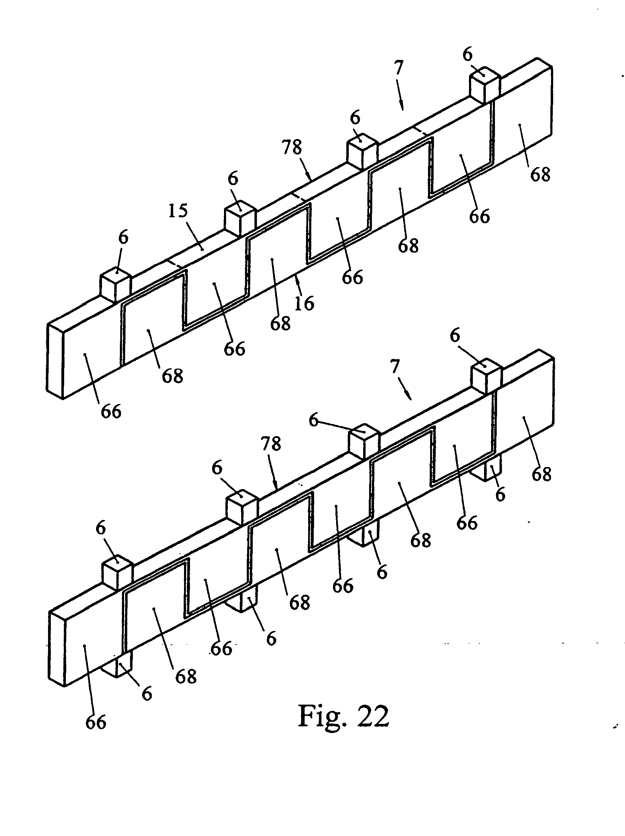

Die in Fig. 21 dargestellten Oszillatoren 7 haben eine Resonanzlänge L gleich 2λ. Die in Fig. 22 dargestellten Oszillatoren 7 haben eine Resonanzlänge L gleich 4λ.

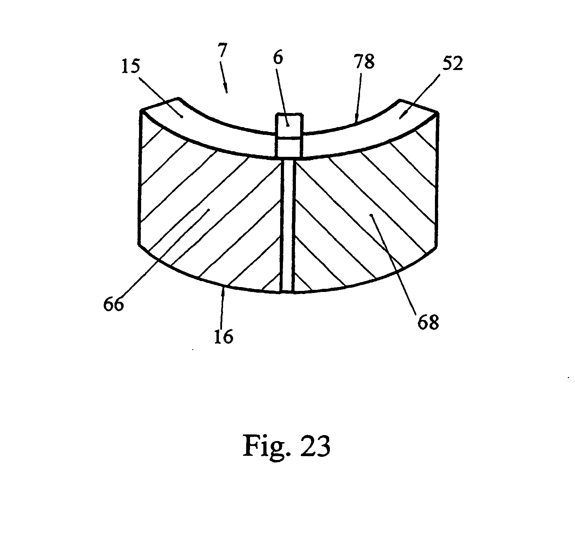

Fig. 23 zeigt den Oszillator 7 in Form des Zylinderteils 52, dessen Resonanzlänge L gleich λ ist.

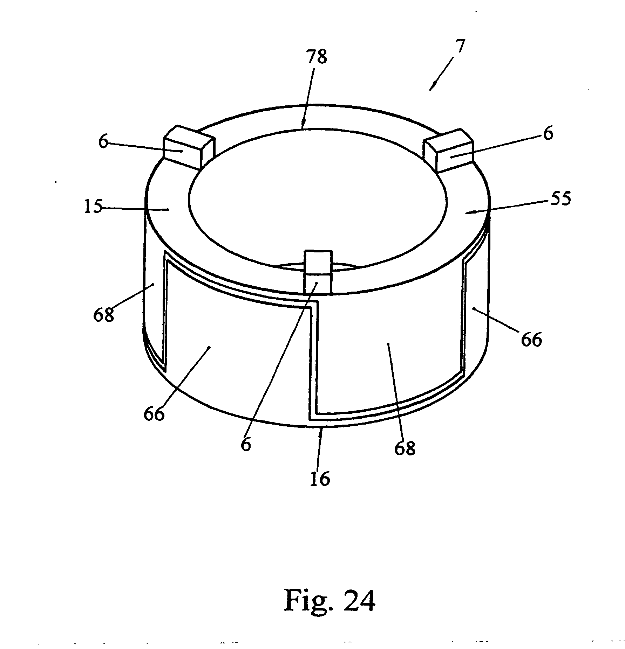

Fig. 24 zeigt den Oszillator 7 in Form des Zylinders 55, dessen Resonanzlänge L gleich 3λ ist.

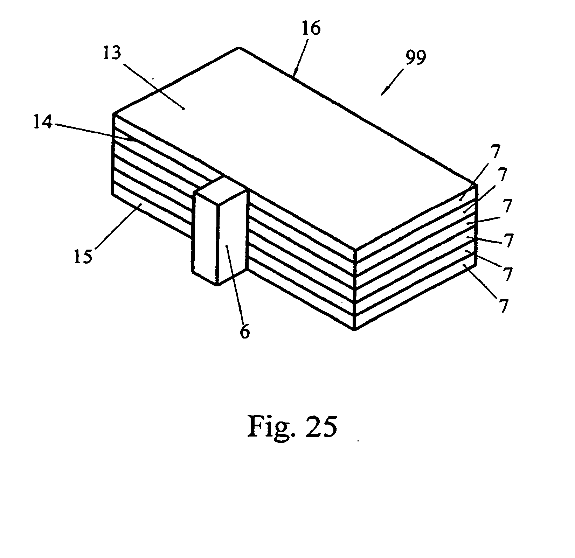

Fig. 25 zeigt einen piezoelektrischen Oszillator, der zwei oder mehrere Oszillatoren 7 enthält, die so miteinander verbunden sind, daß ein gemeinsamer elektromechanischer Resonator 99 gebildet wird. Eine solche Verbindung kann mittels eines festen organischen Klebers durchgeführt werden, z.B. eines Klebers auf der Basis der Epoxydharzes oder durch Sintern.

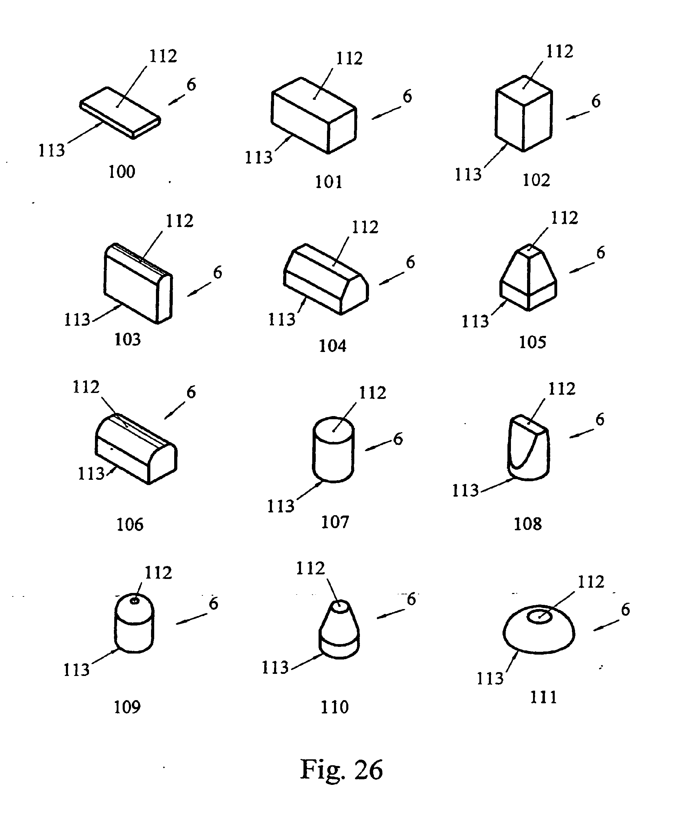

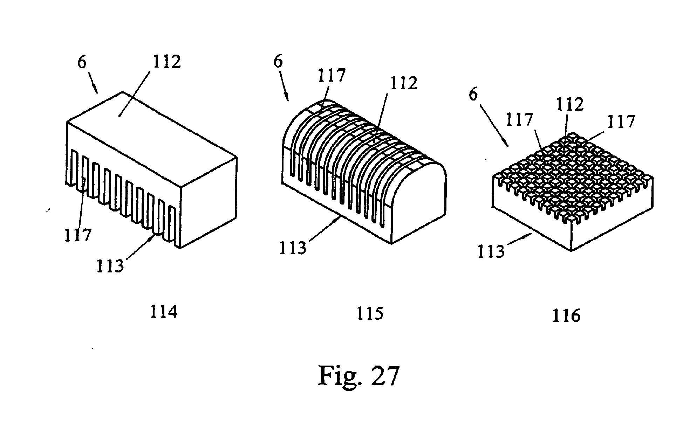

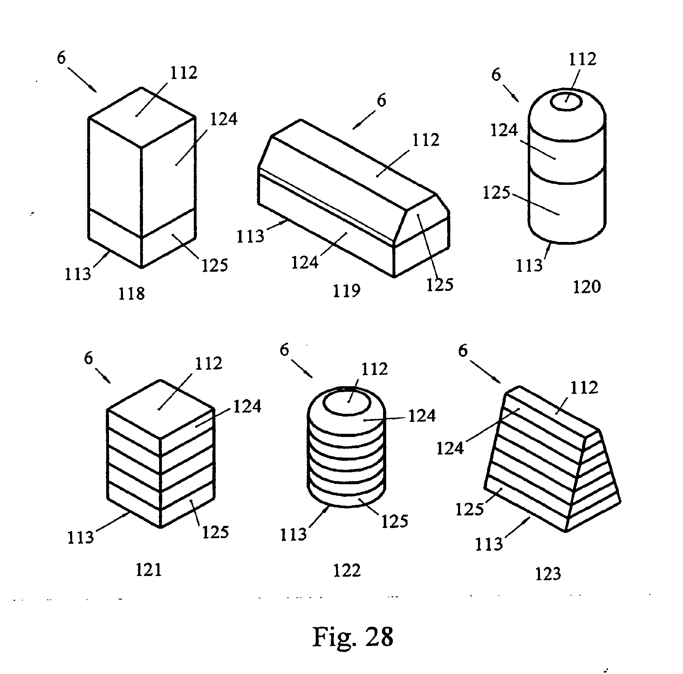

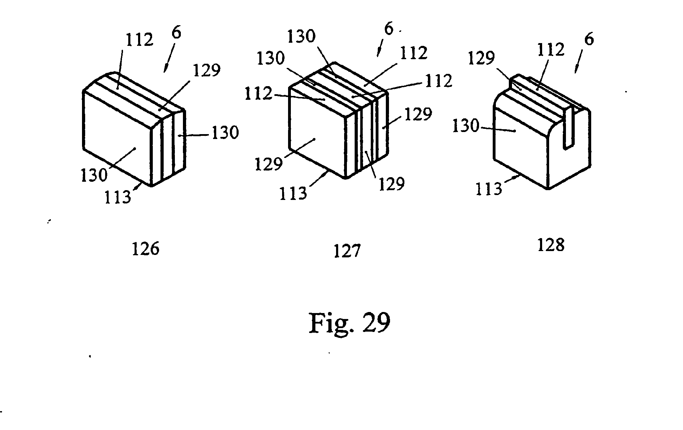

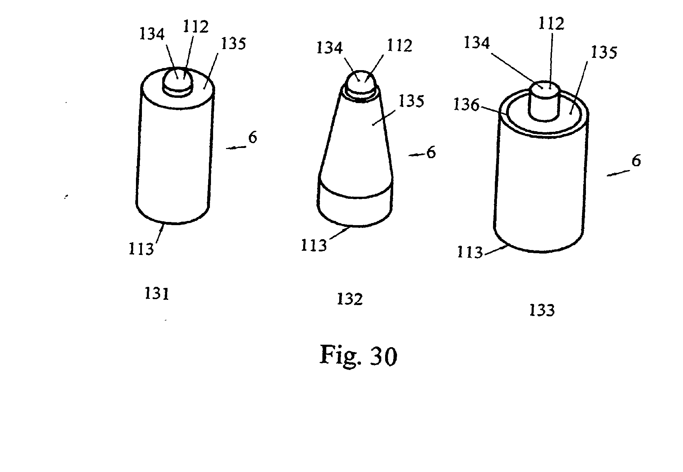

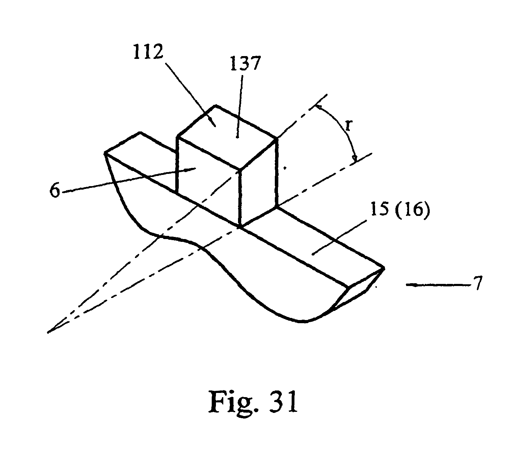

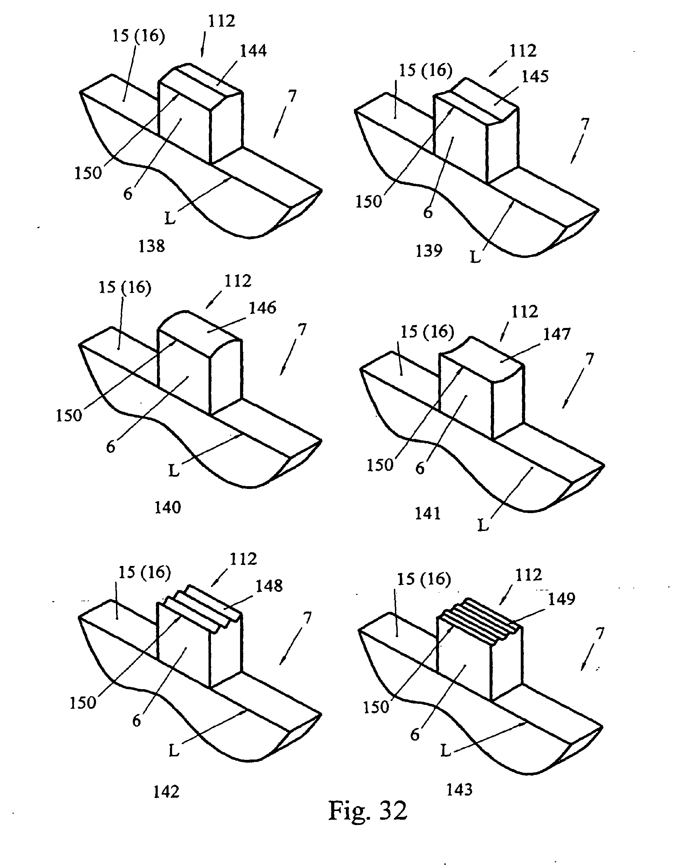

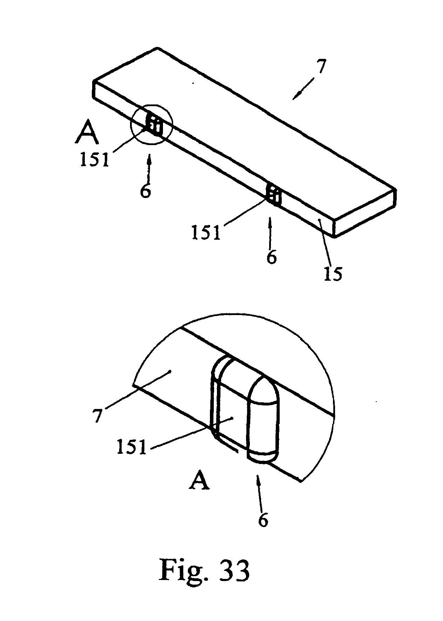

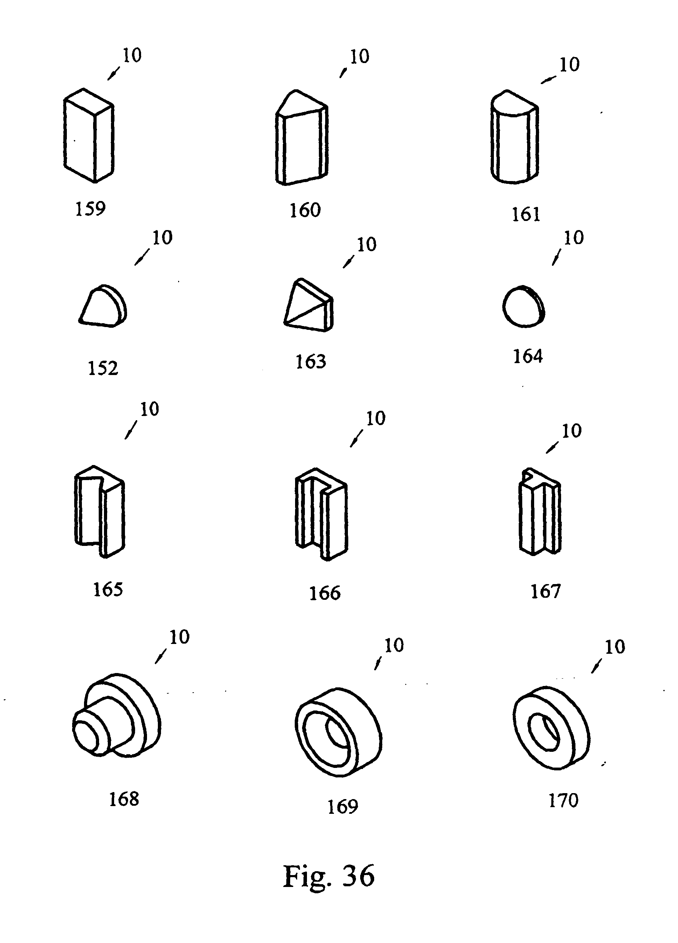

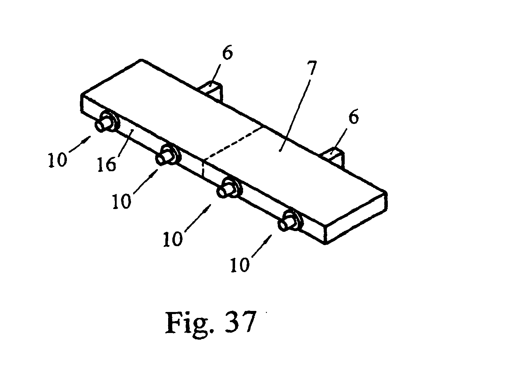

In Fig. 26 sind mögliche Konstruktionsvarianten des Oszillators 7 dargestellt. Die Friktionselemente können als Streifen 100, als Stäbchen oder Prismen 101, 102, 103, als pyramidenförmige Elemente 104,105, als halbsphärische Elemente 106, als zylindrische Elemente 107, 108, 109, als kegelförmige Elemente 110 oder als halbsphärische Elemente 111 gefertigt werden.
Jedes Friktionselement 6 hat die Funktionsoberfläche 112, mit der es in einem Friktionskontakt mit der Friktionsschicht 4 steht und eine Verbindungsoberfläche 113, mit der es mit der Seitenoberfläche 15 oder 16 des Oszillators 7 verbunden wird.
Die Friktionselemente 6 werden aus einem harten, verschleißfesten Werkstoff gefertigt, z.B. Oxidkeramik, Metallkeramik, oder ihrer Kompositionen mit anderen Werkstoffen. Es können auch spezielle Sorten von harten verschleißfesten Kunstoffen verwendet werden.
In Pos. 114, 115, 116 Fig. 27 sind Friktionselemente 6 dargestellt, die Quernute 117 besitzen. Die Quernute 117 können sowohl von der Seite der Verbindungsfläche 113 Pos. 114 als auch von der Seite der Funktionsoberfläche 112 Pos. 115 angebracht werden. Sie können auch senkrecht zueinander angeordnet werden, Pos.116.
Die Friktionselemente 6 können eine zwei- oder mehrschichtige Struktur haben, so wie es in Pos. 118, 119, 120, 121, 122, 123 der Fig. 28 dargestellt ist. Jede Schicht dieser Struktur ist parallel zu den Seitenoberflächen 15, 16 des Oszillators 7 angeordnet. Dabei ist die obere Schicht 124 dieser Struktur eine verschleißfeste Schicht. Sie enthält die Funktionsoberfläche 112. Die untere Schicht 125 dieser Struktur ist eine verbindende Schicht. Sie enthält die verbindende Oberfläche 113.
Die Schichten 124, 125 und die dazwischen liegende Schicht können einen unterschiedlichen Elastizitätsmodul haben. Die verschleißfeste Schicht 124 kann einen Elastizitätsmodul besitzen, der durch die Verschleißfestigkeit und mechanische Festigkeit der Funktionsoberfläche 112 bestimmt wird, und die verbindende Schicht des Friktionselements kann einen Elastizitätsmodul aufweisen, der nahezu gleich dem Elastizitätsmodul der piezoelektrischen Keramik des Oszillator 7 ist.
Die Friktionselemente 6, die in Pos. 126, 127, 128 Fig. 29 dargestellt sind, haben die Schichten 129, 130, die senkrecht zu den Seitenoberflächen 15, 16 des Oszillators 7 angeordnet sind. In dieser Konstruktionsvariante der Friktionselemente sind die Schichten 129 verschleißfeste Schichten und die Schichten 130 dämpfende Schichten. Die dämpfenden Schichten 130 gewährleisten eine dynamische Stabilität der verschleißfesten Schichten.
Die verschleißfeste Schicht 129 kann einen Elastizitätsmodul haben, der durch Verschleißfestigkeit und Festigkeit seiner Funktionsoberfläche gekennzeichnet ist, und die dämpfende Schicht 130 kann einen Elastizitätsmodul haben, der durch die dynamische Stabilität der verschleißfesten Schicht 129 bestimmt wird.
Die Friktionselemente 6, die in Pos. 131, 132, 133 Fig.30 dargestellt sind, bestehen aus den zylinderförmigen Schichten 134, 135, 136. Diese Schichten sind konzentrisch angeordnet. Die Schicht 134 ist eine Friktionsschicht. Sie enthält die Funktionsoberfläche 112. Die Schicht 135 ist eine dämpfende Schicht. Sie gewährleistet eine dynamische Stabilität der Friktionsschicht 134. Die Schicht 136 ist eine Schutzschicht.
Die Schichten 124, 125, die dazwischen liegenden Schichten 129, 130 und die Schichten 134, 135, 136 können aus monolithischen Materialien gefertigt werden und z.B. durch Sintern miteinander verbunden werden.
Die verbindende Schicht 125 einer zwei- oder mehrschichtigen Struktur der Friktionselemente 6 kann aus einem porösen Werkstoff hergestellt werden. Außerdem kann ein Teil der zwei- oder mehrschichtigen Struktur der Friktionselemente 6, die in Pos. 121, 122, 123 Fig. 28 dargestellt ist, aus einem porösen Werkstoff mit variabler Porosität bestehen. Dabei kann die verbindende Schicht 124 eine maximale Porosität besitzen, wobei die verschleißfeste Schicht 125 nicht porös ist.
Die dämpfenden Schichten 130, 135 (siehe Fig. 29, 30) können auch aus einem porösen Werkstoff hergestellt werden. Bei den Friktionselementen 6 mit der ebenen Funktionsoberfläche 112 kann diese Oberfläche als eine geneigte Fläche 137 ausgeführt werden, so wie es in Fig. 31 dargestellt ist. Die geneigte Funktionsoberfläche 137 wird unter dem Winkel r zu der Seitenoberfläche 15 oder 16, auf der die Friktionselemente 6 angebracht sind, angeordnet.
Die Funktionsoberfläche 112 der Friktionselemente 6 kann die in Fig. 32 Pos. 138, 139, 140, 141, 142, 143 dargestellte Form haben. Sie kann die dreieckige konkave (143) oder konvexe (144) Form, die runde konkave(145) oder konvexe (146) Form oder eine rippenförmige (147, 148) Form besitzen. Die Rippen oder Rillen 149 der Funktionsoberfläche 112 sind längs der Resonanzlänge L des piezoelektrischen Oszillators 7 angeordnet. Die Funktionsoberfläche 112 kann auch eine andere ähnliche Form haben.
Die Friktionselemente 6 können mit den Oberflächen 15, 16 des piezoelektrischen Oszillators 7 mittels eines organischen Werkstoffs verbunden werden, z.B. mit Epoxydharz. Die Friktionselemente 6 können auch mit einem Stoff mit der Oberfläche der piezoelektrischen Oszillator 7 verbunden werden, der eine chemische Bindung mit der piezoelektrischen Keramik eingeht, z.B. mittels bleihaltigen leichtschmelzenden Glases.
Alle Poren der Friktionselementen 6 oder ein Teil davon können mit einem Stoff aufgefüllt werden, der das Friktionselement 6 mit den Oberflächen 15, 16 der piezoelektrischen Oszillators 7 verbindet.
Die Quernute 17 können vorteilhaft mit einem schalldämpfenden Stoff aufgefüllt werden.
Die Friktionselemente 6 können als Glasstreifen 150 gefertigt werden, die auf die Seitenoberfläche 15 oder 16 des piezoelektrischen Oszillators 7 aufgeschmolzen sind, so wie es in Fig. 33 dargestellt ist.
Dabei können die als Glasstreifen 150 gefertigten Friktionselemente mit Pulver eines verschleißfesten Stoffes beschichtet werden, z.B. mit Pulver von Aluminiumoxid, Zirkonoxid, Wolframcarbid, Titancarbid oder einem anderen ähnlichen Stoff.

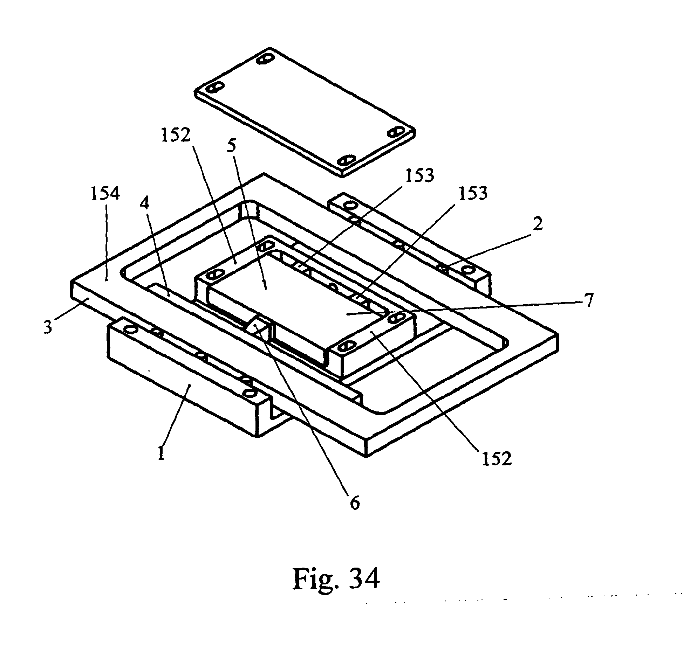

Fig. 34 zeigt einen piezoelektrische Motor mit speziellen Halterungen 152 des piezoelektrischen Oszillators 7, die seine Verschiebung in Richtung seiner Resonanzlänge L verhindern. Die Anpressung des Friktionselements 6 des Oszillators 7 an die Friktionsschicht 4 in dieser Motorvariante wird mit Hilfe von elastischen Elementen 153 durchgeführt, die als Streifen aus Gummi oder anderen ähnlichen Werkstoffes hergestellt sind.
In der betrachteten Motorvariante wird das getriebene Element 3 als ein das treibende Element 5 umfassender Rahmen 154 ausgeführt.

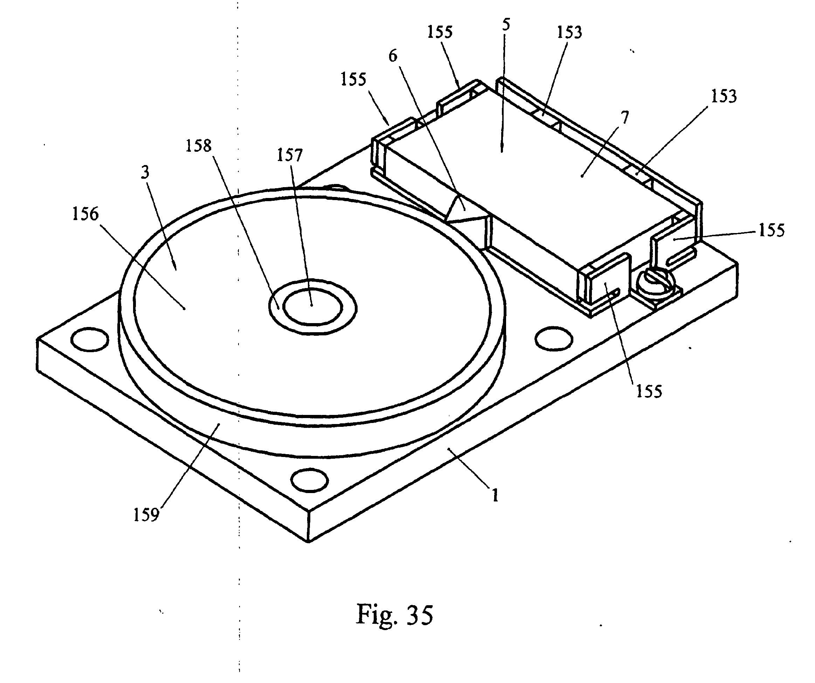

Fig. 35 zeigt eine Konstruktionsvariante des piezoelektrischen Motors, in dem die die Verschiebung des Oszillators verhindernden Elemente 155 als mechanische Resonatoren dienen, deren Resonanzfrequenz mit der Schwingungsfrequenz des piezoelektrischen Oszillators 7 übereinstimmt.
In der Motorvariante, die in Fig. 35 dargestellt ist, kann das getriebene Element 3 in Form eines Zylinders oder einer Scheibe 156 realisiert werden, die auf der Welle 157 in dem Lager der Rotationsbewegung 158 aufgestellt wird.
In dem vorgeschlagenen Motor kann der piezoelektrische Oszillator 7 mit mindestens einem fixierenden Element 10 ausgestattet werden, das starr mit dem Oszillator verbunden ist.
Die Konstruktionen der fixierenden Elmente 10 sind in den Pos. 159 bis 170 Fig. 36 dargestellt. So können die fixierenden Elemente in Form von rechteckigen Prismen (159), dreieckigen Prismen (160), halbzylindrischen Prismen (161) ausgebildet sein oder kegelförmige Elemente (162), pyramidenförmige Elemente (163), halbsphärische Elemente (164), rechteckige Elemente mit Profilnuten (165) oder herausragende Elemente (167), als zylindrische Stufenelemente(168), runde Elemente mit Profilbohrungen (169, 170) bzw. andere ähnliche Elemente darstellen.
Die fixierenden Elemente 10 können aus einem Werkstoff hergestellt werden, dessen Elastizitätsmodul gleich oder ein wenig größer als der Elastizitätsmodul der piezoelektrischen Keramik des piezoelektrischen Oszillators 7 ist, z.B. aus Oxidkeramik.
Die fixierenden Elemente 10 können aus einem Werkstoff bestehen, dessen Elastizitätsmodul viel kleiner als der Elastizitätsmodul der Piezokeramik des piezoelektrischen Oszillators 7 ist, z.B. aus speziellen Kunststoffsorten. Die fixierende Elemente 10 können aus derselben Piezokeramiktyp gefertigt werden wie der piezoelektrische Oszillator 7.
Jedes fixierende Element 10 oder eines seiner Teile kann aus einem porösen Werkstoff gefertigt werden.
Die fixierenden Elemente 10 können mittels eines starren organischen Stoffes, z.B. eines Klebers auf der Basis von Epoxydharz, mit den Seitenoberflächen 15, 16 des piezoelektrischen Oszillators 7 verbunden werden.
Die fixierenden Elemente 10 können mittels eines Stoffes mit den Seitenoberflächen 15, 16 der piezoelektrischen Oszillator 7 verbunden werden, der eine chemische Bindung mit der piezoelektrischen Keramik oder einer auf den Seitenoberflächen 15, 16 angebrachten Zwischenschicht und mit dem Material des fixierenden Elements eingeht, z.B. mittels bleihaltigen leichtschmelzenden Glases.
Als Beispiel zeigt Fig. 37 den piezoelektrischen Oszillator 7 mit den auf ihn angebrachten fixierenden Elementen 10, die als zylindrische stufenförmige Elemente ausgeführt sind, so wie es in Pos. 168 Fig. 35 dargestellt ist.

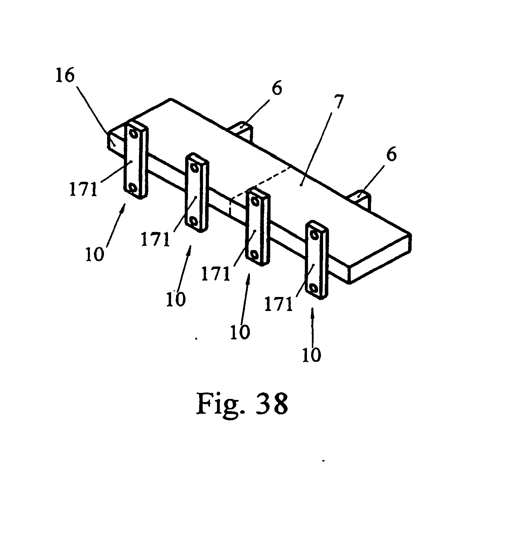

Fig. 38 zeigt eine Variante des Oszillators 7, in dem die fixierenden Elemente 10 als Resonanzbiegeplatten oder Balken 171 ausgeführt werden.

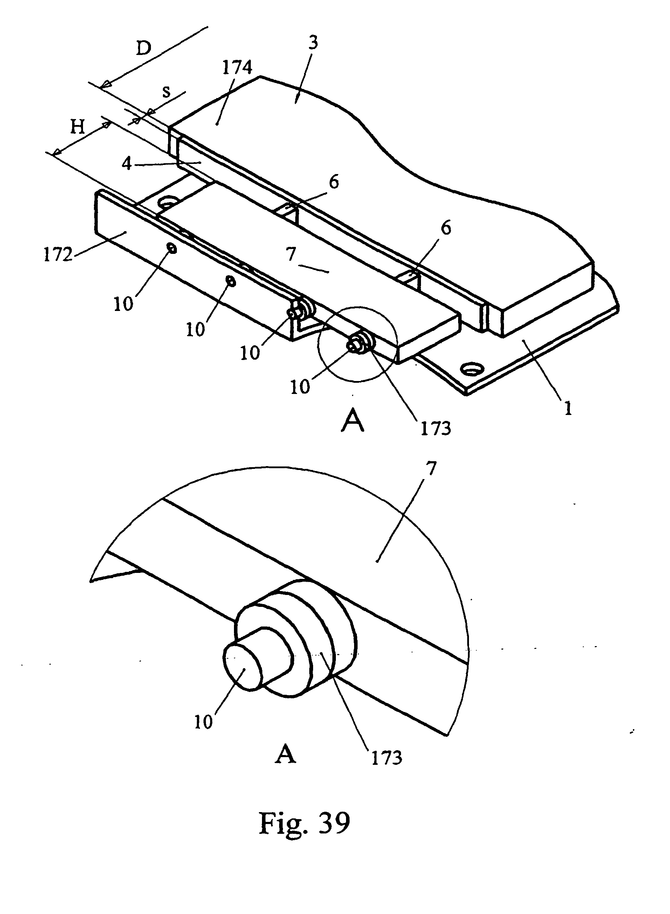

Fig. 39 zeigt eine Konstruktionsvariante des vorgeschlagenen Motors, bei dem die fixierenden Elemente 10 in festen Stützträgern 172 aufgestellt werden. Bei dieser Konstruktionsvariante des Motors wird der Oszillator 7 an der Friktionsschicht 4 mit Hilfe der fixierenden Elemente 173 befestigt, die als Ringe aus Gummi oder aus einem anderen ähnlichen Werkstoff hergestellt werden.
In dieser Motorvariante ist das getriebene Element 3 in Form einer rechteckigen Plattform 174 ausgeführt, auf deren Seitenoberfläche die Friktionsschicht 4 angeordnet ist.

Im vorgeschlagenen Motor wird die Friktionsschicht 4 als Streifen aus Oxidkeramik oder aus einem anderen ähnlichen Stoff gefertigt, z.B. Zirkonoxid, Wolframcarbid, Titancarbid, Siliziumoxid.
Die Dicke der Friktionsschicht S (siehe Fig. 39) kann mindestens fünf mal kleiner als die Resonanzhöhe H des piezoelektrischen Oszillators 7 sein.
Die Körperdicke D des sich unter der Friktionsschicht 4 befindlichen Friktionselements 3 kann größer als die Resonanzhöhe H des piezoelektrischen Oszillators 7 sein. Im vorgeschlagenen Motor kann das getriebene Element 3 aus Metall, Keramik oder Kunststoff hergestellt werden.

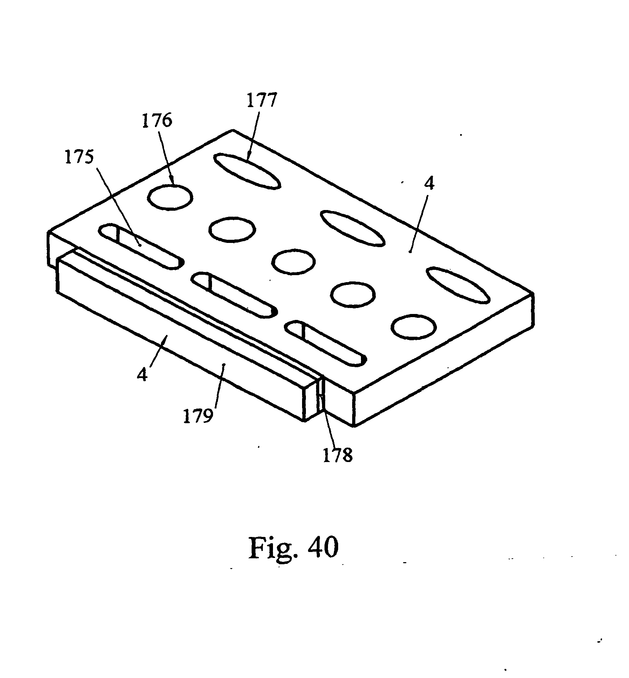

Fig. 40 zeigt ein getriebenes Element, in dessen Körper rechteckige 175, runde 176 oder elliptische 177 Dämpfungsbohrungen eingebracht sind.
Das getriebene Element 3 kann aus einem harten porösen Werkstoff hergestellt werden, z.B. aus porösem Aluminium. Poren des getriebenen Elementen 3 können mit einem schalldämpfenden Werkstoff aufgefüllt werden.
Zwischen dem Körper des getriebenen Elements 3 und der Friktionsschicht 4 kann eine dünne dämpfende Schicht 178 (Fig. 40) angeordnet sein, die aus einem viskosen organischen oder einem porösen Werkstoff oder aus ihren Kompositionen hergestellt wird.
Im vorgeschlagenen Motor besitzt jede Friktionsschicht 4 eine Funktionsoberfläche 179, die in Friktionskontakt mit den Friktionselementen 6 steht. Diese Funktionsfläche kann glatt sein oder eine andere, in Fig. 40 dargestellte Form aufweisen.

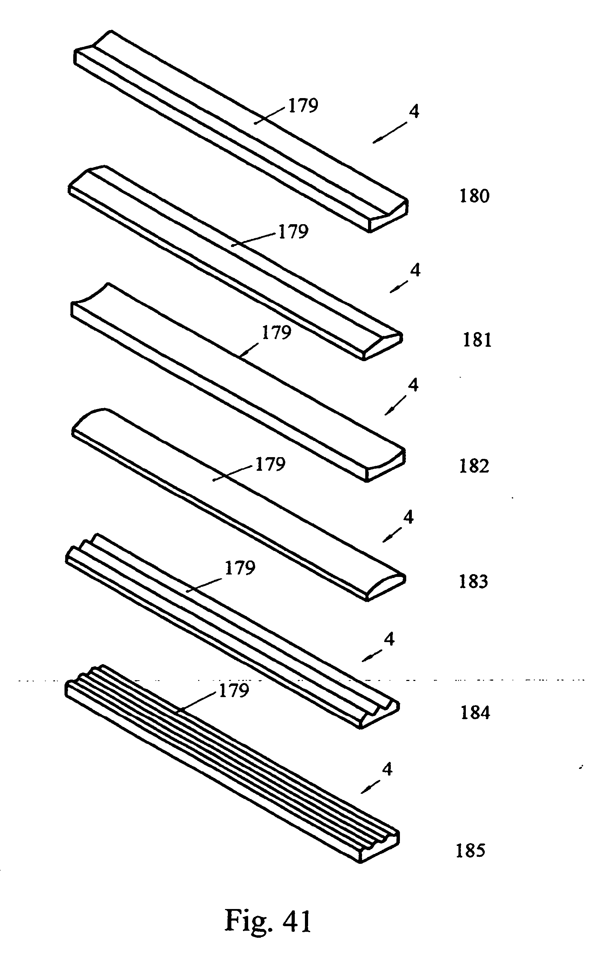

Fig. 41 Pos. 180 bis 185 zeigen verschiedene Varianten der Funktionsoberflächen 179. Die Funktionsoberfläche 179 kann die dreieckige konkave (180) oder konvexe (181) Form, runde konkave(182) oder konvexe (183) Form oder eine rippenförmige (147, 148) Form haben. Die Funktionsoberfläche 112 kann auch eine andere ähnliche Form haben.

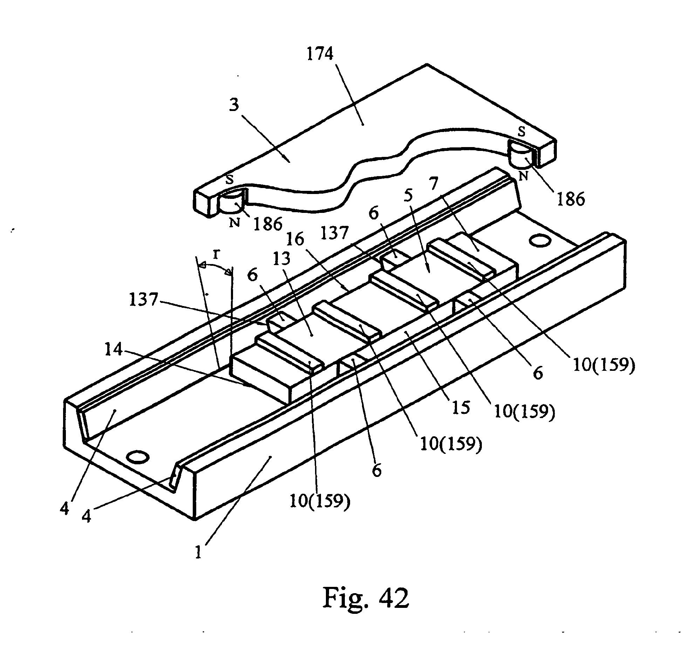

Fig. 42 zeigt eine Konstruktionsvariante des vorgeschlagenen Motors, bei dem die zwei Friktionsschichten 4 sich gegenüber und unter dem Winkel r zu den Seitenoberflächen 15, 16 des Oszillators 7 an dem Gehäuse 1 befestigt sind. Der Oszillator 7 besitzt vier Friktionselemente 6, die paarweise auf den Seitenoberflächen 15, 16 angeordnet sind. Die Friktionselemente 6 sind ebenso mit den geneigten Funktionsoberflächen 137 ausgeführt und unter dem Winkel r zu den Seitenoberflächen 15, 16 des Oszillators 7 angeordnet. Die fixierenden Elemente 10 (159) dieser Motorvariante sind mit einer ihrer Seiten auf der Hauptoberfläche 13 und mit der zweiten an dem getriebenen Element 3 befestigt, das als rechteckige Plattform 174 ausgeführt ist. Das Anpressen des Oszillators 7 an die Friktionsschichten 4 geschieht mit Hilfe der Magneten 186, die auf den getriebenen Element 3 befestigt sind.

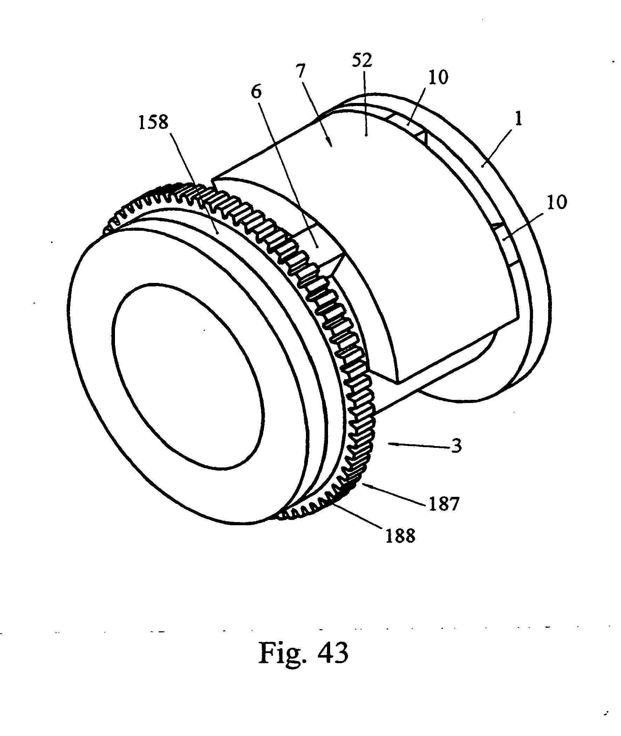

Fig. 43 zeigt eine Konstruktionsvariante des vorgeschlagenen Motors, in dem der Oszillator 7 als ein Zylinderteil 52 ausgeführt ist. Dieser Motor besitzt das getriebene Element 3, das als ein Hohlzylinder oder Ring 187 ausgeführt ist. Die Außenoberfläche des getriebenen Elements ist mit einem Zahnrad 188 versehen.

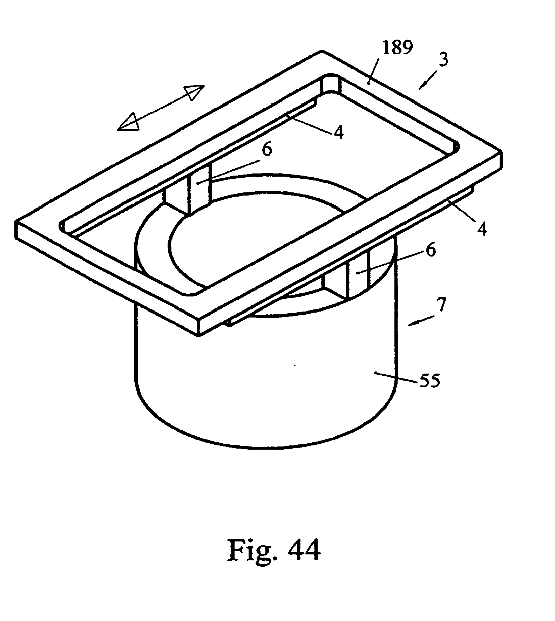

Fig. 44 erklärt die Funktionsweise eines Motors, in dem der Oszillator 7 als Zylinder 55 mit der Resonanzlänge L=2λ ausgeführt ist. In diesem Motor besitzt der Oszillator 7 zwei Friktionselemente 6 und das getriebene Element 3, welches als ein Rahmen 189 ausgeführt ist, der zwei parallele und in einer Ebene liegende Friktionsschichten 4 enthält.

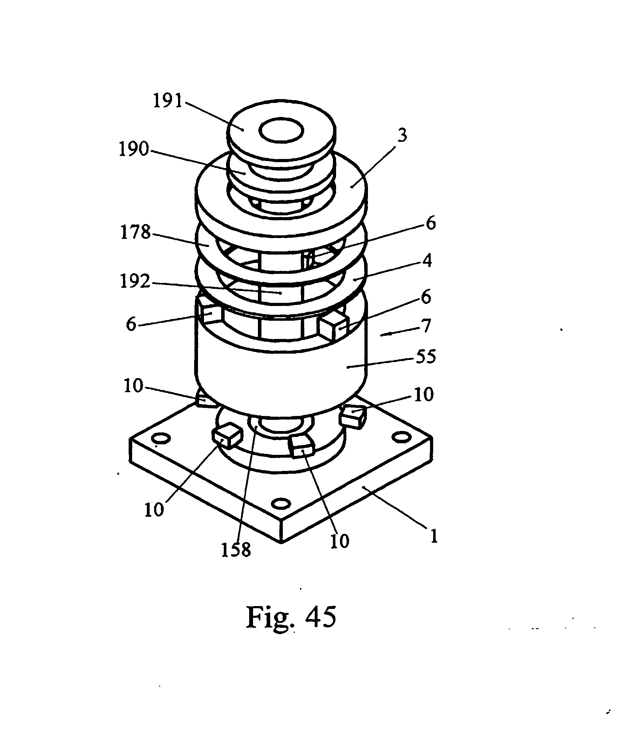

Fig. 45 zeigt eine Konstruktionsvariante des vorgeschlagenen Motors, in dem der Oszillator 7 als Zylinder 55 mit der Resonanzlänge L=3λ ausgeführt ist. Der Oszillator 7 besitzt drei Friktionselemente 6. Sein getriebenes Element 3 ist in Form eines Ringes ausgeführt, der mit Hilfe der elastischen Zwischenlage 190 und des an der Welle 192 befestigten Flansches 191 an den Oszillator 7 angepresst wird.

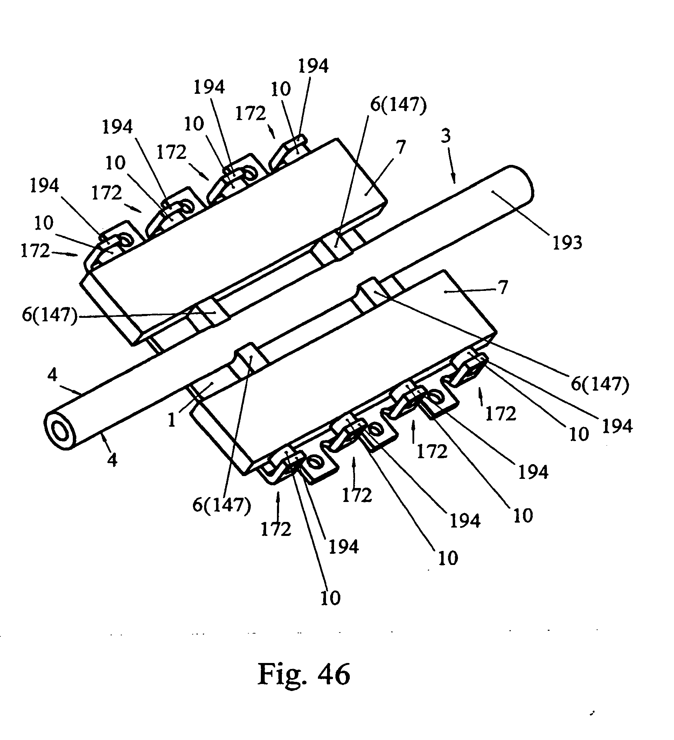

Fig. 46 zeigt einen Linearmotor, der zwei gegenüberliegende Oszillatoren 7 und zwei, sich auf den zwei gegenüberliegenden Seiten des getriebenen Elements befindende Friktionsschichten 4 einschließt.

Bei einem solchen Motor kann das getriebene Elemente 3 aus einem Balken mit rundem Querschnitt oder aus einem Rohr 193 hergestellt werden, so wie es Fig. 46 darstellt. Hier kann die Balkenaußenoberfläche 193 die Funktion der Friktionsschicht 4 ausführen. Das Anpressen des Oszillators 7 an die Friktionsschicht 4 kann in diesem Motor mit Hilfe der starren Stützträger 172 gewährleistet werden, die als flache Feder 194 gefertigt sind.

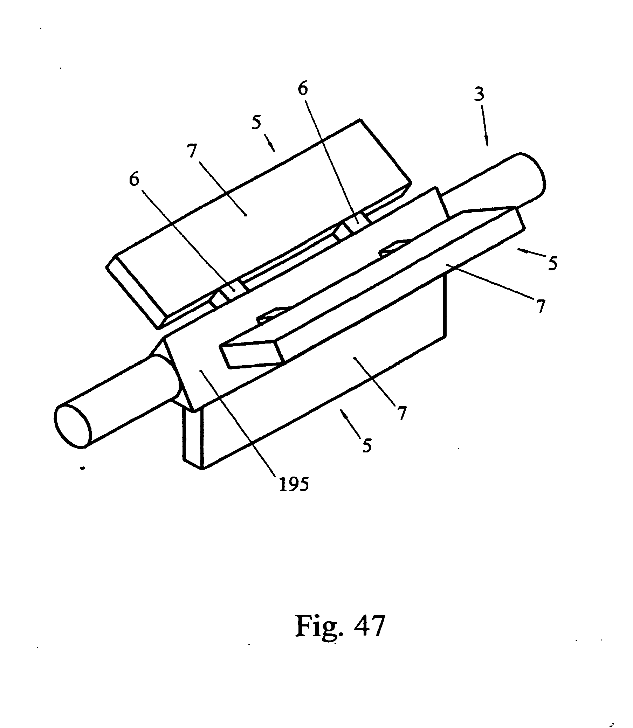

Fig. 47 zeigt eine Konstruktionsvariante des Motors, die mindestens drei piezoelektrische Oszillatoren 7 und mindestens drei Friktionsschichten 4 einschließt, die parallel zueinander angeordnet sind und mindestens in drei Ebenen liegen. Bei einem derartigen Motor kann das getriebene Elemente 3 als ein Balken 195 mit drei- oder mehreckigem Querschnitt ausgeführt werden, so wie es in Fig. 47 dargestellt ist.

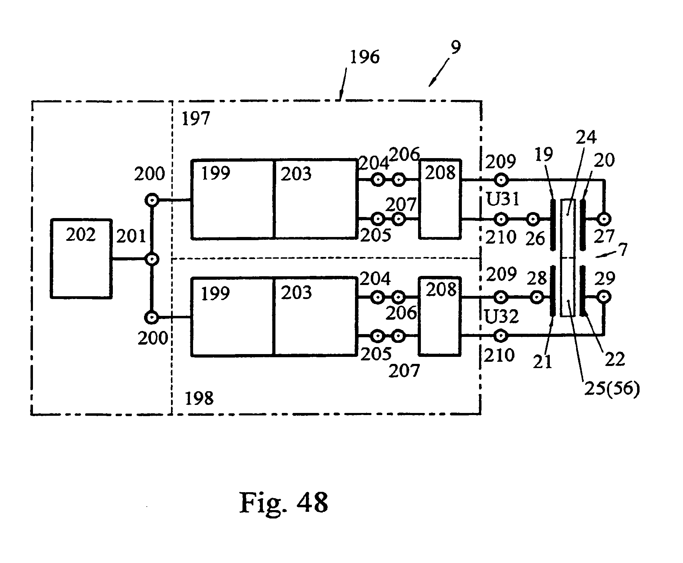

Fig. 48 zeigt ein Blockschema des vorgeschlagenen Motors, das die Funktionsweise der einfachsten Erregerquelle 9 erklärt, die die Zweiphasenspannungen U31= U31maxSin(ωot), U32= U32maxSin (ωot±ϕu) bereitstellt.
Hier ist die elektrische Erregerquelle 9 als Zweikanalleistungsverstärker 196 aufgebaut, mit dem ersten 197 und mit dem zweiten 198 Kanal. Jeder Kanal (197, 198) schließt die Formierungsstufe 199 ein, die mit ihrem Eingang 200 an den Ausgang 201 des Grundgenerators 202 angeschlossen ist. Außerdem schließen die Kanäle 197, 198 den Ausgangsleistungsverstärker 203 ein, der mit seinen Ausgängen 204, 205 elektrisch mit den Eingängen 206, 207 der Anpassungstufe 208 verbunden ist. Die Ausgänge 209, 210 der Anpassungstufe 208 des Kanals 197 sind elektrisch mit den Anschlüssen 26, 27 des Generators von akustischen Longitudinalwellen 24 des Oszillators 7 verbunden. Die Ausgänge 209, 210 der Anpassungstufe 208 des Kanals 198 sind elektrisch mit den Anschlüssen 28, 29 des Generators von akustischen Longitudinalwellen 25 (oder 56) des Oszillators 7 verbunden.

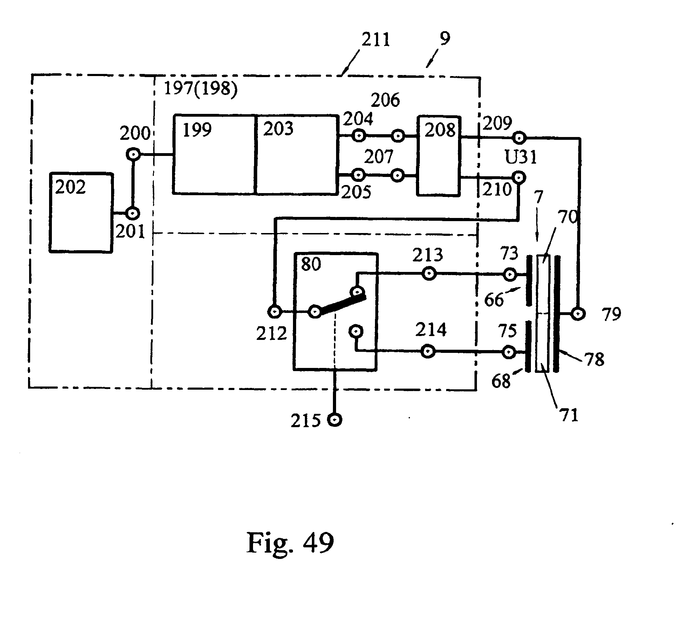

Fig. 49 zeigt ein Blockschema des vorgeschlagenen Motors, das die Funktionsweise der Erregerquelle 9 erklärt, die die Einphasenspannung U31= U31maxSin(ωot) bereitstellt.

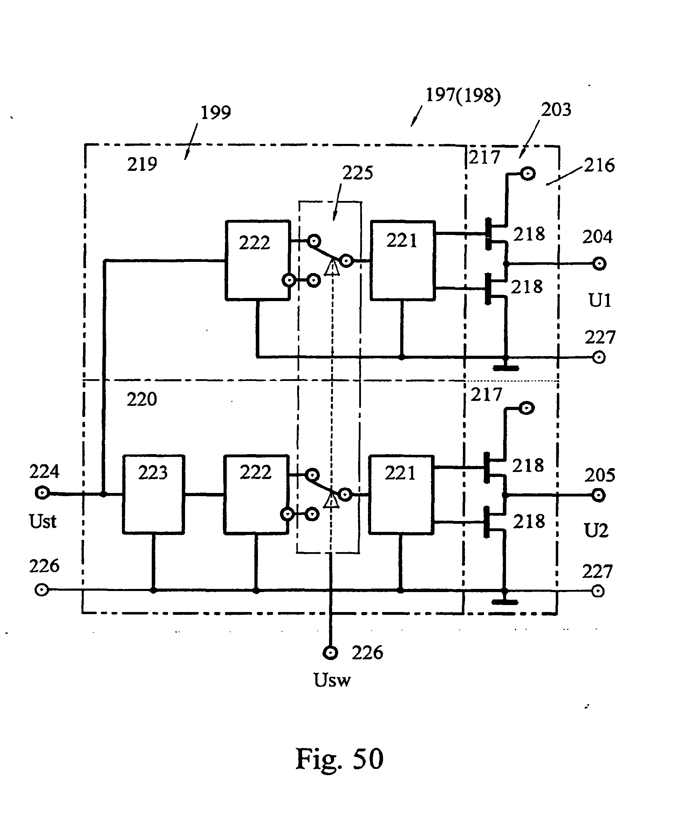

Die elektrische Erregerquelle 9 ist als Einkanalleistungsverstärker 211 aufgebaut, mit dem Kanal 197 (oder 198), der die Formierungsstufe 199 einschließt, die mit ihrem Eingang 200 an den Ausgang 201 des Grundgenerators 202 angeschlossen ist. Außerdem schließt der Kanal 197 (oder 198)den Ausgangsleistungsverstärker 203 ein, der mit seinen Ausgängen 204, 205 elektrisch mit den Eingängen 206, 207 der Anpassungstufe 208 verbunden ist. Der Ausgang 209 der Anpassungstufe 208 ist elektrisch mit dem Anschluss 79 der gemeinsamen Elektrode 78 des Oszillators 7 verbunden.
Der zweite Eingang 210 der Anpassungstufe 208 ist mit dem Eingang 212 des Elektrodenkommutators 80 verbunden. Die Ausgänge 213 und 214 des Elektrodenkommutators 80 sind mit den Elektroden 66 und 68 der zusammengesetzten Generatoren 70 und 71 des Oszillators 7 verbunden. In dieser Konstruktionsvariante des Motors besitzt der Elektrodenkommutator 80 den Steuereingang 215.
Die vorgeschlagene Erfindung sieht eine Motorvariante vor, bei der jeder der Ausgangsleistungsverstärker 203 des Kanals 197 oder 198 als Brückenleistungsverstärker 216 (siehe Fig.50) aufgebaut wird, der den ersten Halbbrückenleistungsverstärker 217 mit dem Ausgang 204 und den zweiten Halbbrückenleistungsverstärker 217 mit dem Ausgang 205 einschließen, auf der die Spannungen U1 und U2 wirksam sind. Beide Halbbrückenleistungsverstärker 217 schließen die Transistorschalter 218 ein.
Bei dieser Variante bestehen die Formierungsstufen 199 aus zwei Erregerkanälen 219, 220 der Halbbrückenleistungsverstärker 217. Jeder der Erregerkanäle 219, 220 schließt die Treiber 221 und die Formierungsstufe 222 ein. Außerdem kann einer der Erregerkanäle, z.B. der Kanal 220, mit dem Signalphasensteuerungsglied 223 ausgestattet werden, auf dessen Phasensteuereingang 224 die Steuerspannung Ust wirksam ist.
Zusätzlich kann einer der Kanäle 197, 198 mit dem Reversumschalter 225 ausgestattet werden, auf dessen Steuereingang 226 die Steuerspannung Usw wirksam ist (siehe Fig. 50).

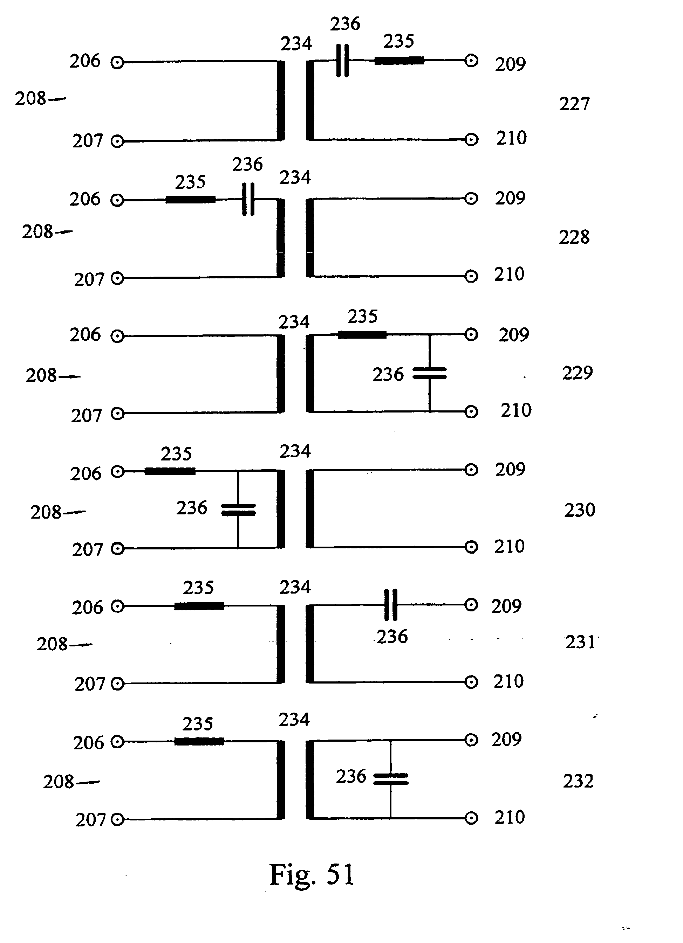

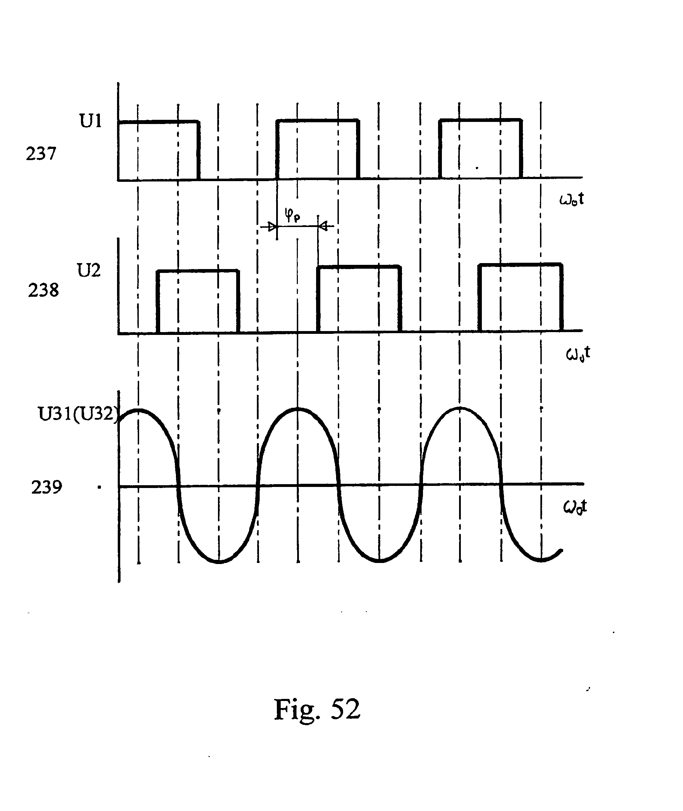

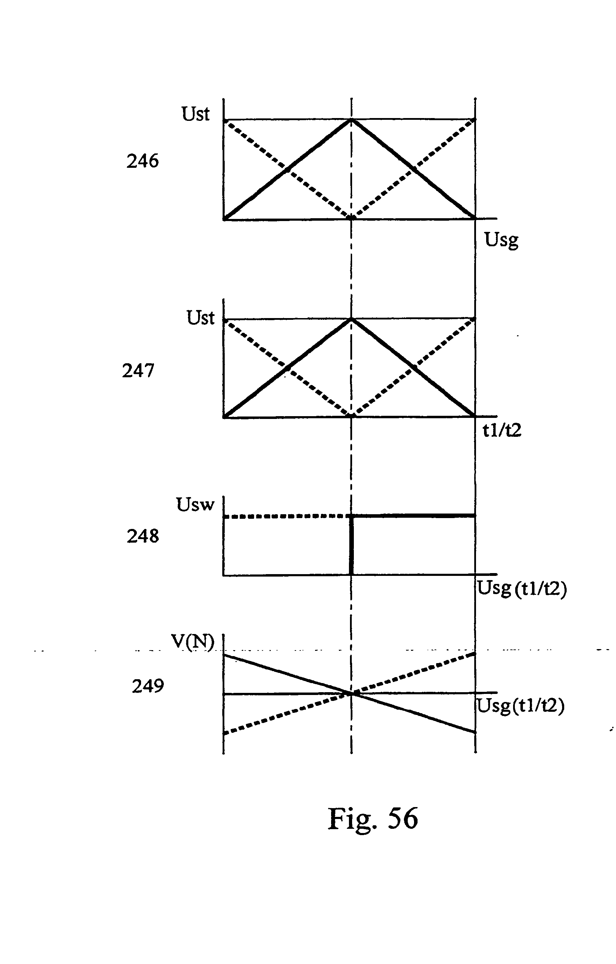

Der Anschluss 227 ist mit Masse oder dem gemeinsamen Nullpotenzial der Erregerquelle 9 verbunden.
Die Pos. 228 bis 233 der Fig. 51 zeigen mögliche Varianten der Anpassungsglieder 208, die den summierenden Transformator 234, die Kompensationsspule 235 und den Resonanzkondensator 236 einschließen.
Die Pos. 237 bis 239 der Fig. 52 zeigen Diagramme der elektrischen Spannungen U1, U2, U31 (U32). Die Spannung U1 liegt zwischen dem Ausgang 204 und dem gemeinsamen Potenzial 227 des ersten Halbbrückenverstärker 217 an. Die Spannung U2 ist zwischen dem Ausgang 205 und dem gemeinsamen Potenzial 227 des zweiten Halbbrückenverstärker 217 anstehend. Diese Spannungsverläufe haben eine rechteckige Form. Die Spannungen U31 oder U32 sind an den Ausgängen 209 und 210 des Anpassungsgliedes 208 wirksam. Diese Spannung hat eine Sinusform.
Die Spannungen U1 und U2 sind um den Phasenverschiebungswinkel φp gegeneinander verschoben. Der Winkel φp wird durch das Signalphasensteuerungsglied 223 bestimmt und durch die an seinem Steuereingang 224 aktive Steuerspannung Ust geändert.

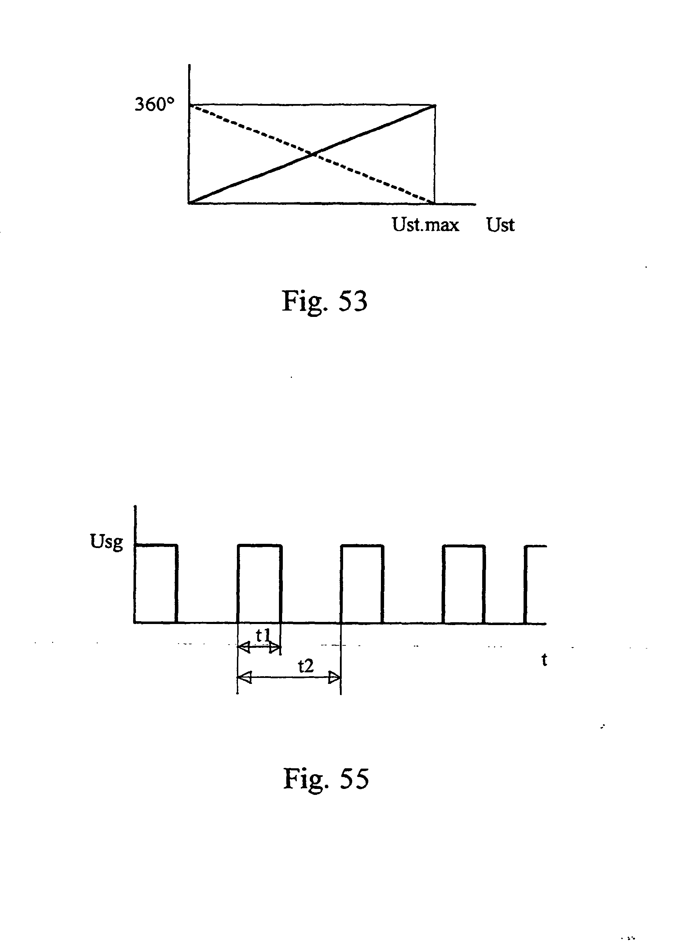

In Fig. 53 ist durch die ununterbrochene Linie die gewünschte Abhängigkeit des Phasenverschiebungswinkels φp von der Steuerspannung Ust des Signalphasensteuerungsglieds 223 dargestellt. Mit Hilfe der punktierten Linie ist eine andere mögliche Abhängigkeit dargestellt.

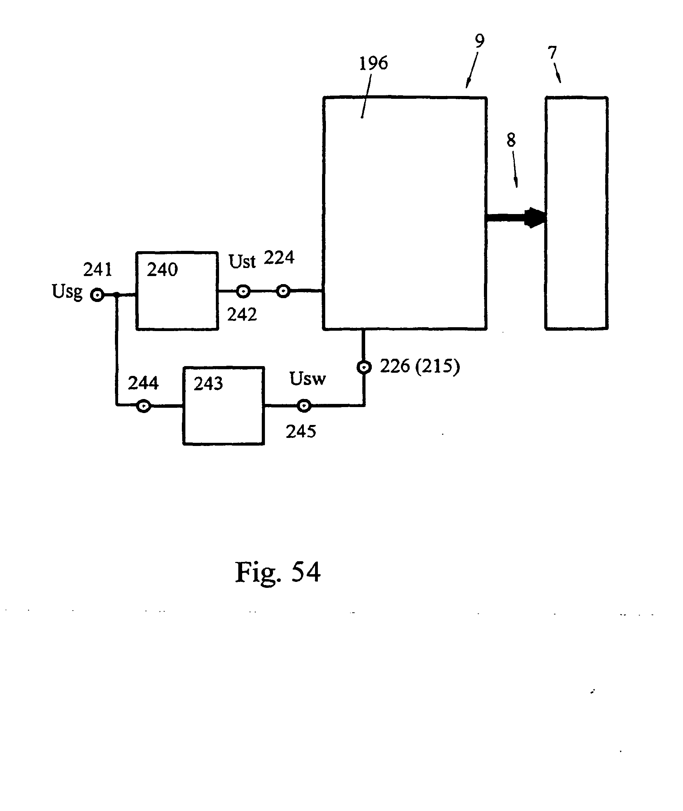

In Fig. 54 stellt ein Blockschema des vorgeschlagenen Motors dar, der mit einem Umformer 240 des Steuersignals Usg ausgerüstet ist, der den Signaleingang 241 und den Ausgang 242 der Steuerspannung Ust enthält und der mit dem Phasensteuereingang 224 des Phasensteuerungsgliedes 242 verbunden ist.
In einer Ausführungsvariante kann der Umformer 240 als ein Pegelumformer der Signalspannung Usg in die Spannung Ust realisiert werden.
In den anderen Ausführungsvariante ist der Umformer 240 ein Demodulator eines pulsbreitenmodulierten Signals, der die Signalbreitenverhältnis t1/t2 in die Steuerspannung Ust umformt. Das Diagramm des plusbreitenmodulierten Signals ist in Fig. 55 dargestellt.
Außerdem können die betrachteten Varianten des vorgeschlagenen Motors mit einem Stufendetektor 243 der Nullage ausgestattet werden, dessen Messeingang 244 mit dem Eingang 241 des Umformers 240 verbunden ist. Sein Eingang 245 kann an den Steuereingang 226 des Reversumschalters 225 oder an den Steuereingang 215 des Elektrodenkommutators 215 (siehe Fig. 54) angeschlossen werden. Am Ausgang 245 des Stufendetektors 243 ist die Umschaltspannung Usw aktiv.
In Fig. 56 Pos. 246, 247 sind mit ununterbrochenen Linien die gewünschten Übertragungskennlinien des Umformers 240 dargestellt.
In Fig. 56 Pos. 248 ist durch die ununterbrochenen Linie die Übertragungskennlinie des Stufendetektors der Nulllage 243 gezeigt.
In Fig. 56 Pos. 249 sind durch die unnuterbrochenen Linie und die Punktierlinie mögliche Steuerkennlinien der Bewegung des getriebenen Elements des vorgeschlagenen Motors 3 abgebildet.

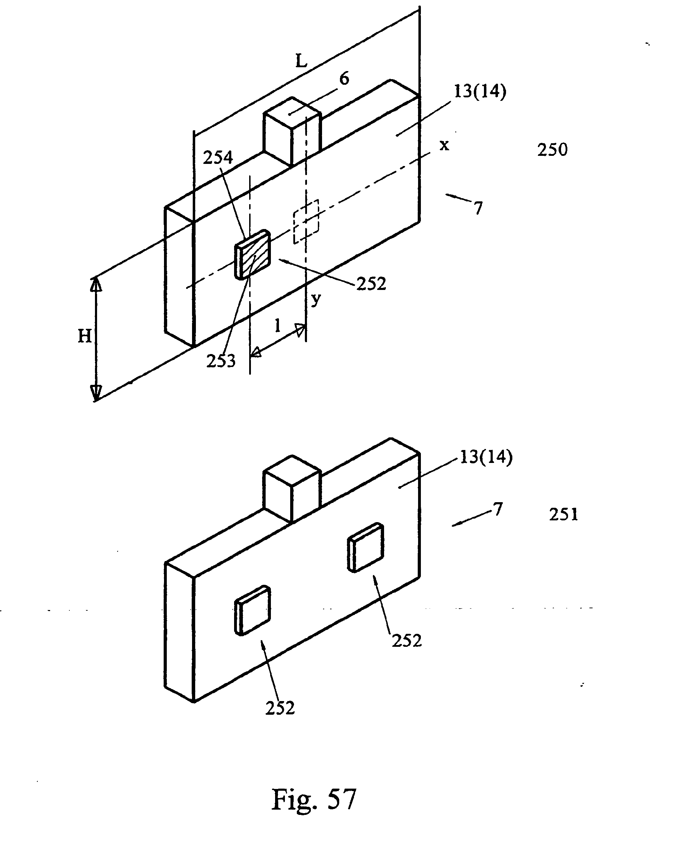

In Fig. 57 Pos. 250, 251 sind mögliche Konstruktionsvarianten des Sensors der mechanischen Spannungen einer akustischen Longitudinalwelle gezeigt, die sich im Oszillator 7 ausbreitet. Der Sensor 252 kann als eine dünne rechteckige oder runde (nicht dargestellte) piezoelektrische Platte ausgeführt werden, mit den Elektroden 253, 254 auf ihren breiten Oberflächen und mit der senkrecht zu den Elektroden gerichteten Polarisation, wie in Pos. 250 offenbart.
Der Sensor 252 wird akustisch gekoppelt auf einer der Hauptoberflächen 13, 14 des Oszillators 7 befestigt, und zwar am Ort der maximalen mechanischen Spannungen der entsprechenden akustischen sich im Oszillator 7 ausbreitenden Longitudinalwelle. Er kann auf der Oberfläche des Oszillators 7, längs der x-Achse, im Abstand I=1/4L von der vertikalen y-Achse, befestigt werden, wie in Fig. 57 Pos. 250 dargestellt. Außerdem kann er auf der Oberfläche des Oszillator 7 im Zentrum angeordnet werden, längs der x-und y-Achsen , wie in Fig. 57 Pos. 250 abgebildet.

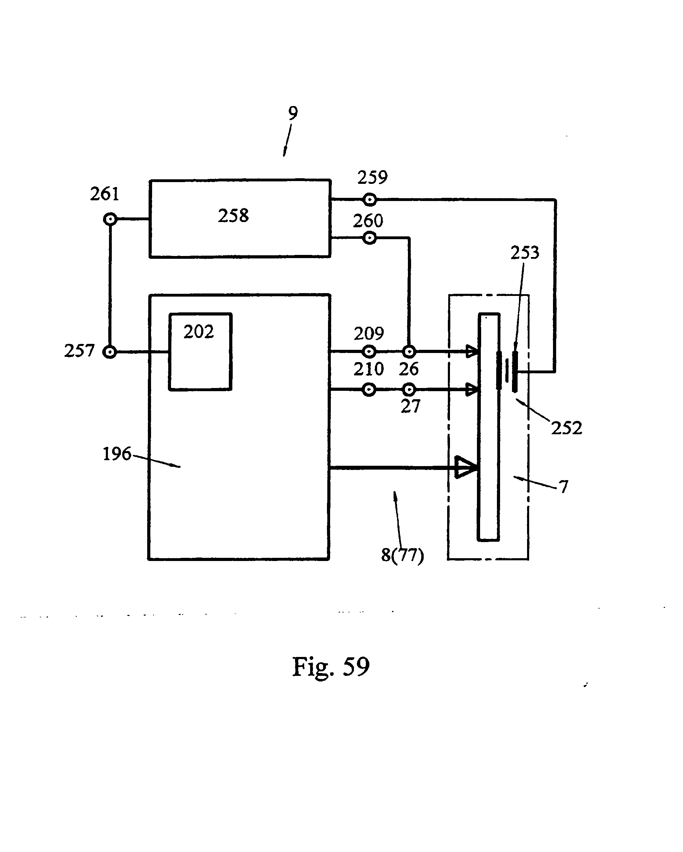

Der Sensor 252 kann als zwei dünne piezokeramische Platten ausgeführt sein, die akustisch auf einer der Hauptoberflächen 13, 14 des piezoelektrischen Oszillators 7 befestigt sind und zwar an Orten von größten mechanischen Spannungen, einer akustischen Longitudinalwelle, die sich entlang der Resonanzlänge des Oszillators ausbreitet, und deren Punkte bei einer 180°-Signalphasenverschiebung einer der Leistungsverstärkerkanäle 197, 198 bezüglich des Signals eines anderen, die gleichen Bewegungsbahnen besitzen. Die Sensorplatten werden symmetrisch im Abstand 1/4L von der vertikalen y-Achse auf Oberflächen 13, 14 des Oszillators 7 befestigt, wie in Fig. 57 Pos. 251 dargestellt.
Die akustische Befestigung des Sensors 252 auf der Oberflächen 13 oder 14 des Oszillators 7 kann durch Ankleben an eine der Elektroden 253, 254 des Sensors 252 mit Hilfe eines harten Klebers auf der Basis des Epoxydharzes oder durch Anlöten an die entsprechende Elektrode (19, 20, 66, 68, 78) des Oszillators 7 durchgeführt werden.

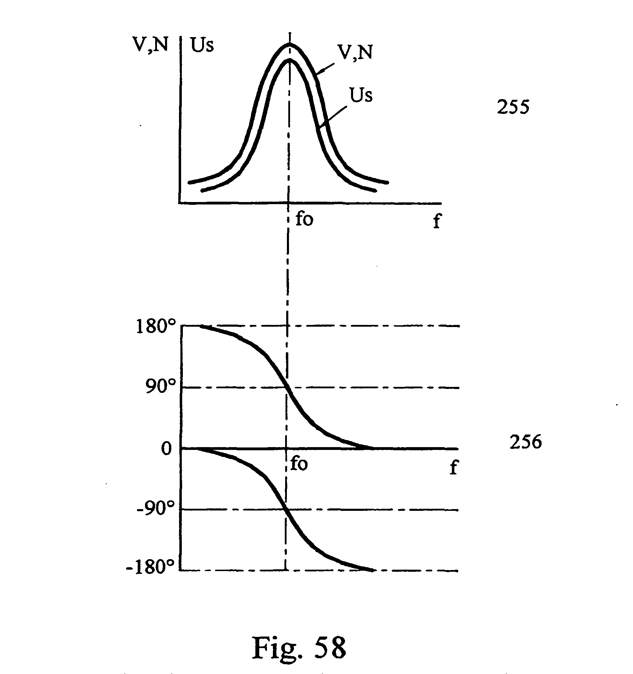

In Fig. 58 Pos. 255, 256 sind Frequenzkennlinien des Sensors 252 dargestellt. Die Pos. 255 zeigt eine Abhängigkeit der Spannung Us des Sensorsignals und die Abhängigkeit der Bewegungsgeschwindigkeit V oder Drehzahl N des getriebenen Elements 3 von der Erregerfrequenz f des Oszillators 7. Die Pos. 256 zeigt die Abhängigkeit des Phasenverschiebungswinkels ϕs zwischen der Spannung am Anschluss 26 der Elektroden 19 des Sensors 7 und der Spannung Us des Sensorsignals für zwei entgegengesetzte Polarisationsrichtungen des Sensors 252.
In den Konstruktionsvarianten des vorgeschlagenen Motors kann der Grundgenerator 202 mit einem Erregerfrequenzsteuereingang 257 ausgerüstet werden (siehe Fig.59). Außerdem kann der vorgeschlagene Motor mit dem Phasendetektor 258 ausgestattet werden, der den ersten 259, den zweiten 260 Phaseneingang und den Ausgang 261 besitzt.
Der erste Ausgang 259 des Phasendetektors 258 kann mit der Elektrode 253 des Sensors 252 verbunden werden. Der zweite Ausgang 260 ist mit dem Anschluss 26 der Elektroden 19 des Oszillators 7 verbunden. Der Phasendetektorausgang muss an den Frequenzsteuereingang 257 des Grundgenerators 202 angeschlossen werden, wie in Fig. 59 dargestellt.

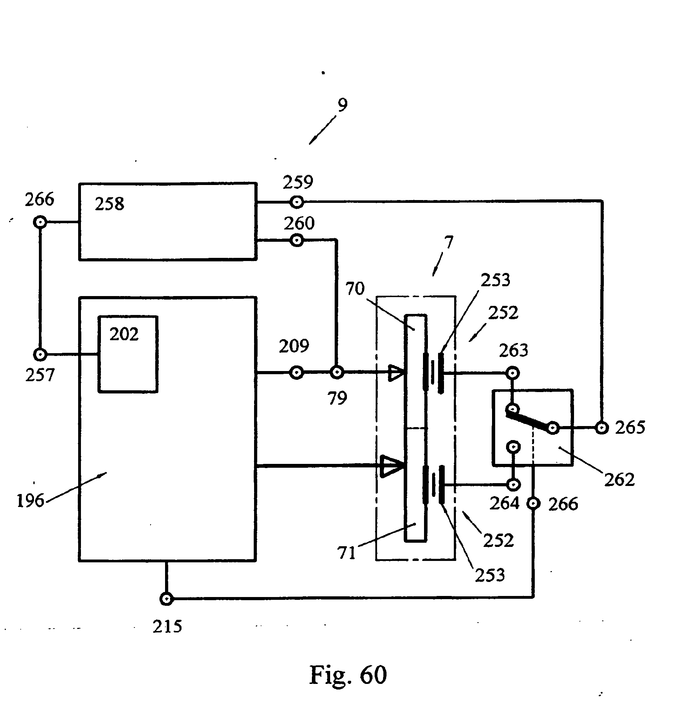

In Fig. 60 ist ein Blockschaltbild der Konstruktionsvariante des vorgeschlagenen Motors mit dem Sensor 252, der aus zwei dünnen Platten hergestellt ist, gezeigt. Diese Variante des Motors ist mit dem Signalkommutator des Sensors 262 ausgestattet, der den ersten Eingang 263, den zweiten Eingang 264, den Ausgang 265 und den Steuereingang 266 enthält. Der erste Eingang 263 des Kommutators 262 ist mit der Elektrode 253 der ersten Platte des Sensors 252 verbunden und sein zweiter Eingang 264 ist an die Elektrode 23 der zweiten Sensorplatte 252 angeschlossen und der Ausgang 256 ist mit dem Phaseneingang 259 des Phasendetektors 258 verbunden. Der Steuereingang 266 des Kommutators 262 ist am Steuereingang 215 des Elektrodenkommutators 80 angeschlossen.

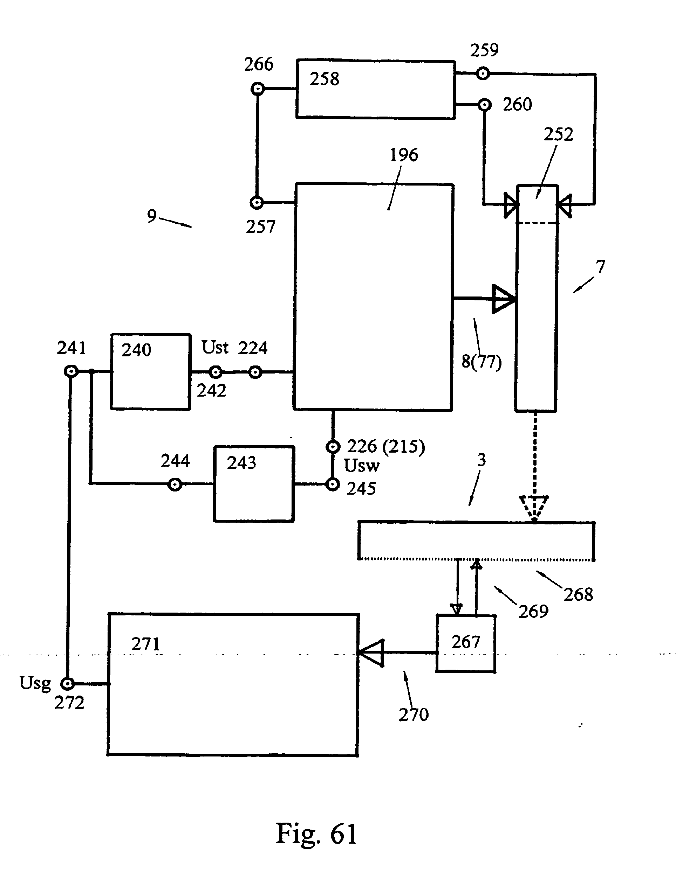

In Fig. 61 ist ein Blockschaltbild einer Konstruktionsvariante des vorgeschlagenen Motors dargestellt, der mit einem Koordinaten- oder Bewegungsparametersensor 267 des getriebenen Elements 3 ausgestattet ist. Der Sensor 267 hat die Skale 268 und die Ableseeinrichtung 269. Der Informationsausgang sdes Sensors 267 ist elektrisch mit einem prozessorgesteuerten Regler 271 verbunden. Der Ausgang 272 des prozessorgesteuerten Reglers 271 ist an den Eingang 241 des Umformers 240 angeschlossen.

Die Funktionsweise des vorgeschlagenen piezoelektrischen Motors beruht auf einer gleichzeitigen elektrischen Erregung in dem monolithischen piezoelektrischen Oszillator 7 einer akustischen Longitudinalwelle, die sich entlang der Resonanzlänge L und einer akustischen Longitudinalwelle, die sich entlang der Resonanzhöhe H des Oszillators 7 ausbreitet.
Unter einer akustischen Welle, die sich entlang der Oszillatorlänge L des Oszillators 7 ausbreitet, ist eine Welle zu verstehen, aufgrund deren Ausbreitung die Teilchen des Oszillators 7 vorzugsweise in Richtung der Oszillatorlänge L schwingen. Bei der Ausbreitung wird diese Welle an den beiden Stirnoberflächen 17, 18 des Oszillators 7 reflektiert, aufgrund dessen sich eine Stehwelle ausbildet.
Unter einer akustischen Welle, die sich entlang der Oszillatorhöhe H des Oszillators 7 ausbreitet, ist eine Welle zu verstehen, aufgrund dererAusbreitung die Teilchen des Oszillators 7 vorzugsweise in Richtung der Oszillatorhöhe H schwingen. Bei der Ausbreitung wird diese Welle an den beiden Seitenoberflächen 15, 16 des Oszillators 7 reflektiert, aufgrund dessen eine Stehwelle resultiert.
Die Resonanzlänge L des Oszillators 7 ist gleich oder beträgt ein ganzzahliges Vielfaches einer Wellenlänge der sich längs der Oszillatorlänge L ausbreitenden akustischen Stehwelle.
Die Resonanzhöhe H des Oszillators 7 beträgt eine halbe Wellenlänge der sich längs der Oszillatorhöhe H ausbreitenden akustischen Stehwelle.
Die Resonanzlänge L und die Resonanzhöhe H des Oszillators 7 werden an die Bedingung geknüpft, dass die Frequenzen der sich im Oszillator ausbreitenden Wellen gleich sind.
Diese Bedingung setzt den geometrischen Abmessungen des Oszillators 7 gewisse Grenzen. Da die beiden im Oszillator erzeugten Wellen vom gleichen Typ sind, sind bei der Frequenzgleichheit dieser Welle die Wellenlängen auch in etwa gleich, d.h. λ≈ν. Das bedeutet, dass das Verhältnis L/H des Oszillators ca. 2 oder ein ganzzahliges Vielfaches von 2 beträgt, d.h. 4, 6, 8.
Die im Oszillator 7 erzeugte akustische und sich längs der Resonanzhöhe H ausbreitende akustische Welle kann vorzeichenkonstant und vorzeichenvariabel längs der Resonanzlänge L sein.
In einer Konstruktionsvariante des Motors geschieht die Erregung von zwei akustischen Wellen im Oszillator 7 mit Hilfe von zwei unabhängigen Generatoren der akustischen Wellen 24, 25 oder 56.

In einer anderen konstruktiven Variante des Motors kann die Erregung von zwei Wellen gleichzeitig mit Hilfe eines zusammengesetzten Generators der akustischen Wellen 70 oder 71 vollzogen werden.

Der Unterschied zwischen den Generatoren 24, 25 und 56 besteht in der Konfiguration der Elektroden 19, 20 der ersten Elektrodengruppe und der zweiten Elektrodengruppe 21, 22, die diese Generatoren bilden, in der Anordnung dieser Elektroden auf der Oberfläche des Oszillators 7 und in ihrer gegenseitigen Beschaltung.
Die Elektroden 19, 20 der ersten Elektrodengruppe sind in den Randgebieten der Hauptoberflächen 13,14 des Oszillators 7 angeordnet, symmetrisch bezüglich der Symmetrieebene S, die durch die Mitte der Resonanzhöhe H des Oszillators 7 geht. Diese Konfiguration der Elektroden 19, 20 ermöglicht durch die Erregung im Oszillator 7 eine akustische Longitudinalwelle, die sich längs der Resonanzlänge L ausbreitet.
Die Elektroden 21, 22 der zweiten Elektrodengruppe sind in den Zentralgebieten der Hauptoberflächen 13, 14 des Oszillators 7 angeordnet, symmetrisch bezüglich der Symmetrieebene S, die durch die Mitte der Resonanzhöhe des Oszillators 7 geht. Diese Konfiguration der Elektroden 21, 22 ermöglicht durch die Erregung im Oszillator 7 eine akustische Longitudinalwelle, die sich längs der Resonanzhöhe H ausbreitet.
Die Elektroden 19, 20 der ersten Elektrodengruppe können mit den Elektroden 21, 22 der zweiten Elektrodengruppe verbunden werden, so dass die zusammengesetzten Generatoren der akustischen Wellen 70, 71 gebildet werden. Die Generatoren 70, 71 erregen gleichzeitig im Oszillator 7 eine akustische Longitudinalwelle, die sich längs der Resonanzlänge L und eine akustische Longitudinalwelle, die sich längs der Resonanzhöhe H des Oszillators 7 ausbreitet.
In allen betrachteten Fällen werden im Oszillator 7 akustische Longitudinalwellen erzeugt, die keine Biegekomponente haben.
Die elektrische Erregung der Generatoren 24, 25, 56, 70, 71 in den Varianten des vorgeschlagenen Motors geschieht mit Hilfe der elektrischen Erregerquelle 9, die in Abhängigkeit von der Konstruktion des Oszillators 7 eine periodische Ein- oder Zweiphasenerregerspannung bereitstellt.

Die Erregerspannung wird an die Elektroden der Generatoren 24, 25, 56, 70, 71 der akustischen Wellen gegeben und erregt sie. Aufgrund dessen werden in dem Oszillator 7 die oben betrachteten akustischen Wellen erzeugt. Die Einwirkung dieser Wellen auf die Friktionselemente 6 veranlasst diese, eine elliptische Bewegung auszuführen.

Die elliptische Bewegung des Friktionselements 6 (Fig. 1) verursacht eine Längsbewegung des getriebenen Elements 6, in die eine oder andere Richtung, in Abhängigkeit von der Phasenverschiebung zwischen der sich im Oszillator 7 ausbreitenden akustischen Wellen.
Das auf der Seitenoberfläche 15 oder 16 angeordnete Friktionselement 6 gemäß Fig. 4 bewegt sich aufgrund der Ausbreitung zweier akustischer Longitudinalwellen im Oszillator 7 längs der in den Pos. 43, 44, 45, 46 dargestellten elliptischen Bahnen. Diese Bewegung kann in vier Phasen unterteilt werden.
Vorwärtsanpressphase - Pos. 43. Das Friktionselement bewegt sich in Richtung der Friktionsschicht 4 und wird an sie angepresst. Dabei findet eine Kopplung zwischen dem Friktionselement 6 und der Friktionsschicht 4 statt. Phase der Vorwärtsbewegung - Pos. 44. Das Friktionselement überträgt durch die Reibungskräfte die Kraft an das getriebene Element 3 und veranlasst es sich zu bewegen. Rückwärtsanpressphase - Pos. 45. Das Friktionselement 6 geht von der Friktionsschicht 4 zurück und bricht den Friktionskontakt ab. Phase der Rückwärtsbewegung - Pos. 46. Das Friktionselement führt eine Rückwärtsbewegung aus.

Fig. 9 zeigt, wie bereits dargelegt, eine Konstruktionsvariante eines als das Zylinderteil 52 ausgeführten Oszillators 7, dessen Resonanzlänge L=2λ beträgt. In einem solchen Oszillator haben die Friktionselemente 6 eine entgegengesetzte Bewegungsrichtung ihrer elliptischen, in zwei parallelen Ebenen liegenden, Bewegungsbahnen, was eine Verwendung in Linearmotoren ermöglicht. Die Friktionselemente 6 können sowohl auf einer Seitenoberfläche 15 oder 16 als auch auf den beiden Oberflächen gleichzeitig aufgestellt werden.
Fig. 10 offenbart den Oszillator 7 als Zylinder 55 mit der gemeinsamen Resonanzlänge L =3λ. In einem solchen Oszillator haben die Friktionselemente 6 die gleiche Bewegungsrichtung ihrer elliptischen Bewegungsbahnen, die in den drei, unter dem 120°-Winkel stehenden Ebenen liegen. Solche Oszillatoren können ihre Verwendung in Rotationsmotoren finden.

In Motoren, in denen die Friktionselemente 6 Quernute 117 (siehe Fig. 27) besitzen, können diese Nute mit einem schalldämpfenden Stoff aufgefüllt werden.
In diesem Fall werden parasitäre Schwingungen gedämpft, die in Teilen der Friktionselemente 6 entstehen.
Zur Vereinfachung von Herstellungstechnologien der Friktionselemente 6 können sie als Glasstreifen 151 gefertigt werden, die auf die Seitenoberfläche 15 oder 16 des piezoelektrischen Oszillators 7 aufgeschmolzen sind, so wie es in Fig. 33 dargestellt ist.
Solche Friktionselemente können mit Hilfe der Siebdruck-Technologie mit weiteren thermischen Behandlungen auf den Oszillator 7 aufgetragen werden.
Zur Erhöhung der mechanischen Festigkeit und Verschleißfestigkeit der Friktionselemente können die als Glasstreifen 151 gefertigten Friktionselemente 6 mit Pulver eines verschleißfesten Stoffes aufgefüllt werden, z.B. mit Pulver von Aluminiumoxid, Zirkonoxid, Wolframcarbid, Titancarbid oder eines anderen ähnlichen Stoffes.
Fig. 34 zeigt zwei begrenzende Elemente 152 des piezoelektrischen Oszillators 7, die seine Verschiebung längs der Resonanzlänge L verhindern. Diese Elemente müssen aus Kunststoff mit einem kleinem Reibungskoeffizienent bezüglich der piezoelektrischen Keramik z.B. aus Teflon oder aus einem ihm ähnlichen Material gefertigt werden.
Zur Vermeidung einer Verklemmung des Oszillators zwischen den begrenzenden Elementen wird der Abstand zwischen ihnen etwas größer als die Resonanzlänge L des Oszillators 7 gewählt. Der Spalt zwischen dem Oszillator 7 und den begrenzenden Elementen 152 (nicht in Fig. 34 dargestellt) muß ca. 0,05...0,1 mm betragen. Ein solcher Spalt gewährleistet eine zuverlässige Anpressung des Friktionselements 6 an die Friktionsschicht 4 durch die elastischen Elemente 135.
In dieser Motorvariante halten die begrenzenden Elemente 152 zuverlässig den piezoelektrischen Oszillator 7 von seiner Längsverschiebung in Grenzen der Spaltbreite.
Das getriebene Element 3 kann in dieser und in anderen Motorvarianten als ein das treibende Element 5 umfassenden Rahmen 154 ausgeführt werden.
Fig. 35 zeigt eine Motorvariante, in der die begrenzenden Elemente 155 mechanische Resonatoren darstellen, dessen Resonanzfrequenz mit der Schwingungsfrequenz des piezoelektrischen Oszillators 7 bei Motorbetrieb übereinstimmt. Diese Elemente sind aus elastischen Metallplatten hergestellt, die durch isolierende Unterlagen den Oszillator 7 zusammendrücken und ihn von einer Verschiebung längs der Resonanzlänge L abhalten.
Während des Motorbetriebs schwingen die begrenzenden Elemente 155 mit dem Oszillator 7 mit, ohne dabei erhebliche mechanische Verluste in das Resonanzsystem des Oszillators 7 hineinzubringen, was die mechanischen Verluste bei Motorbetrieb verringert.
Während des Abbremsen des getriebenen Elements 3 verschiebt sich der piezoelektrische Oszillator 7 etwas in Richtung der bremsenden Kraft in Grenzen der Elastizität des begrenzenden Elements 155.
Die in Fig. 48 dargestellte Konstruktionsvariante der elektrischen Erregerquelle 9 hat folgende Funktionsweise: Der Grundgenerator 202 erzeugt an seinem Ausgang 201 eine elektrische Spannung mit der Frequenz, die der mechanischen Resonanzfrequenz f0 (oder der Kreisfrequenz ω0) der akustischen Schwingungen des Oszillators 7 entspricht, bei der sich längs seiner Resonanzlänge L eine akustische Longitudinalwelle ausbreitet. Diese Spannung wird an die Eingänge 200 der Formierstufen 199 der ersten 197 und zweiten 198 Kanäle gegeben. Die Formierstufen 199 regen die mit ihnen verbundenen Leistungsverstärker 203 an.

In unterschiedlichen Varianten des vorgeschlagenen Motors kann eine der Formierstufen 199, entweder von Kanal 197 oder Kanal 198, ein Phasenschiebeglied enthalten, der die Signalphase des Kanals 199 um den Winkel ±ϕu bezüglich des Signals von Kanal 198 verschiebt. Das Phasenschiebeglied ist nicht abgebildet.
Die Ausgänge 204, 205 der Leistungsverstärker 203 der Kanäle 197, 198 sind mit den Eingängen 206, 207 der Anpassungsglieder 208 verbunden, an deren Ausgängen 209, 210 die elektrischen Spannungen U31, U32 erzeugt werden. Diese Spannungen haben folgende Form: U31=U31maxSin(ωot), U32= U32maxSin(ωot±ϕu).
Der Phasenverschiebungswinkel ϕu zwischen den Spannungen U31 und U32 bestimmt den optimalen Phasenverschiebungswinkel zwischen den akustischen Wellen im Oszillator 7. Dieser Winkel hängt von Maßverhältnissen des Oszillators 7 und von seiner Konstruktion ab. Bei unterschiedlichen Motorvarianten beträgt er 0...±90°. Für die Erklärung der Funktionsweise werden weitere Motorvarianten betrachtet, bei denen dieser Winkel gleich Null ist, d.h. das Phasenschiebeglied ist weggelassen.
Die in Fig. 49 dargestellte Variante der elektrische Erregerquelle 9 hat folgende Funktionsweise: Der Grundgenerator 202 erzeugt an seinem Ausgang 201 eine elektrische Spannung mit der Frequenz, die der mechanischen Resonanzfrequenz f0 (oder der Kreisfrequenz ω0) der akustischen Schwingungen des Oszillators 7 entspricht, bei der sich längs seiner Resonanzlänge L eine akustische Longitudinalwelle ausbreitet. Diese Spannung wird an den Eingang 200 der Formierstufe 199 des Kanals 197 (198) gegeben. Die Formierstufe 199 regt den mit ihr verbundenen Leistungsverstärker 203 an.
Die Ausgänge 204, 205 der Leistungsverstärker 203 sind mit den Eingängen 206, 207 des Anpassungsgliedes 208 verbunden, an deren Ausgängen 209, 210 die elektrische Einphasenspannung erzeugt wird, die abwechselnd den Generator 70 oder 71 des Oszillators 7 erregen. Diese Spannung hat die Form U31= U31maxSin(ωot).

Die Umschaltung der Erregung von Generatoren 70, 71 mit Hilfe des Elektrodenkommutators 80 führt zur Änderung der Bewegungsrichtung des getriebenen Elements 3.
Bei der in Fig. 50 dargestellten Variante eines der Kanäle 197, 198 ist der Leistungsverstärker als ein Brückenleistungsverstärker 216 aufgebaut. Dieser Verstärker schließt zwei Halbbrückenleistungsverstärker 217, an dessen Ausgängen 204, 227 und 205, 227 die elektrischen Spannungen U1, U2 bereitgestellt werden.
Die Erregung der Halbbrückenleistungsverstärker 217 geschieht mit Hilfe der aus zwei Erregerkanäle 219, 220 bestehenden Formierstufen. Jeder der Erregerkanäle 219, 220 schließt Treiber 221 und die Formierungsstufe 222 ein. Die Treiber 221 erzeugen elektrische Spannungen zur Steuerung von Transistoren 218 und die Formierglieder 222 stellen elektrische Spannungen zur Steuerung der Treiber 221 bereit.
Außerdem kann einer der Erregerkanäle, z.B. der Kanal 220, mit dem Signalphasensteuerungsglied 223 ausgestattet werden.
Das Signalphasensteuerungsglied 223 ermöglicht eine Phasenverschiebung zwischen den Spannungen U1, U2 um den Winkel ϕp, der zwischen 0 und 360° variieren kann, in Abhängigkeit von der Steuerspannung Ust am Ausgang 224.
In den zweiphasigen Erregerquellen 9 kann einer der Kanäle 197, 198 mit dem Reversumschalter 225 ausgestattet werden, auf dessen Steuereingang 226 die Steuerspannung Usw (siehe Fig. 50) wirksam ist. Der Umschalter 225 funktioniert so, daß bei seiner Betätigung der Phasenverschiebungswinkel zwischen den sich im Oszillator 7 ausbreitenden akustischen Wellen um 180° verschoben wird. Dies führt zur Richtungsänderung des getriebenen Elements 6.
Die in Fig. 51 Pos. 227 bis 232 dargestellten Anpassungsstufen 208 dienen zur Addition der an den Ausgängen 204, 227 und 205, 227 des Halbbrückenleistungsverstärkers 216 wirksamen Spannungen U1, U2, sowie ihrer Erhöhung und Filtration. Die Addition wird mit Hilfe des Summiertransformators 234 durchgeführt. Die Spannung wird von dem Transformator auch teilweise erhöht. Die Filtration und eine weitere Spannungserhöhung wird mit Hilfe eines Resonanzkreises durchgeführt, der durch Kompensationsinduktivität 235 und Resonanzkondensator gebildet wird.

In Fig. 52 sind Diagramme der Spannungen U1, U2, U31 oder U32 dargestellt. Die Spannungen U1, U2 haben eine rechteckige Form, da die Leistungsverstärker 217 im Schaltbetrieb mit einem hohen Wirkungsgrad betrieben werden.
Das Spannungssteuerungsglied verändert den Phasenverschiebungswinkel zwischen den Spannungen U1 und U2. Eine Änderung dieses Winkels führt zur Amplitudenänderung der Spannung U31 oder U32. Bei einer Phasenverschiebung von 0° ist die Spannung U31 oder U32 auch gleich Null und bei einer 360°-Phasenverschiebung hat die Spannung U31 oder U32 ihren maximalen Wert.
Eine Amplitudenänderung der Spannung U31 und U32 führt zur proportionalen Amplitudenänderung der Erregung des Oszillators 7, was praktisch zur proportionalen Erhöhung oder Verringerung der Bewegungsgeschwindigkeit V oder Drehzahl N des getriebenen Elements 3 führt.
In Fig. 53 ist mit Hilfe einer ununterbrochenen Linie die erwünschte Abhängigkeit der Änderung des Phasenverschiebungswinkels φp von der Steuerspannung Ust des. Phasensteuerungsglieds 223 dargestellt.
Mit der Punktierlinie ist eine andere mögliche Abhängigkeit dargestellt.
Das Vorhandensein eines Signalphasensteuerungsgliedes 223 im vorgeschlagenen Motor ermöglicht mit Hilfe der Steuerspannung Ust die Bewegungsgeschwindigkeit V oder Drehzahl N des getriebenes Elements 3 bei gleichzeitiger Beibehaltung von hohen Werten des Wirkungsgrades der Leistungsverstärkers 217 zu variieren.
Der vorgeschlagene Motor kann mit einem Umformer 240 des an seinen Signaleingang 241 kommenden Steuersignals Usg ausgerüstet werden. Das Blockschaltbild eines solchen Motors ist in Fig. 54 dargestellt.
Die Konstruktion des Umformers 240 hängt von der Form des Steuersignals Usg ab.

Wenn das Signal Usg die Form einer sich ändernden unipolaren Einphasenspannung hat, kann der Umformer 240 als ein Spannungspegelumformer des Steuersignals Usg in die Spannung Ust aufgebaut werden, die an seinem Ausgang 242 wirksam ist. In diesem Fall kann der Umformer eine in Fig. 56 Pos. 246 mit Hilfe einer ununterbrochenen Linie dargestellte Übertragungskennlinie haben.
Wenn das Signal Usg die Form eines rechteckigen pulsbreitemodulierten Signals mit sich ändernden Tastverhältnissen t1/t2 hat (siehe Fig. 55), muß der Umformer 240 als ein Demodulator eines pulsbreitemodulierten Signals aufgebaut werden, der das Tastverhältnis t1/t2 dieses Signals in die Steuerspannung Ust umwandelt.
In diesem Fall kann der Umformer eine in Fig. 56 Pos. 247 mit Hilfe einer ununterbrochenen Linie dargestellte Übertragungskennlinie haben.
Die betrachteten Varianten des vorgeschlagenen Motors können mit dem Stufendetektor der Nullage 243 ausgestattet werden.
Der Stufendetektor der Nullage 243 bestimmt aus dem Steuersignal Usg die Nullage des getriebenen Elements 3 und stellt die Steuerspannung Usw, die die Bewegungsrichtung des getriebenen Elements 3 ändert.
In Fig. 56 Pos. 248 ist mit Hilfe der ununterbrochenen Linie die gewünschte Übertragungskennlinie des Stufendetektors der Nullage 243 dargestellt.
Ein mit dem Stufendetektor der Nullage 243 ausgerüsteter Motor hat die in Fig. 56 Pos. 249 mit Hilfe der ununterbrochenen Linie dargestellte Steuerkennlinie. Mit der Punktierlinie ist eine andere mögliche Steuerkennlinie dargestellt.
Der vorgeschlagene Motor kann mit einem Sensor 252 der mechanischen Spannungen einer sich im Oszillator 7 ausbreitenden akustischen Longitudinalwelle ausgerüstet werden. Der Sensor 252 kann akustisch auf einer der Hauptoberflächen 13, 14 des Oszillators 7 befestigt werden, am Ort der maximalen mechanischen Spannungen der entsprechenden akustischen sich im Oszillator 7 ausbreitenden Longitudinalwelle.

Ein solcher Sensor hat einen in Fig. 58 Pos. 255 dargestellten Frequenzgang und einen in Pos. 256 dargestellten Phasengang. Der Sensor stellt an seinen Elektroden 253, 254 eine elektrische Spannung Us bereit, die proportional den mechanischen Spannungen im Oszillator 7 ist, denen ihrerseits die Schwingungsamplitude des Oszillators proportional ist. Deshalb ist Sensorspannung Us proportional der Bewegungsgeschwindigkeit V oder Drehzahl N des getriebenen Elements 3.
Der Phasenverschiebungswinkel ϕu zwischen der Spannung am Anschluß 26 der Elektroden 19 und der Spannung Us des Sensorsignals beträgt ±90°. Dieser Winkel entspricht stets der mechanischen Resonanz des Oszillators 7 d.h. der maximalen Bewegungsgeschwindigkeit V oder Drehzahl N des getriebenen Elements 3.
Eine Ausführung des als zwei dünne Platten aus piezoelektrischer Keramik bestehenden Sensors 252 ermöglicht den Sensorbetrieb bei einer möglichen Asymmetrie des Oszillators 7. Der Sensor 252 soll vorzugsweise in den Motoren mit den zusammengesetzten Generatoren 70, 71 eingesetzt werden.
Fig. 59 zeigt ein Blockschaltbild des vorgeschlagenen Motors, bei dem der Grundgenerator 202 mit einem Frequenzsteuereingang der Erregerfrequenz ausgestattet ist. Dieser Eingang ermöglicht eine Änderung der Frequenz des Grundgenerators im Bereich der Resonanzkennlinie des Oszillators 7. Dadurch kann die Frequenz des Oszillators 7 gesteuert werden.
Außerdem schließt das in Fig. 59 dargestellte Blockschaltbild einen Phasendetektor 258 ein, der den Phasenverschiebungswinkel ϕs zwischen der Spannung am Anschluß 26 der Elektroden 19 und der Spannung Us des Sensorsignals variiert, und stellt an seinem Ausgang 257 eine dem gemessenen Winkel ϕs proportionale Steuerspannung bereit. Die Steuerspannung wird von dem Ausgang 257 des Phasendetektors 258 an den Steuereingang 258 des Grundgenerators 202 geleitet und steuert seine Frequenz so, daß diese Frequenz stets gleich der mechanischen Resonanzfrequenz der Oszillatorschwingungen bleibt, die durch eine Ausbreitung längs der Resonanzlänge L des Oszillators 7 einer akustischen Longitudinalwelle hervorgerufen werden.
In Fig. 60 ist ein Blockschaltbild einer Konstruktionsvariante des vorgeschlagenen Motors mit dem Sensor 252 dargestellt, der als zwei dünne Platten ausgeführt ist. In dem Blockschaltbild ist eine Motorvariante dargestellt, dessen Oszillator 7 zwei zusammengesetzte Generatoren der akustischen Wellen 70, 71 einschließt. In diesem Fall ist der vorgeschlagene Motor mit dem Sensorsignalkommutator 252 ausgestattet. Der Sensorsignalkommutator 252 schaltet die Sensorelektroden 253 synchron mit der Umschaltung der Bewegungsrichtung des getriebenes Elements 3 um. Eine solche Ausführung des Sensors 252 ermöglicht es, eine mögliche Asymmetrie der Sensorspannung Us bei Änderung der Bewegungsrichtung des getriebenen Elements 3 zu korrigieren.
In Fig. 61 ist ein Blockschaltbild einer Konstruktionsvariante des vorgeschlagenen Motors dargestellt, der mit einem Koordinaten- oder Bewegungsparametersensor 267 des getriebenen Elements 3 und einem prozessorgesteuerten Regler 271 ausgestattet ist.
Diese Variante hat folgende Funktionsweise: Die an dem Eingang des prozessorgesteuerten Reglers 271 befindlichen Koordinaten- oder Parameterwerte der Bewegung des getriebenen Elements 3 werden mit den softwaremäßig eingestellten Parameter verglichen. Bei einem Fehler stellt der Regler 271 ein Fehlersignal in Form der Spannung Usg bereit, die an den Eingang 241 des Umformers 240 weitergegeben wird. Diese Spannung wirkt auf den Umformer 240 und der vorhandene Fehler wird korrigiert.

Prüfungen des vorgeschlagenen Motors mit einer Oszillatorresonanzlänge L=2λ und den Maßen 60x14,5x5mm mit den getrennten Generatoren der akustischen Wellen und mit zwei auf ihn aufgestellten Friktionselementen haben ergeben, dass der Motor eine maximale Kraft von 45N bei den Erregerspannungen an den Elektroden der Generatoren von akustischen Wellen von 55 und 60 V entwickelt. Die Bewegungsgeschwindigkeit des getriebenen Elements ohne äußere Belastung beträgt 0,3m/s. Die minimale Bewegungsgeschwindigkeit des getriebenen Elements ohne ein Bewegungsstabilisationssystem beträgt ca. 0,1 µm/s.
Prüfungen eines anderen Exemplars des vorgeschlagenen Motors mit einer Oszillatorresonanzlänge L=λ und den Maßen 40x20x5mm mit den zusammengesetzten Generatoren der akustischen Wellen und mit auf ihn aufgestellten Friktionselementen haben ergeben, dass der Motor eine maximale Kraft von 27N bei der Erregerspannung an den Elektroden des zusammengesetzten Generators von akustischen Wellen von 90 V entwickelt. Der Oszillator dieses Motors hat eine sehr einfache Elektrodenstruktur, was die Herstellungstechnologie des Motors vereinfacht. Außerdem hat ein solcher Oszillator nur drei Anschlüsse. Das erhöht die Betriebsstabilität eines solchen Oszillators bei hohem Erregerniveau erheblich.
Auf den piezoelektrischen Oszillatoren dieser Motoren wurden Friktionselemente mit der Fläche der Funktionsoberfläche von 5x2=10mm² befestigt. Bei solcher Fläche der Funktionsoberfläche haben die Friktionselemente einen sehr geringen Verschleiß. Die Prüfungen des zweiten Exemplar des Motors haben ergeben, dass nach 100 Betriebsstunden der Verschleiß des Friktionselements nicht nachgemessen werden konnte. Das garantiert einen langen und stabilen Betrieb des vorgeschlagenen Motors.

### Bezugszeichenliste

- 1: Gehäuse
- 2: Lager einer Längsbewegung
- 3: Getriebenes Element
- 4: Friktionsschicht
- 5: Treibendes Element
- 6: Friktionselement
- 7: Monolithischer piezoelektrischer Oszillator
- 8: Anschlußgruppe
- 9: Elektrische Erregerquelle
- 10: Fixierende Elemente
- 11: Stützträger
- 12: Rechteckiges Piezoelement
- 13: Erste Hauptoberfläche
- 14: Zweite Hauptoberfläche
- 15: Erste Seitenoberfläche
- 16: Zweite Seitenoberfläche
- 17: Erste Stirnoberfläche
- 18: Zweite Stirnoberfläche
- 19: Elektroden der ersten Elektrodengruppe
- 20: -
- 21: Elektroden der zweiten Elektrodengruppe
- 22: -
- 23: Die Elektrodenkonfiguration des Oszillators mit einem Generator 25 demonstrierende Position
- 24: Generator einer akustischen Longitudinalwelle, die sich längs der Resonanzlänge L des Oszillators ausbreitet
- 25: Generator einer vorzeichenkonstanten akustischen Longitudinalwelle, die sich längs der Resonanzhöhe H des Oszillators ausbreitet
- 26: Anschlusse der Elektroden 19
- 27: Anschlusse der Elektroden 20
- 28: Anschlusse der Elektroden 21
- 29: Anschlusse der Elektroden 22
- 30: Oszillator 7 mit einem Generator 25
- 31: Oszillator 7 mit einem Generator 24
- 32: Erste Deformationsphase des Oszillators 7 mit einem Generator 24
- 33: Zweite Deformationsphase des Oszillators 7 mit einem Generator 25
- 34: Bewegungsbahnen von Punkten der Oberfläche 15 des Oszillators 7 mit einem Generator 24
- 35: Bewegungsbahnen von Punkten der Oberfläche 16 des Oszillators 7 mit einem Generator 24
- 36: Ausdehnungsphase des Oszillators 7 mit einem Generator 25
- 37: Komprimierungsphase des Oszillators 7 mit einem Generator 25
- 38: Bewegungsbahnen von Punkten der Oberfläche 15 des Oszillators 7 mit einem Generator 25
- 39: Bewegungsbahnen von Punkten der Oberfläche 15 des Oszillators 7 mit einem Generator 24
- 40: Eine die Funktionsweise des Oszillators 7 mit zwei Generatoren 24, 25 erklärende Position
- 41: Bewegungsbahnen von Punkten der Oberfläche 15 des Oszillators 7 mit zwei Generatoren 24, 25
- 42: Bewegungsbahnen von Punkten der Oberfläche 16 des Oszillators 7 mit zwei Generatoren 24, 25
- 43: Anpreßphase des Friktionselements 6
- 44: Vorwärtsbewegungsphase des Friktionselements 6
- 45: Rückwertsanpreßphase Friktionselements 6
- 46: Rückwärtsbewegungsphase des Friktionselements 6
- 47: Variante des Oszillators 7 mit der Resonanzlänge L =nλ, n=1, 2, 3...
- 48: -
- 49: -
- 50: -
- 51: Oszillator 7 als ein Zylinder
- 52: Oszillator 7 als ein Zylinderteil
- 53: Anordnungsvariante von Stoßer am Oszillator 7 in Form eines Zylinderteils
- 54: -
- 55: Oszillator 7 als ein Zylinder
- 56: Generator für eine vorzeichenvariable akustische Longitudinalwelle, die sich längs der Resonanzhöhe H des Oszillators 7 ausbreitet
- 57: Eine die Elektrodenkonfiguration des Oszillators 7 mit einem Generator 56 illustrierende Position
- 58: Oszillator 7 mit einem Generator 56
- 59: Erste Deformationsphase des Oszillators 7 mit einem Generator 56
- 60: Zweite Deformationsphase des Oszillators 7 mit einem Generator 56
- 61: Bewegungsbahnen von Punkten der Oberfläche 15 des Oszillators 7 mit einem Generator 56
- 62: Bewegungsbahnen von Punkten der Oberfläche 16 des Oszillators 7 mit einem Generator 56
- 63: Eine die Funktionsweise des Oszillators 7 mit zwei Generatoren 24, 56 illustrierende Position
- 64: Bewegungsbahnen von Punkten der Oberfläche 15 des Oszillators 7 mit zwei Generatoren 24, 56
- 65: Bewegungsbahnen von Punkten der Oberfläche 16 des Oszillators 7 mit zwei Generatoren 24, 56
- 66: Erste vereinigte Elektrode
- 67: Zweite vereinigte Elektrode
- 68: Dritte vereinigte Elektrode
- 69: Vierte vereinigte Elektrode
- 70: Erster zusammengesetzter Generator
- 71: Zweiter zusammengesetzter Generator
- 72: Elektrodenkonfiguration des Oszillators 7 mit den Generatoren 70, 71
- 73: Anschluß der Elektrode 66
- 74: Anschluß der Elektrode 67
- 75: Anschluß der Elektrode 68
- 76: Anschluß der Elektrode 69
- 77: Gruppe der Anschlusse 66, 67, 68, 69
- 78: Gemeinsame Elektrode
- 79: Anschluß der Elektrode 78
- 80: Elektrodenkommutator
- 81: Erste Deformationsphase des Oszillators 7 bei der Ausbreitung einer vom Generator 70 erregten Longitudinalwelle längs der Länge L
- 82: Zweite Deformationsphase des Oszillators 7 bei der Ausbreitung einer vom Generator 70 erregten Longitudinalwelle längs der Länge L
- 83: Bewegungsbahn von längs der Achse b1 liegenden Punkte der Oberfläche 15
- 84: Bewegungsbahn von längs der Achse b1 liegenden Punkte der Oberfläche 16
- 85: Erste Deformationsphase des Oszillators 7 bei der Ausbreitung einer vom Generator 70 erregten Longitudinalwelle längs der Höhe H
- 86: Zweite Deformationsphase des Oszillators 7 bei der Ausbreitung einer vom Generator 70 erregten Longitudinalwelle längs der Höhe H
- 87: Bewegungsbahn von längs der Achse e liegenden Punkte der Oberfläche 15
- 88: Bewegungsbahn von längs der Achse b1 liegenden Punkte der Oberfläche 16
- 89: Die Funktionsweise des Oszillators 7 mit einem Generator 70 illustrierende Position
- 90: Bewegungsbahn von längs der Achse ble liegenden Punkte der Oberfläche 15
- 91: Bewegungsbahn von längs der Achse ble liegenden Punkte der Oberfläche 16
- 92: Erste Deformationsphase des Oszillators 7 bei der Ausbreitung einer vom Generator 71 erregten Longitudinalwelle längs der Länge L
- 93: Zweite Deformationsphase des Oszillators 7 bei der Ausbreitung einer vom Generator 71 erregten Longitudinalwelle längs der Länge L
- 94: Bewegungsbahn von längs der Achse b2 liegenden Punkte der Oberfläche 15
- 95: Bewegungsbahn von längs der Achse b2 liegenden Punkte der Oberfläche 16
- 96: Die Funktionsweise des Oszillators 7 mit einem Generator 71 illustrierende Position
- 97: Bewegungsbahn von längs der Achse b2e liegenden Punkte der Oberfläche 15
- 98: Bewegungsbahn von längs der Achse ble liegenden Punkte der Oberfläche 16
- 99: Mehrschichtiger Oszillator 7 in Form eines ganzen elektromechanischen Resonators
- 100: Friktionselement 6 als ein Streifen
- 101: Friktionselement 6 als ein Stäbchen oder eine Prisma
- 102: -
- 103: -
- 104: Friktionselement 6 als ein pyramidenförmiges Element
- 105: -
- 106: Friktionselement 6 als ein halbzylinderförmiges Element
- 107: Friktionselement 6 als ein zylinderförmiges Element
- 108: -
- 109: -
- 110: Friktionselement 6 als ein konisches Element
- 111: Friktionselement 6 als ein halbsphärisches Element
- 112: Funktionsoberfläche des Friktionselements 6
- 113: Verbindende Oberfläche des Friktionselements 6
- 114: Variante des Friktionselements 6 mit Quernuten
- 115: -
- 116: -
- 117: Quernut der Friktionselemente
- 118: Variante eines zweischichtigen Friktionselements 6
- 119: -
- 120: -
- 121: Variante eines mehrschichtigen Friktionselements 6
- 122: -
- 123: -
- 124: Verschleißfeste Schicht des Friktionselements 6
- 125: Verbindende Schicht des Friktionselements 6
- 126: Variante eines mehrschichtigen Friktionselements 6 mit senkrecht zu den Seitenoberflächen 15, 16 angeordnetes Schichten
- 127: -
- 128: -
- 129: Verschleißfeste Schicht
- 130: Dämpfungsschicht des Friktionselements
- 131: Variante eines mehrschichtigen Friktionselements mit zylindrischen Schichten
- 132: -
- 133: -
- 134: Verschleißfeste Schicht des mehrschichtigen Friktionselements 6 mit zylindrischen Schichten
- 135: Dämpfungsschicht des mehrschichtigen Friktionselements 6 mit zylindrischen Schichten
- 136: Schutzschicht des mehrschichtigen Friktionselements 6 mit zylindrischen Schichten
- 137: Geneigte Funktionsoberfläche
- 138: Varianten der Funktionsoberfläche
- 139: -
- 140: -
- 141: -
- 142: -
- 143: -
- 144: Konkave Funktionsoberfläche 112 dreieckiger Form
- 145: Konvexe Funktionsoberfläche 112 dreieckiger Form
- 146: Konkave Funktionsoberfläche 112 runder Form
- 147: Konvexe Funktionsoberfläche 112 runder Form
- 148: Funktionsoberfläche 112 rippenförmiger dreieckiger Form
- 149: Funktionsoberfläche 112 rippenförmiger runder Form
- 150: Die Funktionsoberfläche 112 bildende Oberfläche
- 151: Friktionselemente als Glasstreifen
- 152: Begrenzende Elemente
- 153: Elastische Elemente
- 154: Getriebenes Elemente 3 in Form eines Rahmen
- 155: Begrenzenden Elemente als mechanische Resonatoren
- 156: Getriebenes Element 2 in Form einer Scheibe
- 157: Welle
- 158: Lager der Rotationsbewegung
- 159: Fixierenden Elemente 10 als rechteckige Prismen
- 160: Fixierenden Elemente 10 als dreieckige Prismen
- 161: Fixierenden Elemente 10 als halbzylindrische Prismen
- 162: Konische fixierende Elemente 10
- 163: Pyramidenförmige fixierende Elemente 10
- 164: Halbsphärische fixierend Elemente 10
- 165: Fixierende Elemente 10 mit Profilnuten
- 166: -
- 167: Fixierende Elemente 10 mit herausragenden Teilen
- 168: Fixierenden Elemente 10 als zylindrisch stufenförmige Elemente
- 169: Fixierende Elemente 10 als runde Elemente mit Profilbohrungen
- 170: -
- 171: Fixierende Elemente 10 als Resonanzbiegeplatten oder -balken
- 172: Starre Stützträger der fixierenden Elementen 10
- 173: Elastische Elemente
- 174: Getriebenes Element als eine rechteckige Plattform
- 175: Längsdämpfungsbohrungen
- 176: Dämpfungsbohrungen runder Form
- 177: Dämpfungsbohrungen elliptischer Form
- 178: Dämpfungsschicht
- 179: Funktionsoberfläche der Friktionsschicht 4
- 180: Konvexe dreieckige Funktionsoberfläche 179
- 181: Konkave dreieckige Funktionsoberfläche 179
- 182: Konvexe runde Funktionsoberfläche 179
- 183: Konkave runde Funktionsoberfläche 179
- 184: Rippenförmige dreieckige Funktionsoberfläche 179
- 185: Rippenförmige runde Funktionsoberfläche 179
- 186: Magneten
- 187: Getriebenes Element 3 als ein Ring oder ein Hohlzylinder
- 188: Zähne eines Zahnrads
- 189: Getriebenes Element 3 als Rahmen
- 190: Elastische Unterlage
- 191: Flansch
- 192: Welle
- 193: Getriebenes Element 3 als runder Balken oder als Rohr
- 194: Starre Stützträger als flache Feder
- 195: Getriebenes Element 3 als dreieckiger Balken
- 196: Zweikanalleistungsverstärker
- 197: Erster Kanal des Verstärkers 196
- 198: Zweiter Kanal des Verstärkers 196
- 199: Formierungsglied
- 200: Eingang des Formierungsgliedes 199
- 201: Ausgang des Grundgenerators
- 202: Grundgenerator
- 203: Ausgangsleistungsverstärker
- 204: Erster Ausgang des Leistungsverstärkers 203
- 205: Zweiter Ausgang des Leistungsverstärkers 203
- 206: Erster Eingang des Anpassungsgliedes
- 207: Zweiter Eingang des Anpassungsgliedes
- 208: Anpassungsglied
- 209: Erster Ausgang des Anpassungsgliedes
- 210: Zweiter Ausgang des Anpassungsgliedes
- 211: Einkanalleistungsverstärker
- 212: Eingang des Elektrodenkommutators 80
- 213: Erster Ausgang des Elektrodenkommutators 80
- 214: Zweiter Ausgang des Elektrodenkommutators 80
- 215: Steuereingang des Elektrodenkommutators 80
- 216: Brückenleistungsverstärker
- 217: Halbbrückenleistungsverstärker
- 218: Transistorschalter des Halbbrückenleistungsverstärkers 217
- 219: Erster Erregerkanal
- 220: Zweiter Erregerkanal
- 221: Treiber
- 222: Formierglied
- 223: Signalphasensteuerungsglied
- 224: Phasensteuereingang
- 225: Reversumschalter
- 226: Steuereingang des Reversumschalters
- 227: Masse oder gemeinsames Potential der Erregerquelle 9
- 228: Variante des Anpassungsgliedes 208
- 229: -
- 230: -
- 231: -
- 232: -
- 233: -
- 234: Summierender Transformator
- 235: Kompensationsinduktivität
- 236: Resonanzkondensator
- 237: Diagramme der zwischen den Anschlüssen 204 und 227 wirksamen Spannung U1
- 238: Diagramme der zwischen den Anschlüssen 205 und 227 wirksamen Spannung U1
- 239: Diagramme der an den Anschlüssen 209 und 210 des Anpassungsgliedes 208 wirksamen Spannung U3
- 240: Steuersignalumformer
- 241: Signaleingang des Umformers 240
- 242: Steuerspannungsausgang
- 243: Schwellendetektor der Nullage
- 244: Meßeingang des Schwellendetektor 243
- 245: Ausgang des Schwellendetektor 243
- 246: Kennlinienvarianten des Steuersignalumformers 240
- 247: -
- 248: Kennlinie des Schwellendetektors der Nullage 243
- 249: Steuerkennlinie der elektrischen Erregerquelle 9
- 250: Sensor für mechanische Spannungen mit einer piezoelektrischen Platte
- 251: Sensor für mechanische Spannungen mit zwei piezoelektrischen Platten
- 252: Sensor
- 253: Erste Elektrode des Sensors 252
- 254: Zweite Elektrode des Sensors 252
- 255: Frequenzkennlinien des Sensors 252
- 256: Phasenkennlinien des Sensors 252
- 257: Frequenzsteuereingang der elektrischen Erregerquelle 202
- 258: Phasendetektor
- 259: Erster Phaseneingang des Phasendetektors 258
- 260: Zweiter Phaseneingang des Phasendetektors 258
- 261: Ausgang des Phasendetektors 258
- 262: Signalkommutator des Sensors 252
- 263: Erster Eingang des Signalkommutators 262
- 264: Zweiter Eingang des Signalkommutators 262
- 265: Ausgang des Signalkommutators 262
- 266: Steuereingang des Signalkommutators 262
- 267: Sensor der Koordinaten oder Bewegungsparameter des getriebenen Elements 3
- 268: Skale des Sensors 267
- 269: Ablesevorrichtung des Sensors 267
- 270: Informationsausgang des Sensors 267
- 271: Prozessorregler.
- 272: Ausgang des Prozessorsreglers 271.

## Patentansprüche

1. Piezoelektrisches Stellelement, insbesondere piezoelektrischer Motor in Form eines monolithischen plattenförmigen oder zylindrischen piezoelektrischen Oszillators (7) mit einer ersten und einer zweiten Art von Hauptoberflächen (13, 14) und diesen zugeordneten Elektrodengruppen, (19, 20, 21, 22) umfassend ein Gehäuse (1), ein getriebenes Element (3), mindestens eine sich auf dem Gehäuse (1) oder auf dem getriebenen Element (3) befindliche Friktionsschicht (4), ein mit einer elektrischen Erregerquelle (9) verbundenes und mit der Friktionsschicht, im Friktionskontakt stehendes treibendes Element (5) ,
**dadurch gekennzeichnet, dass**
der piezoelektrische Oszillator (7) durch die Elektrodengruppen (19, 20, 21, 22) zu stehenden longitudinalen akustischen Wellen in Richtung einer Oszillatorresonanzlänge (L), sowie einer Oszillatorresonanzhöhe (H) dieses piezoelektrischen Oszillators (7) angeregt wird, wobei die Oszillatorresonanzlänge (L) gleich oder gleich einem ganzzahligen Vielfachen der Wellenlänge der in ihre Richtung schwingenden stehenden longitudinalen akustischen Welle ist, sowie die Oszillatorresonanzhöhe (H) gleich einer halben Wellenlänge der in ihre Richtung schwingenden stehenden longitudinalen akustischen Welle ist, wobei sowohl die Oszillatorresonanzlänger (L) auch die Oszillatorresonanzhöhe (H) in der Weise gewählt sind, dass die Frequenzen der sich durch den piezoelektrischen Oszillator (7) ausbreitenden stehenden longitudinalen akustischen Wellen sowohl in Richtung der Oszillatorresonanzlänge (L) als auch der oszillatorresonanzhöhe (H) gleich sind.

2. Piezoelektrisches Stellelement nach Anspruch 1,
**dadurch gekennzeichnet, dass**
die in Oszillatorresonanzhöhe schwingende stehende akustische longitudinale Welle vorzeichenkonstant entlang der Oszillatorresonanzlänge ist.

3. Piezoelektrisches Stellelement nach Anspruch 1,
**dadurch gekennzeichnet, daß**
die in Oszillatorresonanzhöhe schwingende stehende akustische longitudinale Welle vorzeichenvariabel entlang der Oszillatorresonanzlänge ist.

4. Piezoelektrisches Stellelement nach Anspruch 1 oder 2,
**dadurch gekennzeichnet, dass**
eine Gruppe von Elektroden, die einen ersten Generator akustischer stehender longitudinaler Wellen bilden, an Enden der Oszillatorhauptoberflächen symmetrisch bezüglich einer durch die Mitte der Oszillatorresonanzhöhe verlaufenden Symmetrieebene angeordnet ist und eine zweite Gruppe von Elektroden, die einen zweiten Generator stehender akustischer longitudinaler Wellen bilden, in mittleren Gebieten der Oszillatorhauptoberflächen symmetrisch bezüglich der durch die Mitte der Oszillatorresonanzhöhe verlaufenden Symmetrieebene liegen.

5. Piezoelektrisches Stellelement nach einem der vorhergehenden Ansprüche,
**dadurch gekennzeichnet, dass**
die erste und die zweite Elektrodengruppe, die den ersten und den zweiten Generator der stehenden longitudinalen akustischen Wellen bilden, miteinander verbunden sind und damit einen zusammengesetzten Wellengenerator bilden, der gleichzeitig eine in Richtung der Oszillatorresonanzlänge schwingende stehende longitudinale akustische Welle sowie eine in Richtung der Oszillatorresonanzhöhe schwingende stehende longitudinale akustische Welle erzeugt.

6. Piezoelektrisches Stellelement nach einem der Ansprüche 1 bis 5,
**dadurch gekennzeichnet, daß**
dieses aus mindestens zwei plattenförmigen piezoelektrischen, akustisch miteinander verbundenen Oszillatoren besteht, die einen einheitlichen elektromechanischen Resonator bilden.

7. Piezoelektrisches Stellelement nach Anspruch 6,
**dadurch gekennzeichnet, daß**
bei die piezoelektrischen Oszillatoren mittels eines starren organischen Klebstoffes verbunden sind.

8. Piezoelektrisches Stellelement nach Anspruch 6,
**dadurch gekennzeichnet, daß**
die Verbindung der piezoelektrischen Oszillatoren mittels eines Sinterverfahrens verbunden sind.

9. Piezoelektrisches Stellelement nach Anspruch 2,
**dadurch gekennzeichnet, daß**
die Friktionselemente auf einer oder zwei Seitenoberflächen des piezoelektrischen Oszillators vorzugsweise in Bereichen mit vorzeichengleichen Schwingungsmaxima der in Richtung der Oszillatorresonanzlänge schwingenden stehenden akustischen longitudinalen Welle angeordnet sind.

10. Piezoelektrisches Stellelement nach Anspruch 3,
**dadurch gekennzeichnet, daß**
die Friktionselemente auf einer oder zwei Seitenoberflächen des piezoelektrischen Oszillators vorzugsweise in Bereichen mit vorzeichenunterschiedlichen Schwingungsmaxima, der in Richtung der Oszillatorresonanzlänge schwingenden stehenden akustischen longitudinalen Welle angeordnet sind.

11. Piezoelektrisches Stellelement nach einem der vorhergehenden Ansprüche,
**dadurch gekennzeichnet, daß**
die Friktionselemente eine streifenförmige, stäbchenförmige, pyramidenförmige, konische, zylindrische oder halbsphärische Form aufweisen und aus einem harten, verschleißfesten Werkstoff, beispielsweise Oxidkeramik, Metallkeramik oder Kompositen mit anderen Materialien bestehen.

12. Piezoelektrisches Stellelement nach Anspruch 11,
**dadurch gekennzeichnet, daß**
die Friktionselemente Quernute aufweisen.

13. Piezoelektrisches Stellelement nach Anspruch 11,
**dadurch gekennzeichnet, daß**
die Friktionselemente eine ein- oder mehrschichtige Struktur haben.

14. Piezoelektrisches Stellelement nach Anspruch 13,
**dadurch gekennzeichnet, daß**
die Schichten der ein- oder mehrschichtigen Struktur der Friktionselemente parallel zu den Seitenoberflächen des piezoelektrischen Oszillators angeordnet sind.

15. Piezoelektrisches Stellelement nach Anspruch 13,
**dadurch gekennzeichnet, daß**
die Schichten der ein- oder mehrschichtigen Struktur der Friktionselemente senkrecht bezüglich der Seitenoberflächen des piezoelektrischen Oszillators orientiert sind.

16. Piezoelektrisches Stellelement nach einem der vorhergehenden Ansprüche,
**dadurch gekennzeichnet, daß**
die Schichten der Friktionselemente eine zylindrische Form aufweisen und konzentrisch angeordnet sind.

17. Piezoelektrisches Stellelement nach einem der vorhergehenden Ansprüche,
**dadurch gekennzeichnet, dass**
die Schichten der ein- oder mehrschichtigen Struktur der Friktionselemente unterschiedliche Elastizitätsmodule aufweisen.

18. Piezoelektrisches Stellelement nach Anspruch 14,
**dadurch gekennzeichnet, dass**
eine verschleißfeste Schicht des Friktionselementes einen Elastizitätsmodul aufweist, der durch Verschleißfestigkeit und Festigkeit der Funktionsoberfläche bestimmt ist und eine verbindende Schicht des Friktionselementes einen Elastizitätsmodul aufweist, der dem Elastizitätsmodul der piezoelektrischen Keramik des piezoelektrischen Oszillators entspricht.

19. Piezoelektrisches Stellelement nach einem der Ansprüche 1 bis 17,
**dadurch gekennzeichnet, dass**
die verschleißfeste Schicht einer mehrschichtigen Struktur der Friktionselemente einen Elastizitätsmodul aufweist, der durch Verschleißfestigkeit und Festigkeit der Funktionsoberfläche bestimmt ist und weiterhin eine Dämpfschicht einen Elastizitätsmodul aufweist, der durch die dynamische Stabilität der verschleißfesten Schicht bestimmt ist.

20. Piezoelektrisches Stellelement nach einem der vorhergehenden Ansprüche,
**dadurch gekennzeichnet, dass**
die Schichten einer zwei- oder mehrschichtigen Struktur der Friktionselemente aus monolithischen Materialien bestehen und durch Sintern miteinander verbunden sind.

21. Piezoelektrisches Stellelement nach einem der vorhergehenden Ansprüche,
**dadurch gekennzeichnet, dass**
die Verbindungsschicht des Friktionselementes aus einem porösen Material besteht.

22. Piezoelektrisches Stellelement Anspruch 21,
**dadurch gekennzeichnet, dass**
alle Schichten mit Ausnahme einer verschleißfesten Deckschicht zumindest teilweise aus einem porösen Material mit einer variablen Porosität ausgeführt sind, wobei die Verbindungsschicht eine maximale Porosität aufweis.

23. Piezoelektrisches Stellelement nach Anspruch 19,
**dadurch gekennzeichnet, dass**
die dämpfende Schicht aus einem porösen Werkstoff besteht.

24. Piezoelektrisches Stellelement nach einem der vorhergehenden Ansprüche,
**dadurch gekennzeichnet, dass**
bei Friktionselementen einer flach ausgeführten Funktionsoberfläche diese Funktionsoberfläche geneigt zu der Seitenoberfläche angeordnet ist, auf der sich die Friktionselemente befinden.

25. Piezoelektrisches Stellelement nach einem der Ansprüche 1 bis 23,
**dadurch gekennzeichnet, dass**
die Funktionsoberfläche der Friktionselemente eine dreieckige konkave oder konvexe, runde konkave oder konvexe oder rippenförmige Form aufweist, wobei eine so gebildete Funktionsoberfläche entlang der Resonanzlänge des piezoelektrischen Oszillators angeordnet ist.

26. Piezoelektrisches Stellelement nach einem der vorhergehenden Ansprüche,
**dadurch gekennzeichnet, dass**
die Friktionselemente mittels eines organischen Klebstoffes, z.B. auf Epoxydharzbasis mit der Oberfläche des piezoelektrischen Oszillators verbunden sind.

27. Piezoelektrisches Stellelement nach einem der Ansprüche 1 bis 25,
**dadurch gekennzeichnet, dass**
die Friktionselemente mittels eines Stoffes mit der Oberfläche des piezoelektrischen Oszillators verbunden sind, der eine chemische Bindung mit der piezoelektrischen Keramik eingeht, z.B. mittels eines bleihaltigen leichtschmelzenden Glases.

28. Piezoelektrisches Stellelement nach Anspruch 21 bis 23,
**dadurch gekennzeichnet, dass**
die Poren der Friktionselemente vollständig oder teilweise mit dem das Friktionselement mit der Oberfläche der piezoelektrischen Oszillators Verbindungsstoff aufgefüllt sind.

29. Piezoelektrisches Stellelement nach Anspruch 12,
**dadurch gekennzeichnet, dass**
die Quernute mit einem schalldämpfenden Stoff aufgefüllt sind.

30. Piezoelektrisches Stellelement nach einem der vorhergehenden Ansprüche,
**dadurch gekennzeichnet, dass**
das oder die Friktionselemente insbesondere als auf die Oberfläche des piezoelektrischen Oszillators aufgeschmolzene Glasstreifen ausgeführt sind.

31. Piezoelektrisches Stellelement nach Anspruch 30,
**dadurch gekennzeichnet, dass**
die Friktionselemente mit Pulver eines verschleißfesten Stoffes, beispielsweise Aluminiumoxid, Zirkonoxid, Wolframcarbid, Titancarbid, Titannitrid oder eines anderen ähnlichen Stoffes aufgefüllt sind.

32. Piezoelektrisches Stellelement nach einem der vorhergehenden Ansprüche,
**dadurch gekennzeichnet, dass**
dieses mit begrenzenden Elementen ausgestattet ist, um eine Verschiebung des piezoelektrischen Oszillators in Richtung seiner Oszillatorresonanzlänge zu verhindern.

33. Piezoelektrisches Stellelement nach Anspruch 32,
**dadurch gekennzeichnet, dass**
die die Verschiebung des Oszillators verhindernden Elemente als mechanische Resonatoren dienen, derer Resonanzfrequenz mit der Schwingungsfrequenz des piezoelektrischen Oszillators während des Motorbetriebs übereinstimmt.

34. Piezoelektrisches Stellelement nach einem der vorhergehenden Ansprüche,
**dadurch gekennzeichnet, dass**
der piezoelektrische Oszillator mit mindestens einem fixierenden Element ausgestattet ist, das starr mit dem Oszillator verbunden ist.

35. Piezoelektrisches Stellelement nach Anspruch 34,
**dadurch gekennzeichnet, dass**
die fixierenden Elemente mindestens auf einer der Seitenoberflächen des piezoelektrischen Oszillators insbesondere an den Stellen der Schwingungsminima der in Richtung der Oszillatorresonanzlänge schwingenden stehenden akustischen longitudinalen Welle angeordnet sind.

36. Piezoelektrisches Stellelement nach einem der Ansprüche 1 bis 34,
**dadurch gekennzeichnet, dass**
die fixierenden Elemente mindestens auf einer der Hauptoberflächen des piezoelektrischen Oszillators insbesondere an den Stellen der Schwingungsminima der der in Richtung der Oszillatorresonanzlänge schwingenden stehenden akustischen longitudinalen Welle angeordnet sind.

37. Piezoelektrisches Stellelement nach einem der Ansprüche 34 bis 36,
**dadurch gekennzeichnet, dass**
die fixierenden Elemente die Form eines rechteckigen Prismas, eines dreieckigen Prismas, eines halbzylindrischen Prismas, kegelförmigen Elementes, pyramidenförmigen Elementes, halbsphärischen Elements oder rechteckigen Elementes mit Profilnuten oder dergleichen besitzen sowie als herausragende Teile, als zylindrische Stufenelemente oder als runde Elemente mit Profilbohrungen oder dergleichen ausgeführt sind.

38. Piezoelektrisches Stellelement nach einem der Ansprüche 34 bis 37,
**dadurch gekennzeichnet, dass**
die fixierenden Elemente aus einem Werkstoff, dessen Elastizitätsmodul gleich oder ein wenig größer als der Elastizitätsmodul der piezoelektrischen Keramik des piezoelektrischen Oszillators ist, insbesondere Oxidkeramik bestehen.

39. Piezoelektrisches Stellelement nach einem der Ansprüche 34 bis 37,
**dadurch gekennzeichnet, dass**
die fixierenden Elemente aus einem Werkstoff, dessen Elastizitätsmodul viel kleiner als der Elastizitätsmodul der Piezokeramik des piezoelektrischen Oszillators ist, bestehen.

40. Piezoelektrisches Stellelement nach einem der Ansprüche 34 bis 37
**dadurch gekennzeichnet, dass**
die fixierenden Elemente aus dem gleichen Piezokeramiktyp wie der piezoelektrische Oszillator bestehen.

41. Piezoelektrisches Stellelement nach einem der Ansprüche 34 bis 39,
**dadurch gekennzeichnet, dass**
jedes fixierende Element oder eines seiner Teile aus einem porösen Werkstoff besteht.

42. Piezoelektrisches Stellelement nach Anspruch 34,
**dadurch gekennzeichnet, dass**
die fixierenden Elemente als Resonanzbiegeplatten oder -balken ausgeführt sind.

43. Piezoelektrisches Stellelement nach einem der Ansprüche 34 bis 42,
**dadurch gekennzeichnet, dass**
die fixierenden Elemente mit Hilfe eines organischen Klebers mit der Oberfläche des piezoelektrischen Oszillators verbunden sind.

44. Piezoelektrisches Stellelement nach einem der Ansprüche 34 bis 42,
**dadurch gekennzeichnet, dass**
die Friktionselemente mittels eines auf die Oberflächen des piezoelektrischen Oszillators aufgetragenen Stoffes mit diesem verbunden sind, wobei der Stoff eine chemische Bindung mit der piezoelektrischen Keramik oder mit der Zwischenschicht bzw. dem Werkstoff des fixierenden Elementes eingeht, insbesondere unter Verwendung eines bleihaltigen leichtschmelzenden Glases.

45. Piezoelektrisches Stellelement nach einem der Ansprüche 34 bis 41,
**dadurch gekennzeichnet, dass**
die fixierenden Elemente in starren Stützträgern aufgestellt werden.

46. Piezoelektrisches Stellelement nach Anspruch 45,
**dadurch gekennzeichnet, dass**
die starren Stützträger als flache Federn ausgeführt sind.

47. Piezoelektrisches Stellelement nach einem der vorhergehenden Ansprüche,
**dadurch gekennzeichnet, dass**
das getriebene Element verschiebbar gelagert ist.

48. Piezoelektrisches Stellelement nach einem der vorhergehenden Ansprüche,
**dadurch gekennzeichnet, dass**
das getriebene Element in Form einer rechteckigen Plattform, eines Rahmens mit rechteckigem, vieleckigem oder rundem Querschnitt, als ein Balken oder als ein Rohr ausgeführt ist.

49. Piezoelektrisches Stellelement nach einem der Ansprüche 1 bis 46,
**dadurch gekennzeichnet, dass**
das getriebene Element drehbar gelagert ist.

50. Piezoelektrisches Stellelement nach Anspruch 49,
**dadurch gekennzeichnet, dass**
das getriebene Element in Form eines Zylinders, einer Scheibe, eines Hohlzylinders oder eines Ringes oder teilweise aus einem diesen Formen ausgeführt ist.

51. Piezoelektrisches Stellelement nach einem der vorhergehenden Ansprüche,
**dadurch gekennzeichnet, dass**
im Körper des Friktionselementes Dämpfungsbohrungen in rechteckiger, runder, elliptischer oder dergleichen Formen vorgesehen sind, die eine Ausbreitung von akustischen Wellen im Friktionselement verhindern, deren Frequenz gleich der Frequenz des piezoelektrischen Oszillators oder ihrer Oberschwingungen während des Motorbetriebes ist.

52. Piezoelektrisches Stellelement nach einem der vorhergehenden Ansprüche,
**dadurch gekennzeichnet, dass**
das getriebene Element oder Teile hiervon aus einem harten porösen Werkstoff ausgeführt ist.

53. Piezoelektrisches Stellelement nach Anspruch 52,
**dadurch gekennzeichnet, dass**
Poren des getriebenen Elementes mit einem schalldämpfenden Werkstoff, beispielsweise mit Silikongummi, aufgefüllt sind.

54. Piezoelektrisches Stellelement nach einem der vorhergehenden Ansprüche,
**dadurch gekennzeichnet, dass**
die Friktionsschicht des getriebenen Elementes aus Oxidkeramik oder einem anderem harten verschleißfesten Werkstoff ausgeführt ist, wobei deren Dicke mindestens fünf mal kleiner als die Resonanzhöhe des piezoelektrischen Oszillators ist.

55. Piezoelektrisches Stellelement nach Anspruch 29,
**dadurch gekennzeichnet, dass**
die Funktionsoberfläche der Friktionsschicht eine dreieckige konkave oder konvexe Form, eine runde konkave oder konvexe Form oder eine rippenartige Form aufweist, wobei die Funktionsoberfläche entlang der Resonanzlänge des piezoelektrischen Oszillators angeordnet ist.

56. Piezoelektrisches Stellelement nach einem der vorhergehenden Ansprüche,
**dadurch gekennzeichnet, dass**
die Körperdicke des unter der Friktionsschicht angeordneten Friktionselementes größer als die Resonanzhöhe des piezoelektrischen Oszillators ist.

57. Piezoelektrisches Stellelement nach einem der vorhergehenden Ansprüche,
**dadurch gekennzeichnet, dass**
zwischen dem Körper des getriebenen Elementes und der Friktionsschicht eine Dämpfschicht angeordnet ist, die aus einem viskosen organischen oder einem porösen nicht organischen Werkstoff oder aus einer Zusammensetzung dieser Werkstoffe besteht.

58. Piezoelektrisches Stellelement nach einem der vorhergehenden Ansprüche,
**dadurch gekennzeichnet, dass**
dieses mindestens zwei gegenüberstehende piezoelektrische Oszillatoren und mindestens zwei sich auf den gegenüberliegenden Seiten des getriebenen Elementes befindliche Friktionsschichten aufweist.

59. Piezoelektrisches Stellelement nach einem der vorhergehenden Ansprüche,
**dadurch gekennzeichnet, dass**
dieses mindestens drei piezoelektrische Oszillatoren und mindestens drei, parallel zueinander angeordnete und mindestens in drei Ebenen liegende Friktionsschichten aufweist

60. Piezoelektrisches Stellelement nach einem der vorhergehenden Ansprüche,
**dadurch gekennzeichnet, dass**
die elektrische Erregerquelle als ein Zweikanalleistungsverstärker ausgeführt ist, mit einem ersten und einem zweiten Kanal, die an den Grundgenerator angeschlossene Formierungsglieder einschließen und mit einem Ausgangsleistungsverstärker, der elektrisch über Anpassungstufen mit entsprechenden Elektroden des Generators der entlang der Resonanzlänge des piezoelektrischen Oszillators schwingenden stehenden akustischen longitudinalen Wellen, bzw. mit Elektroden des Generators der entlang der Resonanzhöhe schwingenden stehenden akustischen longitudinalen Wellen verbunden ist.

61. Piezoelektrisches Stellelement nach Anspruch 5,
**dadurch gekennzeichnet, dass**
die elektrische Erregerquelle als ein Einkanalleistungsverstärker ausgeführt ist, der mit einer an den Grundgenerator angeschlossenen Formierungstufe und mit einem Ausgangsleistungsverstärker verbunden ist, welcher über eine Anpassungstufe und einen Elektrodenkommutator an den Elektroden des entsprechenden zusammengesetzten Generators angeschlossen ist.

62. Piezoelektrisches Stellelement nach Anspruch 60 oder 61,
**dadurch gekennzeichnet, dass**
der Ausgangsleistungsverstärker als Brückenleistungsverstärker ausgeführt ist, wobei jeder von diesen zwei Halbbrücken einschließt und die Formierungstufen zwei Erregerkanäle der genannten Halbbrückenleistungsverstärker enthalten, wobei einer der Erregerkanäle mit einem Phasensteuerungsglied ausgestattet ist und einen Phasensteuerungseingang aufweist.

63. Piezoelektrisches Stellelement Anspruch 62,
**dadurch gekennzeichnet, dass**
ein Signalpegelumformer vorgesehen ist, dessen Ausgang mit dem Phasensteuerungseingang des Phasensteuerungsgliedes verbunden ist.

64. Piezoelektrisches Stellelement nach Anspruch 62,
**dadurch gekennzeichnet, dass**
ein Demodulator eines pulsbreitenmodulierten Signals vorgesehen ist, dessen Ausgang mit dem Phasensteuerungseingang des Phasensteuerungsgliedes verbunden ist.

65. Piezoelektrisches Stellelement nach Anspruch 63,
**dadurch gekennzeichnet, dass**
ein Stufendetektor für eine Nullage vorgesehen ist, dessen Messeingang an einen Eingang des Signalpegelumformers oder an einen Ausgang des Demodulators eines pulsbreitenmodulierten Signals angeschlossen ist und dessen Ausgang mit einem Eingang eines Reversumschalters oder mit einem Steuereingang eines Elektrodenkommutators verbunden ist.

66. Piezoelektrisches Stellelement nach einem der vorhergehenden Ansprüche,
**dadurch gekennzeichnet, dass**
der Grundgenerator mit einem Frequenzsteuereingang ausgestattet ist.

67. Piezoelektrisches Stellelement nach Anspruch 66,
**dadurch gekennzeichnet, dass**
ein Phasendetektor mit ersten und zweiten Phaseneingängen und mit einem Ausgang vorgesehen ist, wobei der Ausgang des Phasendetektors mit dem Frequenzsteuereingang des Grundgenerators verbunden ist, der erste Phaseneingang elektrisch mit den gleichnamigen Elektroden des entsprechenden Generators von akustischen longitudinalen Wellen verbunden ist und der zweite Phaseneingang elektrisch mit einem mechanischen Spannungssensor dieser Wellen verbunden ist.

68. Piezoelektrisches Stellelement nach Anspruch 67,
**dadurch gekennzeichnet, dass**
der mechanische Spannungssensor als eine dünne piezokeramische Platte ausgeführt ist, die auf ihren größeren Oberflächen Elektroden aufweist und akustisch auf der Oberfläche des piezoelektrischen Oszillators an der Stelle der größten mechanischen Spannungen insbesondere der entsprechenden stehenden akustischen, sich im piezoelektrischen Oszillator ausbreitenden longitudinalen Welle angeordnet ist.

69. Piezoelektrisches Stellelement nach Anspruch 67 oder 68,
**dadurch gekennzeichnet, dass**
der mechanische Spannungssensor aus zwei dünnen piezokeramischen Platten besteht, die auf ihren breiten Oberflächen Elektroden enthalten und akustisch auf der Oberfläche des piezoelektrischen Oszillators an Stellen der größten mechanischen Kräfte, insbesondere an solchen, die durch die stehende akustische longitudinale Welle entstehen, die in Richtung der Resonanzlänge des Oszillators schwingt, und an Punkten, bei einer Signalphasenverschiebung eines der Kanäle des Leistungsverstärkers bezüglich des Signals eines anderen Kanals um 180°, die gleichen Bewegungsbahnen besitzen, befestigt ist, wobei beide Sensorteile über einen Sensorsignalkommutator mit einem zweiten Eingang des Phasendetektors verbunden sind und dessen Steuereingang elektrisch mit dem Steuereingang eines Reversumschalters verbunden ist.

70. Piezoelektrisches Stellelement nach einem der Ansprüche 63 bis 69,
**dadurch gekennzeichnet, dass**
ein Koordinanten- oder Bewegungsparametersensor für das getriebene Element vorgesehen ist, welcher elektrisch mit einem prozessorgesteuerten Regler verbunden ist und dessen Ausgang an dem Signalpegelumformer oder dem Demodulator eines pulsbreitenmodulierten Signals anliegt.

## Claims

1. Piezoelectric positioning element, specifically a piezoelectric motor, in form of a monolithic plate-shaped or cylindrical piezoelectric oscillator (7) having a first and a second type of main surfaces (13, 14) and electrode groups (19, 20, 21, 22) associated therewith, comprising a housing (1), a driven element (3), at least one friction layer (4) located on the housing (1) or on the driven element (3), a driving element (5) which is connected to an electric excitation source (9) and in frictional contact with the friction layer,
**characterized in that**
the piezoelectric oscillator (7) is excited by the electrode groups (19, 20, 21, 22) to standing longitudinal acoustic waves in the direction of an oscillator resonance length (L) and an oscillator resonance height (H) of this piezoelectric oscillator (7), wherein the oscillator resonance length (L) is equal or equal to an integer multiple of the wavelength of the standing longitudinal acoustic wave oscillating in the direction thereof and the oscillator resonance height (H) is equal to half a wavelength of the standing longitudinal acoustic wave oscillating in the direction thereof, wherein both the oscillator resonance length (L) and the oscillator resonance height (H) are selected such that the frequencies of the standing longitudinal acoustic waves propagating through the piezoelectric oscillator (7) are equal in both the direction of the oscillator resonance length (L) and the oscillator resonance height (H).

2. Piezoelectric positioning element according to claim 1,
**characterized in that**
the standing acoustic longitudinal wave oscillating in the oscillator resonance height is sign-constant along the oscillator resonance length.

3. Piezoelectric positioning element according to claim 1,
**characterized in that**
the standing acoustic longitudinal wave oscillating in the oscillator resonance height is sign-variable along the oscillator resonance length.

4. Piezoelectric positioning element according to claim 1 or 2,
**characterized in that**
a group of electrodes forming a first generator of acoustic standing longitudinal waves is arranged, at ends of the oscillator main surfaces, symmetrically with respect to a plane of symmetry extending through the center of the oscillator resonance height and a second group of electrodes forming a second generator of standing acoustic longitudinal waves is located, in central areas of the oscillator main surfaces, symmetrically with respect to the plane of symmetry extending through the center of the oscillator resonance height.

5. Piezoelectric positioning element according to one of the preceding claims,
**characterized in that**
the first and the second electrode groups forming the first and the second generators of the standing longitudinal acoustic waves are connected to each other thereby forming a composite wave generator which simultaneously generates a standing longitudinal acoustic wave oscillating in the direction of the oscillator resonance length and a standing longitudinal acoustic wave oscillating in the direction of the oscillator resonance height.

6. Piezoelectric positioning element according to one of claims 1 to 5,
**characterized in that**
it is comprised of at least two plate-shaped piezoelectric oscillators acoustically connected to each other which form a uniform electromechanical resonator.

7. Piezoelectric positioning element according to claim 6,
**characterized in that**
the piezoelectric oscillators are connected to each other by means of a rigid organic adhesive.

8. Piezoelectric positioning element according to claim 6,
**characterized in that**
the connection of the piezoelectric oscillators are connected to each other by means of a sintering process.

9. Piezoelectric positioning element according to claim 2,
**characterized in that**
the friction elements are arranged on one or two lateral surfaces of the piezoelectric oscillator, preferably in regions with identically signed oscillation maximums of the standing acoustic longitudinal wave oscillating in the direction of the oscillator resonance length.

10. Piezoelectric positioning element according to claim 3,
**characterized in that**
the friction elements are arranged on one or two lateral surfaces of the piezoelectric oscillator, preferably in regions with differently signed oscillation maximums of the standing acoustic longitudinal wave oscillating in the direction of the oscillator resonance length.

11. Piezoelectric positioning element according to one of the preceding claims,
**characterized in that**
the friction elements are strip-shaped, rod-shaped, pyramid-shaped, conical, cylindrical or semi-spherical and are made of a hard wear-resistant material such as oxide ceramics, metal ceramics or composites with other materials.

12. Piezoelectric positioning element according to claim 11,
**characterized in that**
the friction elements include transverse grooves.

13. Piezoelectric positioning element according to claim 11,
**characterized in that**
the friction elements have a single-layer or multi-layer structure.

14. Piezoelectric positioning element according to claim 13,
**characterized in that**
the layers of the single- or multi-layer structure of the friction elements are arranged in parallel to the lateral surfaces of the piezoelectric oscillator.

15. Piezoelectric positioning element according to claim 13,
**characterized in that**
the layers of the single- or multi-layer structure of the friction elements are oriented vertically with respect to the lateral surfaces of the piezoelectric oscillator.

16. Piezoelectric positioning element according to one of the preceding claims,
**characterized in that**
the layers of the friction elements have a cylindrical shape and are arranged concentrically.

17. Piezoelectric positioning element according to one of the preceding claims,
**characterized in that**
the layers of the single- or multi-layer structure of the friction elements have different moduli of elasticity.

18. Piezoelectric positioning element according to claim 14,
**characterized in that**
a wear-resistant layer of the friction element has a modulus of elasticity which is defined by the wear resistance and strength of the functional surface and that a connecting layer of the friction element has a modulus of elasticity which corresponds to the modulus of elasticity of the piezoelectric ceramics of the piezoelectric oscillator.

19. Piezoelectric positioning element according to one of claims 1 to 17,
**characterized in that**
the wear-resistant layer of a multi-layer structure of the friction elements has a modulus of elasticity which is defined by the wear resistance and strength of the functional surface and that further an absorbing layer has a modulus of elasticity which is defined by the dynamic stability of the wear-resistant layer.

20. Piezoelectric positioning element according to one of the preceding claims,
**characterized in that**
the layers of a two- or multi-layer structure of the friction elements are made of monolithic materials and are connected to each other by sintering.

21. Piezoelectric positioning element according to one of the preceding claims,
**characterized in that**
the connecting layer of the friction element is made of a porous material.

22. Piezoelectric positioning element according to claim 21,
**characterized in that**
all layers except for a wear-resistant cover layer are at least partially made of a porous material having a variable porosity, with the connecting layer having a maximum porosity.

23. Piezoelectric positioning element according to claim 19,
**characterized in that**
the absorbing layer is made of a porous material.

24. Piezoelectric positioning element according to one of the preceding claims,
**characterized in that**
with friction elements having a flat functional surface this functional surface is arranged inclined to the lateral surface on which the friction elements are located.

25. Piezoelectric positioning element according to one of claims 1 to 23,
**characterized in that**
the functional surface of the friction elements has a triangular concave or convex, round concave or convex or rib-like shape, wherein a so formed functional surface is arranged along the resonance length of the piezoelectric oscillator.

26. Piezoelectric positioning element according to one of the preceding claims,
**characterized in that**
the friction elements are connected to the surface of the piezoelectric oscillator by means of an organic adhesive, e.g. on an epoxy resin basis.

27. Piezoelectric positioning element according to one of claims 1 to 25,
**characterized in that**
the friction elements are connected to the surface of the piezoelectric oscillator by means of a material which enters into a chemical bond with the piezoelectric ceramics, e.g. by means of a lead-containing low-melting glass.

28. Piezoelectric positioning element according to claim 21 to 23,
**characterized in that**
the pores of the friction elements are entirely or partially filled with the material connecting the friction element to the surface of the piezoelectric oscillator.

29. Piezoelectric positioning element according to claim 12,
**characterized in that**
the transverse grooves are filled with a sound-absorbing material.

30. Piezoelectric positioning element according to one of the preceding claims,
**characterized in that**
the friction element or the friction elements are specifically embodied as glass strips melted onto the surface of the piezoelectric oscillator.

31. Piezoelectric positioning element according to claim 30,
**characterized in that**
the friction elements are filled with a powder of a wear-resistant material, e.g. aluminum oxide, zirconium oxide, tungsten carbide, titanium carbide, titanium nitride or another similar substance.

32. Piezoelectric positioning element according to one of the preceding claims,
**characterized in that**
it is provided with limiting elements so as to prevent a displacement of the piezoelectric oscillator in the direction of its oscillator resonance length.

33. Piezoelectric positioning element according to claim 32,
**characterized in that**
the elements preventing the displacement of the oscillator serve as mechanical resonators the resonance frequency of which corresponds to the oscillation frequency of the piezoelectric oscillator during the operation of the motor.

34. Piezoelectric positioning element according to one of the preceding claims,
**characterized in that**
the piezoelectric oscillator is provided with at least one fixing element which is rigidly connected to the oscillator.

35. Piezoelectric positioning element according to claim 34,
**characterized in that**
the fixing elements are arranged at least on one of the lateral surfaces of the piezoelectric oscillator, specifically at the locations of the oscillation minimums of the standing acoustic longitudinal wave oscillating in the direction of the oscillator resonance length.

36. Piezoelectric positioning element according to one of claims 1 to 34
**characterized in that**
the fixing elements are arranged at least on one of the main surfaces of the piezoelectric oscillator, specifically at the locations of the oscillation minimums of the standing acoustic longitudinal wave oscillating in the direction of the oscillator resonance length.

37. Piezoelectric positioning element according to one of claims 34 to 36,
**characterized in that**
the fixing elements have the shape of a rectangular prism, a triangular prism, a semi-cylindrical prism, a conical element, a pyramid-shaped element, a semi-spherical element or a rectangular element with profiled grooves or the like and are embodied as projecting parts, as cylindrical step elements or as round elements with profiled bores or the like.

38. Piezoelectric positioning element according to one of claims 34 to 37,
**characterized in that**
the fixing elements are made of a material the modulus of elasticity of which is equal to or slightly greater than the modulus of elasticity of the piezoelectric ceramics of the piezoelectric oscillator, especially of oxide ceramics.

39. Piezoelectric positioning element according to one of claims 34 to 37,
**characterized in that**
the fixing elements are made of a material the modulus of elasticity of which is much smaller than the modulus of elasticity of the piezoelectric ceramics of the piezoelectric oscillator.

40. Piezoelectric positioning element according to one of claims 34 to 37,
**characterized in that**
the fixing elements are made of the same piezoceramic type as the piezoelectric oscillator.

41. Piezoelectric positioning element according to one of claims 34 to 39,
**characterized in that**
each fixing element or one of its parts is made of a porous material.

42. Piezoelectric positioning element according to claim 34,
**characterized in that**
the fixing elements are embodied as resonance bending plates or beams.

43. Piezoelectric positioning element according to one of claims 34 to 42,
**characterized in that**
the fixing elements are connected to the surface of the piezoelectric oscillator by means of an organic adhesive.

44. Piezoelectric positioning element according to one of claims 34 to 42,
**characterized in that**
the friction elements are connected to the surfaces of the piezoelectric oscillator by means of a material applied onto the same, wherein the material enters into a chemical bond with the piezoelectric ceramics or with the intermediate layer or, respectively, the material of the fixing element, specifically by the use of a lead-containing low-melting glass.

45. Piezoelectric positioning element according to one of claims 34 to 41,
**characterized in that**
the fixing elements are mounted in rigid support carriers.

46. Piezoelectric positioning element according to claim 45,
**characterized in that**
the rigid support carriers are embodied as flat springs.

47. Piezoelectric positioning element according to one of the preceding claims,
**characterized in that**
the driven element is mounted to be displaceable.

48. Piezoelectric positioning element according to one of the preceding claims,
**characterized in that**
the driven element is embodied in the form of a rectangular platform, a frame having a rectangular, polygonal or round cross-section, as a beam or as a pipe.

49. Piezoelectric positioning element according to one of claims 1 to 46,
**characterized in that**
the driven element is mounted to be rotatable.

50. Piezoelectric positioning element according to claim 49,
**characterized in that**
the driven element is embodied in the form of a cylinder, a disc, a hollow cylinder or a ring or partially in one of these forms.

51. Piezoelectric positioning element according to one of the preceding claims,
**characterized in that**
attenuating bores having a rectangular, round, elliptical or the like shape are provided in the body of the friction element to prevent a propagation of acoustic waves in the friction element the frequency of which is equal to the frequency of the piezoelectric oscillator or their harmonics during the operation of the motor.

52. Piezoelectric positioning element according to one of the preceding claims,
**characterized in that**
the driven element or parts thereof is made of a hard porous material.

53. Piezoelectric positioning element according to claim 52,
**characterized in that**
pores of the driven element are filled with a sound-absorbing material, e.g. with silicone rubber.

54. Piezoelectric positioning element according to one of the preceding claims,
**characterized in that**
the friction layer of the driven element is made of oxide ceramics or another hard wear-resistant material, wherein the thickness thereof is at least five times smaller than the resonance height of the piezoelectric oscillator.

55. Piezoelectric positioning element according to claim 29,
**characterized in that**
the functional surface of the friction layer has a triangular concave or convex shape, a round concave or convex shape or a rib-like shape, with the functional surface being arranged along the resonance length of the piezoelectric oscillator.

56. Piezoelectric positioning element according to one of the preceding claims,
**characterized in that**
the thickness of the body of the friction element arranged underneath the friction layer is greater than the resonance height of the piezoelectric oscillator.

57. Piezoelectric positioning element according to one of the preceding claims,
**characterized in that**
an absorbing layer is arranged between the body of the driven element and the friction layer which is made of a viscous organic or a porous non-organic material or of a combination of these materials.

58. Piezoelectric positioning element according to one of the preceding claims,
**characterized in that**
it is provided with at least two opposing piezoelectric oscillators and at least two friction layers located on the opposing sides of the driven element.

59. Piezoelectric positioning element according to one of the preceding claims,
**characterized in that**
it is provided with at least three piezoelectric oscillators and at least three friction layers which are arranged in parallel to each other and lie in at least three planes.

60. Piezoelectric positioning element according to one of the preceding claims,
**characterized in that**
the electric excitation source is embodied as a dual-channel power amplifier having a first and a second channel which include forming members connected to the base generator and having an output power amplifier which is electrically connected via matching stages to corresponding electrodes of the generator of the standing acoustic longitudinal waves oscillating along the resonance length of the piezoelectric oscillator or, respectively, to electrodes of the generator of the standing acoustic longitudinal waves oscillating along the resonance height.

61. Piezoelectric positioning element according to claim 5,
**characterized in that**
the electric excitation source is embodied as a single-channel power amplifier which is connected to a forming stage connected to the base generator and to an output power amplifier connected via a matching stage and an electrode commutator to the electrodes of the corresponding composite generator.

62. Piezoelectric positioning element according to claim 60 or 61
**characterized in that**
the output power amplifier is embodied as a bridge power amplifier, wherein each of them includes two half-bridges and the forming stages include two excitation channels of said half-bridge power amplifiers, wherein one of the excitation channels is provided with a phase control member and comprises a phase control input.

63. Piezoelectric positioning element according to claim 62,
**characterized in that**
a signal level converter is provided the output of which is connected to the phase control input of the phase control member.

64. Piezoelectric positioning element according to claim 62,
**characterized in that**
a demodulator of a pulse width modulated signal is provided the output of which is connected to the phase control input of the phase control member.

65. Piezoelectric positioning element according to claim 63,
**characterized in that**
a state detector for a zero state is provided, the measurement input of which is connected to an input of the signal level converter or to an output of the demodulator of a pulse width modulated signal, and the output of which is connected to an input of a reversing switch or to a control input of an electrode commutator.

66. Piezoelectric positioning element according to one of the preceding claims,
**characterized in that**
the base generator is provided with a frequency control input.

67. Piezoelectric positioning element according to claim 66,
**characterized in that**
a phase detector having first and second phase inputs and an output is provided, wherein the output of the phase detector is connected to the frequency control input of the base generator, the first phase input is electrically connected to the like electrodes of the corresponding generator of acoustic longitudinal waves and the second phase input is electrically connected to a mechanical tension sensor of these waves.

68. Piezoelectric positioning element according to claim 67,
**characterized in that**
the mechanical tension sensor is embodied as a thin piezoceramic plate which has electrodes on its larger surfaces and is acoustically arranged on the surface of the piezoelectric oscillator at the location of the greatest mechanical tensions specifically of the corresponding standing acoustic longitudinal wave propagating in the piezoelectric oscillator.

69. Piezoelectric positioning element according to claim 67 or 68,
**characterized in that**
the mechanical tension sensor is comprised of two thin piezoceramic plates which have electrodes on their broad surfaces and are acoustically fixed on the surface of the piezoelectric oscillator at locations of the greatest mechanical forces, specifically at those formed by the standing acoustic longitudinal wave which oscillates in the direction of the resonance length of the oscillator, and at points which have the same paths of motion with a signal phase shift of one of the channels of the power amplifier by 180° with respect to the signal of another channel, wherein both sensor parts are connected via a sensor signal commutator to a second input of the phase detector and the control input thereof is electrically connected to the control input of a reversing switch.

70. Piezoelectric positioning element according to one of claims 63 to 69
**characterized in that**
a coordinate or motion parameter sensor for the driven element is provided which is electrically connected to a processor-controlled controller and the output of which is applied to the signal level converter or the demodulator of a pulse width modulated signal.

## Revendications

1. Elément de commande piézoélectrique, en particulier moteur piézoélectrique, sous forme d'un oscillateur (7) piézoélectrique monolithique en forme de plaque ou cylindrique avec un premier et un deuxième type de surfaces principales (13, 14) et des groupes d'électrodes (19, 20, 21, 22) associés à celles-ci, comprenant un boîtier (1), un élément entraîné (3), au moins une couche de friction (4) se trouvant sur le boîtier (1) ou sur l'élément entraîné (3), un élément entraînant (5) relié à une source excitatrice (9) électrique et en contact par friction avec une couche de friction,
**caractérisé en ce que**
l'oscillateur (7) piézoélectrique est excité par les groupes d'électrodes (19, 20, 21, 22) pour former des ondes acoustiques longitudinales stationnaires en direction d'une longueur (L) de résonance d'oscillateur ainsi que d'une hauteur (H) de résonance d'oscillateur de cet oscillateur piézoélectrique (7), la longueur (L) de résonance d'oscillateur étant égale à la longueur d'onde ou égale à un multiple entier de la longueur d'onde de l'onde acoustique longitudinale stationnaire oscillant dans sa direction, la hauteur (H) de résonance d'oscillateur étant égale à la moitié de longueur d'onde de l'onde acoustique longitudinale stationnaire oscillant dans sa direction, et tant la longueur (L) de résonance d'oscillateur que la hauteur (H) de résonance d'oscillateur sont choisies de telle sorte que les fréquences des ondes acoustiques longitudinales stationnaires, qui se propagent à travers l'oscillateur (7) piézoélectrique sont égales tant en direction de la longueur (L) de résonance d'oscillateur que de la hauteur (H) de résonance d'oscillateur.

2. Elément de commande piézoélectrique selon la revendication 1, **caractérisé en ce que** l'onde acoustique longitudinale stationnaire qui oscille en hauteur (H) de résonance d'oscillateur est de signe constant le long de la longueur (L) de résonance d'oscillateur.

3. Elément de commande piézoélectrique selon la revendication 1, **caractérisé en ce que** l'onde acoustique longitudinale stationnaire qui oscille en hauteur (H) de résonance d'oscillateur est de signe variable le long de la longueur (L) de résonance d'oscillateur.

4. Elément de commande piézoélectrique selon la revendication 1 ou 2, **caractérisé en ce qu'**un groupe d'électrodes, qui forment un premier générateur d'ondes acoustiques longitudinales stationnaires, est agencé aux extrémités des surfaces principales d'oscillateur symétriquement par rapport à un plan de symétrie s'étendant à travers le milieu de la hauteur de résonance d'oscillateur, et un deuxième groupe d'électrodes, qui forment un deuxième générateur d'ondes acoustiques longitudinales stationnaires, se trouve dans les régions médianes des surfaces principales d'oscillateur symétriquement par rapport au plan de symétrie s'étendant à travers le milieu de la hauteur de résonance d'oscillateur.

5. Elément de commande piézoélectrique selon l'une des revendications précédentes, **caractérisé en ce que** les premier et deuxième groupes d'électrodes, qui forment les premier et deuxième générateurs des ondes acoustiques longitudinales stationnaires, sont reliés entre eux et forment ainsi un générateur d'ondes composé qui engendre simultanément une onde acoustique longitudinale stationnaire oscillant en direction de la longueur de résonance d'oscillateur ainsi qu'une onde acoustique longitudinale stationnaire oscillant en direction de la hauteur de résonance d'oscillateur.

6. Elément de commande piézoélectrique selon l'une des revendications 1 à 5, **caractérisé en ce que** celui-ci est constitué par au moins deux oscillateurs piézoélectriques en forme de plaques, reliés acoustiquement l'un à l'autre, lesquels forment un résonateur électromécanique unitaire.

7. Elément de commande piézoélectrique selon la revendication 6, **caractérisé en ce que** les oscillateurs piézoélectriques sont reliés au moyen d'une colle organique rigide.

8. Elément de commande piézoélectrique selon la revendication 6, **caractérisé en ce que** la liaison des oscillateurs piézoélectriques a lieu au moyen d'un procédé de frittage.

9. Elément de commande piézoélectrique selon la revendication 2, **caractérisé en ce que** les éléments de friction sont agencés sur une ou sur deux surfaces latérales de l'oscillateur piézoélectrique, de préférence dans des régions présentant des maxima d'oscillations de même signe de l'onde acoustique longitudinale stationnaire oscillant en direction de la longueur de résonance d'oscillateur.

10. Elément de commande piézoélectrique selon la revendication 3, **caractérisé en ce que** les éléments de friction sont agencés sur une ou sur deux surfaces latérales de l'oscillateur piézoélectrique, de préférence dans des régions présentant des maxima d'oscillations de différents signes de l'onde acoustique longitudinale stationnaire oscillant en direction de la longueur de résonance d'oscillateur.

11. Elément de commande piézoélectrique selon l'une des revendications précédentes, **caractérisé en ce que** les éléments de friction présentent une forme de bande, de baguette, de pyramide, de cône, de cylindre ou d'hémisphère et sont constitués d'un matériau dur, résistant à l'usure, par exemple de céramique à base d'oxyde, de céramique métallique ou de composites avec d'autres matériaux.

12. Elément de commande piézoélectrique selon la revendication 11, **caractérisé en ce que** les éléments de friction présentent des gorges transversales.

13. Elément de commande piézoélectrique selon la revendication 11, **caractérisé en ce que** les éléments de friction ont une structure monocouche ou multicouche.

14. Elément de commande piézoélectrique selon la revendication 11, **caractérisé en ce que** les couches de la structure monocouche ou multicouche des éléments de friction sont agencées parallèlement aux surfaces latérales de l'oscillateur piézoélectrique.

15. Elément de commande piézoélectrique selon la revendication 13, **caractérisé en ce que** les couches de la structure monocouche ou multicouche des éléments de friction sont agencées perpendiculairement aux surfaces latérales de l'oscillateur piézoélectrique.

16. Elément de commande piézoélectrique selon l'une des revendications précédentes, **caractérisé en ce que** les couches des éléments de friction présentent une forme cylindrique et sont agencées concentriquement.

17. Elément de commande piézoélectrique selon l'une des revendications précédentes, **caractérisé en ce que** les couches de la structure monocouche ou multicouche des éléments de friction présentent différents modules d'élasticité.

18. Elément de commande piézoélectrique selon la revendication 14, **caractérisé en ce qu'**une couche résistante à l'usure, de l'élément de friction, présente un module d'élasticité qui est déterminé par la résistance à l'usure et par la solidité de la surface fonctionnelle et une couche liante de l'élément de friction présente un module d'élasticité qui correspond au module d'élasticité de la céramique piézoélectrique de l'oscillateur piézoélectrique.

19. Elément de commande piézoélectrique selon l'une des revendications 1 à 17, **caractérisé en ce que** la couche résistance à l'usure, d'une structure multicouche des éléments de friction, présente un module d'élasticité qui est déterminé par la résistance à l'usure et la solidité de la surface fonctionnelle et par ailleurs, une couche amortissante présente un module d'élasticité qui est déterminé par la stabilité dynamique de la couche résistante à l'usure.

20. Elément de commande piézoélectrique selon l'une des revendications précédentes, **caractérisé en ce que** les couches d'une structure bicouche ou multicouche des éléments de friction sont en matériaux monolithiques et sont reliées les unes aux autres par frittage.

21. Elément de commande piézoélectrique selon l'une des revendications précédentes, **caractérisé en ce que** la couche de liaison de l'élément de friction est en un matériau poreux.

22. Elément de commande piézoélectrique selon la revendication 21, **caractérisé en ce que** toutes les couches, à l'exception d'une couche de recouvrement résistante à l'usure, sont réalisées au moins partiellement en un matériau poreux avec une porosité variable, la couche de liaison présentant une porosité maximale.

23. Elément de commande piézoélectrique selon la revendication 19, **caractérisé en ce que** la couche amortissante est en un matériau poreux.

24. Elément de commande piézoélectrique selon l'une des revendications précédentes, **caractérisé en ce qu'**en cas d'éléments de friction d'une surface fonctionnelle réalisée plate, cette surface fonctionnelle est agencée inclinée par rapport à la surface latérale sur laquelle se trouvent les éléments de friction.

25. Elément de commande piézoélectrique selon l'une des revendications 1 à 23, **caractérisé en ce que** la surface fonctionnelle des éléments de friction présente une forme concave ou convexe triangulaire, concave ou convexe arrondie ou nervurée, une surface fonctionnelle ainsi formée étant agencée le long de la longueur de résonance de l'oscillateur piézoélectrique.

26. Elément de commande piézoélectrique selon l'une des revendications précédentes, **caractérisé en ce que** les éléments de friction sont reliés à la surface de l'oscillateur piézoélectrique au moyen d'un adhésif organique, par exemple à base de résine époxy.

27. Elément de commande piézoélectrique selon l'une des revendications 1 à 25, **caractérisé en ce que** les éléments de friction sont reliés à la surface de l'oscillateur piézoélectrique au moyen d'une substance qui s'engage par liaison chimique avec la céramique piézoélectrique, par exemple au moyen d'un verre contenant du plomb et facilement fusible.

28. Elément de commande piézoélectrique selon les revendications 21 à 23, **caractérisé en ce que** les pores de l'élément de friction sont remplis totalement ou partiellement avec la substance de liaison reliant l'élément de friction avec la surface de l'oscillateur piézoélectrique.

29. Elément de commande piézoélectrique selon la revendication 12, **caractérisé en ce que** les gorges transversales sont remplies avec une matière insonorisante.

30. Elément de commande piézoélectrique selon l'une des revendications précédentes, **caractérisé en ce que** le ou les éléments de friction sont réalisés en particulier en tant que bandes de verre appliquées par fusion sur la surface de l'oscillateur piézoélectrique.

31. Elément de commande piézoélectrique selon la revendication 30, **caractérisé en ce que** les éléments de friction sont remplis avec la poudre d'une substance résistante à l'usure, par exemple de l'oxyde d'aluminium, de l'oxyde de zirconium, du carbure de tungstène, du carbure de titane, du nitrure de titane ou d'une autre substance similaire.

32. Elément de commande piézoélectrique selon l'une des revendications précédentes, **caractérisé en ce que** celui-ci est équipé d'éléments limitatifs pour empêcher un déplacement de l'oscillateur piézoélectrique en direction de sa longueur de résonance d'oscillateur.

33. Elément de commande piézoélectrique selon la revendication 32, **caractérisé en ce que** les éléments empêchant le déplacement de l'oscillateur servent de résonateurs mécaniques dont la fréquence de résonance coïncide avec la fréquence d'oscillation de l'oscillateur piézoélectrique pendant le fonctionnement du moteur.

34. Elément de commande piézoélectrique selon l'une des revendications précédentes, **caractérisé en ce que** l'oscillateur piézoélectrique est équipé d'au moins un élément de fixation qui est relié de manière rigide à l'oscillateur.

35. Elément de commande piézoélectrique selon la revendication 34, **caractérisé en ce que** les éléments de fixation sont agencés au moins sur une des surfaces latérales de l'oscillateur piézoélectrique, en particulier aux emplacements des minima d'oscillation de l'onde acoustique longitudinale stationnaire oscillante en direction de la longueur de résonance d'oscillateur.

36. Elément de commande piézoélectrique selon l'une des revendications 1 à 34, **caractérisé en ce que** les éléments de fixation sont agencés au moins sur une des surfaces principales de l'oscillateur piézoélectrique, en particulier aux emplacement des minima d'oscillation de l'onde acoustique longitudinale stationnaire oscillante en direction de la longueur de résonance d'oscillateur.

37. Elément de commande piézoélectrique selon l'une des revendications 34 à 36, **caractérisé en ce que** les éléments de fixation possèdent la forme d'un prisme rectangulaire, d'un prisme triangulaire, d'un prisme semi-cylindrique, d'un élément en forme de cône, d'un élément en forme de pyramide, d'un élément hémisphérique ou d'un élément rectangulaire avec des gorges profilées ou similaires, et sont réalisés sous forme de parties en saillie, sous forme d'éléments en gradins cylindriques ou sous forme d'éléments rond avec perçages profilés ou similaires.

38. Elément de commande piézoélectrique selon l'une des revendications 34 à 37, **caractérisé en ce que** les éléments de fixation sont constitués d'un matériau dont le module d'élasticité est égal ou un peu supérieur au module d'élasticité de la céramique piézoélectrique de l'oscillateur piézoélectrique, en particulier de céramique à base d'oxyde.

39. Elément de commande piézoélectrique selon l'une des revendications 34 à 37, **caractérisé en ce que** les éléments de fixation sont en un matériau dont le module d'élasticité est de beaucoup inférieur au module d'élasticité de la piézocéramique de l'oscillateur piézoélectrique.

40. Elément de commande piézoélectrique selon l'une des revendications 34 à 37, **caractérisé en ce que** les éléments de fixation sont constitués du même type de piézocéramique que l'oscillateur piézoélectrique.

41. Elément de commande piézoélectrique selon l'une des revendications 34 à 39, **caractérisé en ce que** chaque élément de fixation ou l'une de ses parties est constitué(e) d'un matériau poreux.

42. Elément de commande piézoélectrique selon la revendication 34, **caractérisé en ce que** les éléments de fixation sont réalisés sous forme de plaques ou de barres en flexion de résonance.

43. Elément de commande piézoélectrique selon l'une des revendications 34 à 42, **caractérisé en ce que** les éléments de fixation sont reliés à l'aide d'un adhésif organique à la surface de l'oscillateur piézoélectrique.

44. Elément de commande piézoélectrique selon l'une des revendications 34 à 42, **caractérisé en ce que** les éléments de friction sont reliés à l'oscillateur piézoélectrique au moyen d'une substance appliquée sur la surface de celui-ci, la substance s'engageant par liaison chimique avec la céramique piézoélectrique ou avec la couche intermédiaire ou encore avec la substance de l'élément de fixation, en particulier en utilisant un verre contenant du plomb et facilement fusible.

45. Elément de commande piézoélectrique selon l'une des revendications 34 à 41, **caractérisé en ce que** les éléments de fixation sont placés dans des supports de soutien rigides.

46. Elément de commande piézoélectrique selon la revendication 45, **caractérisé en ce que** les supports de soutien rigides sont réalisés sous forme de ressorts plats.

47. Elément de commande piézoélectrique selon l'une des revendications précédentes, **caractérisé en ce que** l'élément entraîné est monté à déplacement.

48. Elément de commande piézoélectrique selon l'une des revendications précédentes, **caractérisé en ce que** l'élément entraîné est réalisé sous la forme d'une plateforme rectangulaire, d'un cadre avec section transversale rectangulaire, polygonale ou ronde, en tant que barre ou en tant que tube.

49. Elément de commande piézoélectrique selon l'une des revendications 1 à 46, **caractérisé en ce que** l'élément entraîné est monté rotatif.

50. Elément de commande piézoélectrique selon la revendication 49, **caractérisé en ce que** l'élément entraîné est réalisé sous la forme d'un cylindre, d'un disque, d'un cylindre creux ou d'une bague ou en partie à partir d'une de ces formes.

51. Elément de commande piézoélectrique selon l'une des revendications précédentes, **caractérisé en ce que** dans le corps de l'élément de friction sont prévus des perçages d'amortissement dans des formes rectangulaires, rondes, elliptiques ou similaires, qui empêchent une propagation dans l'élément de friction d'ondes acoustiques dont la fréquence est égale à la fréquence de l'oscillateur piézoélectrique ou de ses oscillations harmoniques pendant le fonctionnement du moteur.

52. Elément de commande piézoélectrique selon l'une des revendications précédentes, **caractérisé en ce que** l'élément entraîné ou des parties de celui-ci est/sont réalisé(es) en un matériau poreux dur.

53. Elément de commande piézoélectrique selon la revendication 52, **caractérisé en ce que** les pores de l'élément entraîné sont remplis d'un matériau insonorisant, par exemple de caoutchouc de silicone.

54. Elément de commande piézoélectrique selon l'une des revendications précédentes, **caractérisé en ce que** la couche de friction de l'élément entraîné est réalisé en céramique à base d'oxyde ou en un autre matériau dur résistant à l'usure, son épaisseur étant au moins cinq fois inférieure à la hauteur de résonance de l'oscillateur piézoélectrique.

55. Elément de commande piézoélectrique selon la revendication 29, **caractérisé en ce que** la surface fonctionnelle de la couche de friction présente une forme concave ou convexe triangulaire, une forme concave ou convexe arrondie ou une forme nervurée, la surface fonctionnelle étant agencée le long de la longueur de résonance de l'oscillateur piézoélectrique.

56. Elément de commande piézoélectrique selon l'une des revendications précédentes, **caractérisé en ce que** l'épaisseur de corps de l'élément de friction agencé au-dessous de la couche de friction est supérieure à la hauteur de résonance de l'oscillateur piézoélectrique.

57. Elément de commande piézoélectrique selon l'une des revendications précédentes, **caractérisé en ce que** entre le corps de l'élément entraîné et la couche de friction est agencée une couche amortissante qui est constituée d'une matière organique visqueuse ou d'une matière non organique poreuse ou d'un composé de ces matières.

58. Elément de commande piézoélectrique selon l'une des revendications précédentes, **caractérisé en ce que** celui-ci présente au moins deux oscillateurs piézoélectriques opposés avec au moins deux couches de friction se trouvant sur les côtés opposés de l'élément entraîné.

59. Elément de commande piézoélectrique selon l'une des revendications précédentes, **caractérisé en ce que** celui-ci présente au moins trois oscillateurs piézoélectriques et au moins trois couches de friction agencées parallèlement les unes aux autres et situées au moins dans trois plans.

60. Elément de commande piézoélectrique selon l'une des revendications précédentes, **caractérisé en ce que** la source excitatrice électrique est réalisée sous forme d'un amplificateur de puissance à deux canaux, avec un premier canal et un deuxième canal, lesquels renferment des organes de formation raccordés au générateur de base et avec un amplificateur de puissance de sortie qui est relié électriquement via des étages d'adaptation avec des électrodes correspondantes du générateur des ondes acoustiques longitudinales stationnaires oscillant le long de la longueur de résonance de l'oscillateur piézoélectrique ou avec des électrodes du générateur des ondes acoustiques longitudinales stationnaires oscillant le long de la hauteur de résonance.

61. Elément de commande piézoélectrique selon la revendication 5, **caractérisé en ce que** la source excitatrice électrique est réalisée sous forme d'amplificateur de puissance à un canal, qui est relié à un étage de formation raccordé au générateur de base et avec un amplificateur de puissance de sortie qui est raccordé via un étage d'adaptation et via un commutateur d'électrodes aux électrodes du générateur composite correspondant.

62. Elément de commande piézoélectrique selon la revendication 60 ou 61, **caractérisé en ce que** l'amplificateur de puissance de sortie est réalisé sous forme d'amplificateur de puissance à pont, chacun d'eux renferme deux demi-ponts et les étapes de formation contiennent deux canaux excitateurs desdits amplificateurs de puissance à demi-ponts, un des canaux excitateurs étant équipé d'un organe de commande de phase et présentant une entrée de commande de phase.

63. Elément de commande piézoélectrique selon la revendication 62, **caractérisé en ce qu'**il est prévu un transformateur de niveau de signal dont la sortie est reliée à l'entrée de commande de phase de l'organe de commande de phase.

64. Elément de commande piézoélectrique selon la revendication 62, **caractérisé en ce qu'**il est prévu un démodulateur d'un signal modulé en largeur d'impulsion dont la sortie est reliée à l'entrée de commande de phase de l'organe de commande de phase.

65. Elément de commande piézoélectrique selon la revendication 63, **caractérisé en ce qu'**il est prévu un détecteur à étages pour une position zéro dont l'entrée de mesure est raccordée à une entrée du transformateur de niveau de signal ou à une sortie du démodulateur d'un signal modulé en largeur d'impulsion et dont la sortie est reliée à une entrée d'un commutateur d'inversion ou à une entrée de commande d'un commutateur d'électrode.

66. Elément de commande piézoélectrique selon l'une des revendications précédentes, **caractérisé en ce que** le générateur de base est équipé d'une entrée de commande de fréquence.

67. Elément de commande piézoélectrique selon la revendication 66, **caractérisé en ce qu'**il est prévu un détecteur de phase avec des premières et deuxièmes entrées de phase et une sortie, la sortie du détecteur de phase étant reliée à l'entrée de commande de fréquence du générateur de base, la première entrée de phase étant reliée électriquement aux électrodes de polarité identique du générateur correspondant d'ondes acoustiques longitudinales, et la deuxième entrée de phase étant reliée électriquement à un capteur de tension mécanique de ces ondes.

68. Elément de commande piézoélectrique selon la revendication 67, **caractérisé en ce que** le capteur de tension mécanique est réalisé sous forme de plaque piézocéramique mince qui présente sur ses plus grandes surfaces des électrodes et qui est agencée acoustiquement sur la surface de l'oscillateur piézoélectrique à l'emplacement des tensions mécaniques les plus importantes, en particulier de l'onde acoustique longitudinale acoustique correspondante qui se propage dans l'oscillateur piézoélectrique.

69. Elément de commande piézoélectrique selon la revendication 67, **caractérisé en ce que** le capteur de tension mécanique est constitué de deux plaques piézocéramiques minces qui contiennent sur leurs surfaces larges des électrodes et qui est fixé acoustiquement sur la surface de l'oscillateur piézoélectrique aux emplacements des forces mécaniques les plus importantes, en particulier au niveau de forces qui se produisent en raison de l'onde acoustique longitudinale stationnaire qui oscille en direction de la longueur de résonance de l'oscillateur, et au niveau de points, dans le cas d'un décalage de phase de signal de 180° d'un des canaux de l'amplificateur de puissance par rapport au signal d'un autre canal, qui possèdent les mêmes voies de déplacement, les deux parties de capteur étant reliées à une deuxième entrée du détecteur de phase via un commutateur de signal de capteur et son entrée de commande étant reliée électriquement à l'entrée de commande d'un commutateur d'inversion.

70. Elément de commande piézoélectrique selon l'une des revendications 63 à 69, **caractérisé en ce qu'**un capteur de coordonnées ou de paramètres de déplacement est prévu pour l'élément entraîné, lequel est relié électriquement à un régulateur commandé par processeur et dont la sortie est appliqué au convertisseur de niveau de signal ou au démodulateur d'un signal modulé en largeur d'impulsion.
